# EUROPEAN PATENT APPLICATION

(11) **EP 1 734 074 A1**
(43) Date of publication of application: **20.12.2006**
(21) Application number: 05720600.5
(22) Date of filing: 11.03.2005
(51) Int. Cl.: C08L 33/16, C08F 220/22, C08K 3/00

(54) **PHOTOFUNCTIONAL OPTICAL MATERIAL COMPRISING FLUORINATED ACRYLATE POLYMER**

(30) Priority: 29.03.2004 JP 2004096647; 15.04.2004 JP 2004120816; 19.05.2004 JP 2004149609
(71) Applicant: DAIKIN INDUSTRIES, LTD., Osaka-shi, Osaka 530-8323 (JP)
(72) Inventor: ANDO, Yoshito, c/o DAIKIN INDUSTRIES, LTD., Settsu-shi, Osaka 5668585 (JP); ARAKI, Takayuki, c/o DAIKIN INDUSTRIES, LTD., Settsu-shi, Osaka 5668585 (JP); TANAKA, Yoshito, c/o DAIKIN INDUSTRIES, LTD., Settsu-shi, Osaka 5668585 (JP)
(74) Representative: HOFFMANN EITLE
(86) International application number: PCT/JP2005/004329
(87) International publication number: WO 2005/092977

(57) **Abstract**

There is provided the photofunctional optical material which is excellent in an intensity of light emission, light emitting efficiency and/or light amplifying property and also is excellent in processability, for example, easy processing into an optical waveguide device. The photofunctional optical material contains a fluorine-containing acrylate, a polyfunctional acrylate and a rare earth metal compound. There is also provided the composition containing a fluorine-containing acrylate, a polyfunctional acrylate and a rare earth metal compound and is suitable for an optical material.

## Description

### TECHNICAL FIELD

The present invention relates to a photofunctional material which contains a specific fluorine-containing acrylate polymer and a rare earth metal ion and is capable of exhibiting photo-functionality, and particularly relates to a material useful as a photofunctional material and to a material used suitably in the field of optical communication where light amplification technology is used and in the field where light emitting phenomenon is used.

### BACKGROUND ART

An optical communication system using a quartz optical fiber (GOF) and a plastic optical fiber (POF) enables high speed transmission of a large amount of data, and in future, construction of an optical communication network for LAN for domestic use and LAN for car is considered.

In an optical communication system, there arises an attenuation of an optical signal due to a loss caused at the time of transmission, branching, connection and switching, and therefore amplification with a light amplifier and a light amplifying device is needed to compensate for the attenuation of optical signals.

Represented examples of materials being capable of exhibiting light amplifying and light emitting functions are (quartz) glass materials doped with rare earth metal ion. However it is difficult to form such materials into various shapes. For example, in order to incorporate, into a circuit, an optical waveguide type light amplifying device or light emitting device produced from those materials, many steps and much energy consumption are required.

Therefore organic photofunctional materials which can be easily processed and can be used for a light amplifying device or a light emitting device are demanded.

JP2000-63682A discloses, as an organic photofunctional material, a composition prepared by dispersing a rare earth metal complex in a fluorine-containing acrylate polymer.

In JP2000-63682A, there are disclosed examples of a fluorine-containing methacrylate and a fluorine-containing acrylate such as poly(hexafluoroisopropyl methacrylate), poly(hexafluoro-n-propyl methacrylate) and polyfluoroisopropyl acrylate (Paragraph [0069] of JP2000-63682A), and also in the examples thereof, there are disclosed a functional data by visual observation indicating that as compared with PMMA having no fluorine atom, an intensity of light emission is improved in the case of matrix polymers such as a homopolymer of hexafluoroisopropyl methacrylate (iFPMA), NAFION (trademark of DuPont), a copolymer of iFPMA and methyl methacrylate (MMA), a copolymer of MMA and fluoroisopropyl acrylate and a copolymer of MMA and hexafluoro-n-propyl methacrylate.

Also those compositions containing a rare earth metal complex of JP2000-63682A are insufficient in an intensity of light emission and a light emitting efficiency.

Further those compositions are insufficient in heat resistance, and as the case may be, deformation of a shape arises due to heat generation of a device.

### DISCLOSURE OF INVENTION

It is an object of the present invention to provide a photofunctional optical material which is excellent in an intensity of light emission, light emitting efficiency and/or light amplifying property and also is excellent in processability, for example, easy processing into an optical waveguide device.

The present inventors have made intensive studies with respect to various compositions containing a fluorine-containing acrylate polymer and a rare earth metal compound, and have found that an intensity of light emission and a light emitting efficiency can be enhanced significantly in the case of a composition containing a rare earth metal compound and a polymer prepared by copolymerizing a fluorine-containing acrylate with a polyfunctional acrylate.

Also the present inventors have found that in the composition containing a fluorine-containing acrylate, a polyfunctional acrylate and a rare earth metal compound, formation of a thin film is easy, and therefore productivity in processing into an optical waveguide device is excellent.

Namely, the present invention relates to a photofunctional optical material (the first invention) comprising:
(A) a fluorine-containing acrylate polymer which is prepared by polymerizing:
   (a1) at least one selected from fluorine-containing acrylates represented by the formula (1): 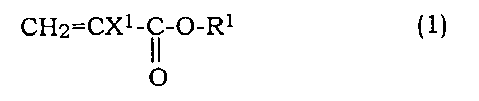 wherein X¹ is H, F, Cl, CH₃ or CF₃; R¹ is at least one selected from monovalent hydrocarbon groups which have 1 to 50 carbon atoms and may have ether bond and monovalent fluorine-containing hydrocarbon groups which have 1 to 50 carbon atoms and may have ether bond; at least either X¹ or R¹ contains fluorine atom,
   (a2) at least one selected from polyfunctional acrylates represented by the formula (2): 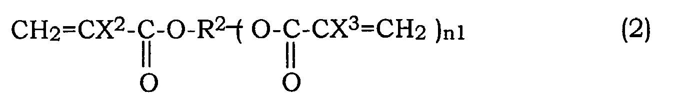 wherein X² and X³ are the same or different and each is H, F, Cl, CH₃ or CF₃; n1 is an integer of 1 to 6; R² is a (n1 + 1)-valent organic group having 1 to 50 carbon atoms, and
   (n) at least one selected from monomers being copolymerizable with the mentioned (a1) and (a2),
   and contains a structural unit A1 derived from the monomer (a1), a structural unit A2 derived from the monomer (a2) and a structural unit N derived from the monomer (n) in amounts of from 20 to 99.9 % by mole, from 0.1 to 80 % by mole and from 0 to 60 % by mole, respectively, and
(B) a rare earth metal compound,
   in which (A) and (B) are contained in amounts of from 1 to 99.99 % by mass and from 0.01 to 99 % by mass, respectively.

Also the present invention relates to a composition (the second invention) which comprises:
(a3) at least one selected from fluorine-containing acrylates represented by the formula (3): 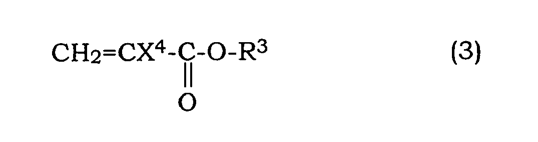 wherein X⁴ is H, F, Cl, CH₃ or CF₃; R³ is a fluorine-containing alkyl group which has 2 to 50 carbon atoms and ether bond and contains a structure represented by the formula (3-1): 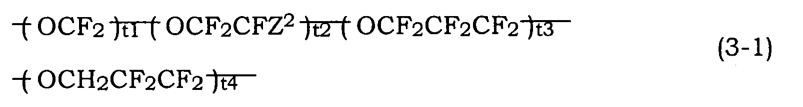 wherein Z² is F or CF₃; t1, t2, t3 and t4 are 0 or integers of 1 to 10 and t1 + t2 + t3 + t4 is an integer of 1 to 10, (a4) at least one selected from polyfunctional acrylates represented by the formula (4): 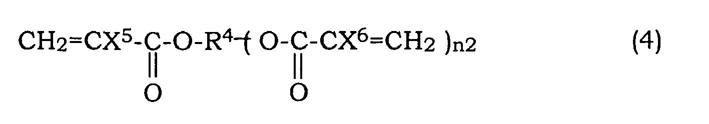 wherein X⁵ and X⁶ are the same or different and each is H, F, Cl, CH₃ or CF₃; n2 is an integer of 1 to 6; R⁴ is a (n2 + 1)-valent organic group having 1 to 50 carbon atoms, and
(b) a rare earth metal compound,
   in which ((a3) + (a4)) is contained in an amount of from 1 to 99.99 % by mass and (b) is contained in an amount of from 0.01 to 99 % by mass and when the number of moles of (a3) plus the number of moles of (a4) is assumed to be 100, a molar ratio (a3)/(a4) is 20/80 to 99/1.

### BRIEF DESCRIPTION OF DRAWINGS

Fig. 1 is a flow chart for explaining production steps of a light amplifying device or light emission device produced using the composition of the present invention.
Fig. 2 is a diagrammatic flow chart of an optical system used for measuring an intensity of light emission at 1,550 nm in the present invention.

### BEST MODE FOR CARRYING OUT THE INVENTION

First, the fluorine-containing acrylate polymer (A) used in the first invention is explained.

The fluorine-containing acrylate polymer (A) used in the first invention has, as essential components, the structural unit (A1) derived from the fluorine-containing acrylate (a1) represented by the formula (1) and the structural unit (A2) derived from the polyfunctional acrylate (a2) represented by the formula (2), and further the structural unit (N) derived from the monomer being copolymerizable with (a1) and (a2) may be contained as an optional structural unit.

The structural unit (A1) derived from the formula (a1) constituting the fluorine-containing acrylate polymer (A) of the present invention is namely a structural unit derived from a monofunctional fluorine-containing acrylate, and fluorine atom is contained in either the side chain portion R¹ or the trunk chain portion X of the formula (a1).

The introduction of fluorine atoms and further the introduction at high fluorine content is preferred because a light emitting efficiency and a light amplifying efficiency can be enhanced remarkably in the case of the composition containing the rare earth metal compound (B).

Namely, the fluorine content of the fluorine-containing acrylate (a1) is not less than 20 % by mass, preferably not less than 30 % by mass, more preferably not less than 40 % by mass.

Examples of the structure of the fluorine-containing acrylate (a1) excluding R¹ are: 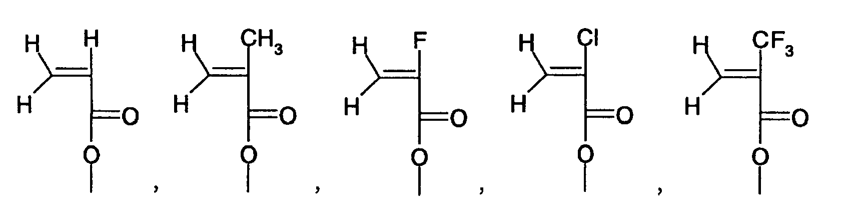 and the like, and from the viewpoint of polymerizability, preferred are: 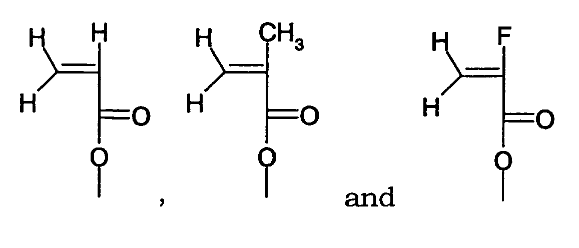 and further preferred is: 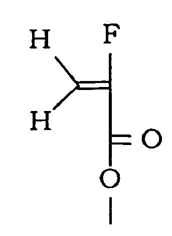 because an intensity of light emission and a light emitting efficiency can be enhanced in the case of the composition containing the rare earth metal compound (B), because transparency and heat resistance can be imparted to the obtained polymer and because a mechanical strength can be imparted.

When X in the fluorine-containing acrylate (a1) is F or CF₃, R¹ in the side chain may not contain fluorine atom, and it is usually preferable that R¹ is at least one selected from monovalent fluorine-containing alkyl groups which have 1 to 50 carbon atoms and may have ether bond and monovalent fluorine-containing aryl groups which have 2 to 50 carbon atoms and an aromatic ring structure and may have ether bond.

Accordingly the fluorine content of the fluorine-containing acrylate polymer (A) can be increased remarkably, and in the case of the composition containing the rare earth metal compound (B), an intensity of light emission and a light emitting efficiency can be enhanced.

It is particularly preferable that R¹ is at least one selected from monovalent fluorine-containing alkyl groups which have 1 to 50 carbon atoms and may have ether bond, from the point that transparency, an intensity of light emission and a light emitting efficiency are further enhanced.

In the fluorine-containing acrylate of the formula (a1), preferred examples of the side chain R¹ are as follows.

### (i) Fluorine-containing linear alkyl group

Concretely there are groups represented by the formula (R1-1): 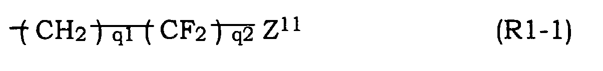 wherein Z¹¹ is at least one selected from H, F, Cl and Br; q1 is 0 or an integer of 1 to 5; q2 is an integer of 1 to 20.

In the formula (R1-1), q1 is preferably an integer of 1 to 4, particularly 1 or 2, and q2 is preferably from 1 to 10, more preferably from 1 to 6, particularly preferably from 1 to 4.

If q1 is too large, there is a tendency that an effect of improving an intensity of light emission and a light emitting efficiency of the composition containing the rare earth metal compound (B) is lowered. Also if q2 is too large, there is a tendency that transparency of the fluorine-containing acrylate polymer (A) is lowered and dispersibility of the rare earth metal compound (B) is lowered, resulting in lowering of transparency of the composition containing the rare earth metal compound (B).

Examples thereof are:
-CH₂CF₃, -CH₂CF₂CF₃, -CH₂CF₂CF₂H, -CH₂(CF₂CF₂)₂H, -CH₂CH₂(CF₂CF₂)₂F, -CH₂CH₂(CF₂CF₂)₃F, -CH₂(CF₂CF₂)₂Cl, -CH₂CF₂CF₂Cl and the like.

Further in the formula (R1-1), it is preferable that Z¹¹ at an end of the side chain is H or Cl, and particularly preferred is hydrogen atom, thereby enabling dispersibility and solubility (compatibility) of the rare earth metal compound (B) to be improved as compared with the case where Z¹¹ is fluorine atom.

From those points of view, preferred are:
-CH₂CF₂CF₂H, -CH₂(CF₂CF₂)₂H, -CH₂(CF₂CF₂)₃H, -CH₂(CF₂CF₂)₄H, -CH₂(CF₂CF₂)₂Cl and -CH₂CF₂CF₂Cl
   and
-CH₂CF₂CF₂H and -CH₂(CF₂CF₂)₂H,
are particularly preferred.

### (ii) Fluorine-containing branched alkyl group

Concretely there are fluorine-containing alkyl groups having a branched structure represented by the formula (R1-2): 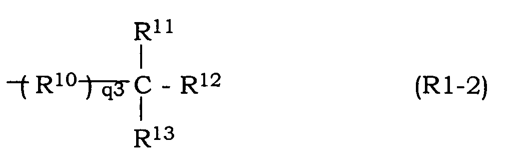 wherein R¹⁰ is a linear alkylene group having 1 to 10 carbon atoms in which a part or the whole of hydrogen atoms may be replaced by fluorine atoms; R¹¹ is a fluorine-containing linear alkyl group which has 1 to 10 carbon atoms and may have ether bond; R¹² is at least one selected from linear alkyl groups having 1 to 5 carbon atoms and fluorine-containing linear alkyl groups which have 1 to 5 carbon atoms and may have ether bond; R¹³ is at least one selected from H, F, linear alkyl groups having 1 to 5 carbon atoms and fluorine-containing linear alkyl groups which have 1 to 10 carbon atoms and may have ether bond; q3 is 0 or 1. Concretely preferred are fluorine-containing alkyl groups represented by the formula (R1-2-1): 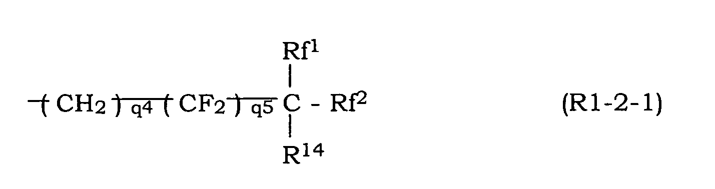 wherein Rf¹ and Rf² are the same or different and each is a perfluoroalkyl group having 1 to 5 carbon atoms; R¹⁴ is H, F or a hydrocarbon group having 1 to 5 carbon atoms in which a part or the whole of hydrogen atoms may be replaced by fluorine atoms; q4 + q5 is an integer of 1 to 10, and more concretely there are preferably: 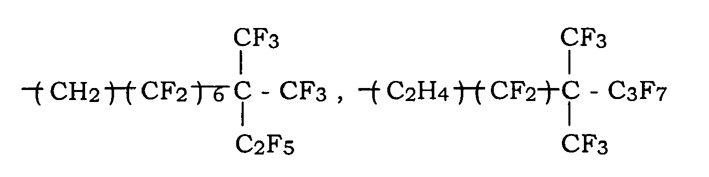 and the like.

Those groups are preferred since more enhanced transparency can be imparted to the fluorine-containing acrylate polymer (A) of the present invention.

Also among the groups of the formula (R1-2-1), preferred as R¹ are fluorine-containing alkyl groups represented by the formula (R1-2-2): 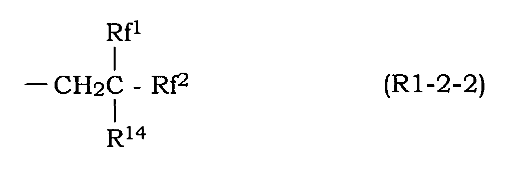 wherein Rf¹, Rf² and R¹⁴ are as defined in the formula (R1-2-1), and more concretely there are preferably: 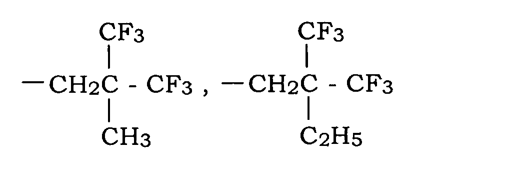 and the like.

Those groups are preferred because a glass transition temperature can be set higher and dispersibility of the rare earth metal compound is excellent.

Further preferred as R¹ are fluorine-containing alkyl groups represented by the formula (R1-2-3): 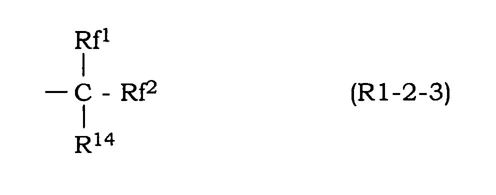 wherein Rf¹, Rf² and R¹⁴ are as defined in the formula (R1-2-1), and more concretely there are preferably: 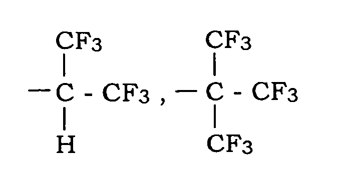 and the like.

In those examples of the branched fluorine-containing alkyl groups (ii), particularly preferred are the fluorine-containing alkyl groups represented by: 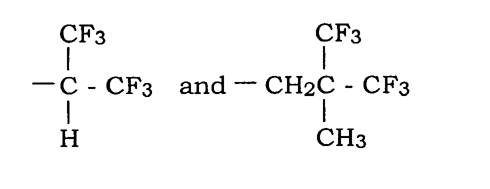 because a polymer providing excellent dispersibility of a variety of rare earth metal compounds, enhanced glass transition temperature and excellent heat resistance can be obtained.

By those effects, an intensity of light emission (amplification) and a light emitting (amplifying) efficiency of the composition containing the rare earth metal compound (B) can be enhanced.

### (iii) Fluorine-containing alkyl group having ether bond

There are fluorine-containing alkyl groups having a moiety of fluorine-containing alkylene ether structure, concretely fluorine-containing alkyl groups having a structure represented by the formula (1-1): 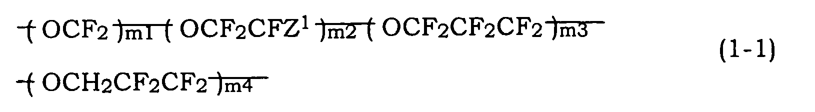 wherein Z¹ is F or CF₃; m1, m2, m3 and m4 are 0 or integers of 1 to 10 and m1 + m2 + m3 + m4 is an integer of 1 to 10.

The polymer (A) of the present invention prepared by using the fluorine-containing acrylate monomer having the mentioned moiety has a high fluorine content, is high in transparency, and can enhance an intensity of light emission (amplification) and a light emitting (amplifying) efficiency of the composition containing the rare earth metal compound (B).

Examples of the side chain portion R¹ having the moiety of the formula (1-1) are:
(1-2): 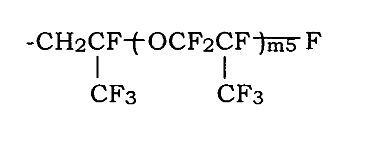 wherein m5 is an integer of 1 to 5,
(1-3): 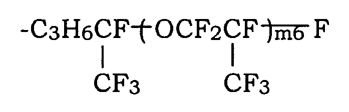 wherein m6 is an integer of 1 to 6,
(1-4): 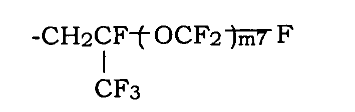 wherein m7 is an integer of 1 to 8,
(1-5): 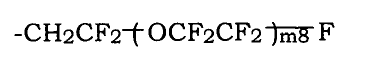 wherein m8 is an integer of 1 to 8,
(1-6): 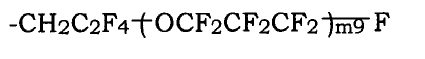 wherein m9 is an integer of 1 to 7,
(1-7): 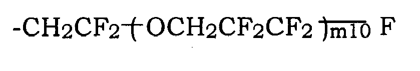 wherein m 10 is an integer of 1 to 8
and the like.

Among them, more preferred is the side chain structure of the formula (1-2): 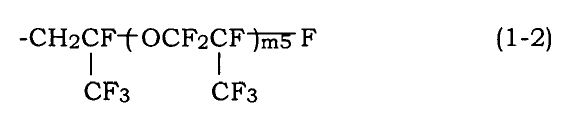 wherein m5 is an integer of 1 to 5, because a fluorine content is high and an intensity of light emission (amplification) and a light emitting (amplifying) efficiency of the composition containing the rare earth metal compound (B) can be enhanced.

In the photofunctional optical material of the present invention, preferred examples of the fluorine-containing acrylate (a1) providing the structural unit A1 constituting the fluorine-containing acrylate polymer (A) are monomers raised below.

### (a1-i) Monomers having a fluorine-containing linear alkyl group

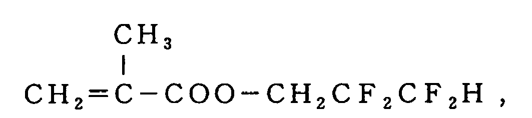

CH₂=CF-COO-CH₂CF₂CF₂H,

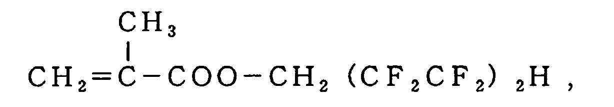

CH₂=CF-COO-CH₂ (CF₂CF₂)₂H,

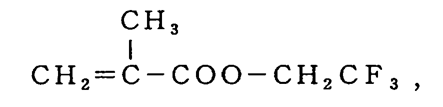

CH₂=CF-COO-CH₂CF₃

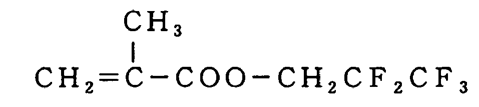

and

CH₂=CF-COO-CH₂CF₂CF₃

are preferred and among them,
CH₂=CF-COO-CH₂CF₂CF₂H and CH₂=CF-COO-CH₂(CF₂CF₂)₂H
are particularly preferred.

### (a1-ii) Monomers having a fluorine-containing branched alkyl group

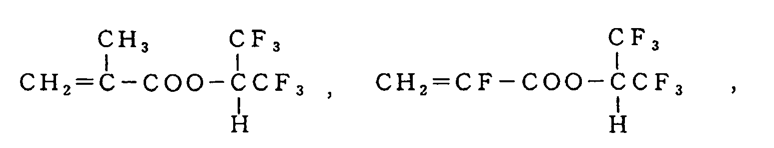

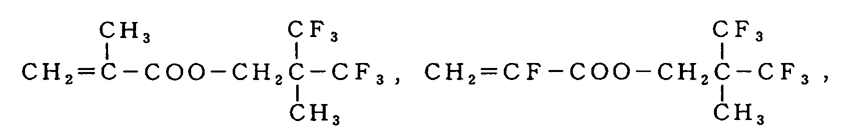

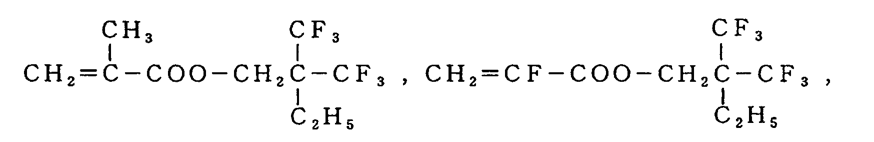

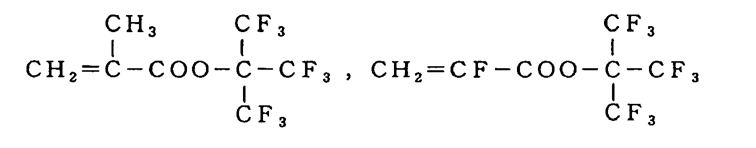

and the like are preferred, and 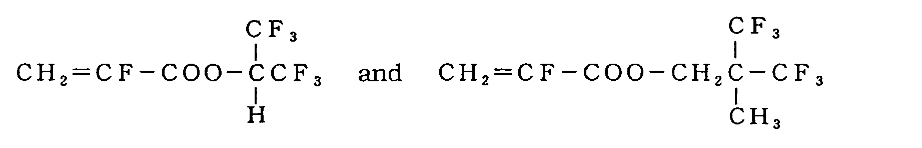 are particularly preferred.

### (a1-iii) Monomers having, in its side chain, a fluorine-containing alkyl group having ether bond

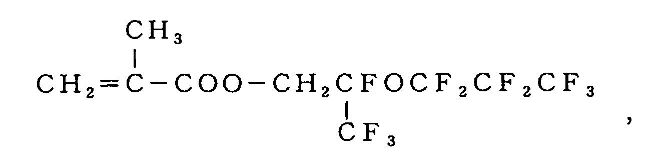

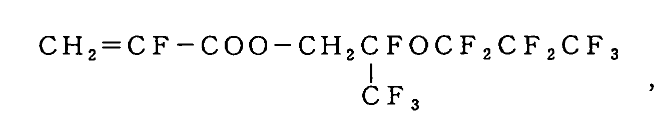

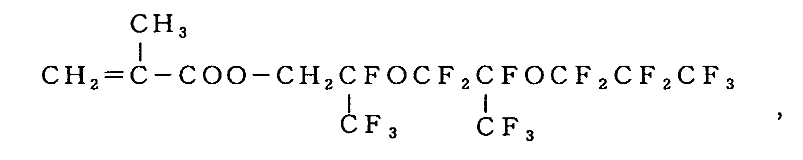

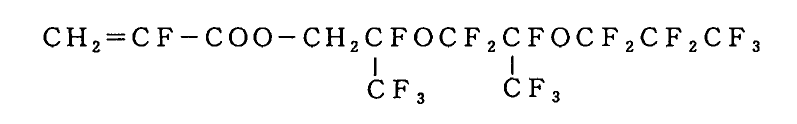

and the like, and 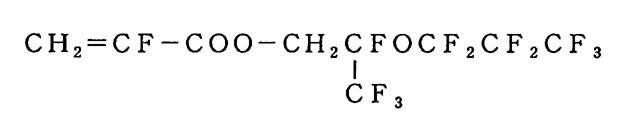 and 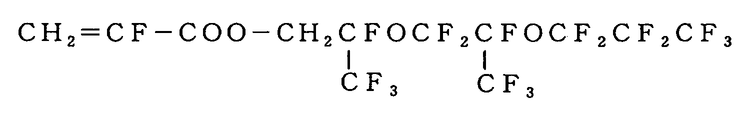 are particularly preferred.

The fluorine-containing acrylate polymer (A) which is used for the photofunctional optical material of the present invention is characterized by containing the structural unit A2 derived from the polyfunctional acrylate (a2) in addition to the structural unit (A1) derived from the fluorine-containing acrylate (a1). By the introduction of the structural unit A2 derived from the polyfunctional acrylate (a2), an intensity of light emission (amplification) and a light emitting (amplifying) efficiency of the photofunctional optical material comprising the composition containing the rare earth metal compound (B) can be enhanced remarkably.

The polyfunctional acrylate (a2) is at least one selected from the acrylates represented by the formula (2): 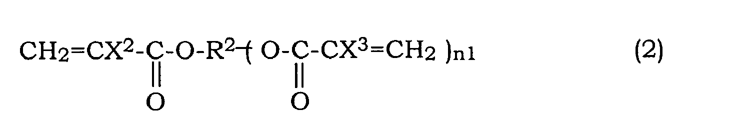 wherein X² and X³ are the same or different and each is H, F, Cl, CH₃ or CF₃; n1 is an integer of 1 to 6; R² is a (n1 + 1)-valent organic group having 1 to 50 carbon atoms.

In the polyfunctional acrylate of the formula (2), X² and X³ are H, CH₃, F, CF₃ or Cl, and particularly preferred are CH₃ and F and further preferred is F.

R² is a (n1 + 1)-valent organic group having 1 to 50 carbon atoms, and concretely there are:
(1) linear or branched (n + 1)-valent organic group which may have ether bond,
(2) (n1 + 1)-valent organic group having an aromatic ring structure,
(3) (n1 + 1)-valent organic group having an aliphatic ring (monocyclic or polycyclic) structure,
(4) (n1 + 1)-valent organic group having urethane bond
   and the like. In those organic groups, a part or the whole of hydrogen atoms forming a carbon-hydrogen bond may be replaced by fluorine atoms.

First, preferred embodiments of the respective R² are explained by means of examples thereof.

### (1) Linear or branched (n1 + 1)-valent organic group which may have ether bond:

In the case of n1=1 (bifunctional acrylate) in the formula (2) representing the polyfunctional acrylate (a2), there are, for example, organic groups represented by the formula (R2-1):

- (CH₂)ₚ₁ - (CF₂)ₚ₂ - (C(CH₃))ₚ₃ - (R2-1)

wherein p1 + p2 + p3 is from 1 to 30.

Examples thereof are:
-CH₂CH₂-, -CH₂CH(CH₃)-, -CH₂CH₂CH(CH₃)-, -(CH₂)₄-, -(CH₂)₆-, -(CH₂)₂(CF₂)₂(CH₂)₂-, -(CH₂)₂(CF₂)₄(CH₂)₂-, -(CH₂)₂(CF₂)₆(CH₂)₂-, -CH₂C(CH₃)₂CH₂-
and the like.

Also there are organic groups represented by the formula (R2-1-1): 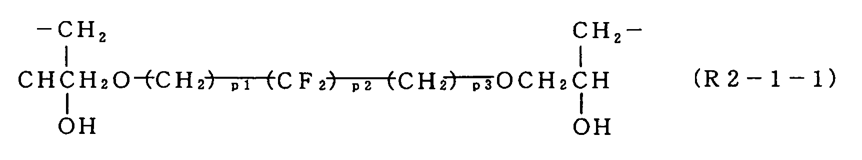 wherein p1, p2 and p3 are as defined in the formula (R2-1).

More concretely there are preferably: 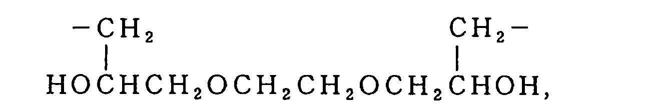 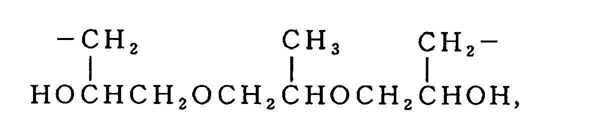 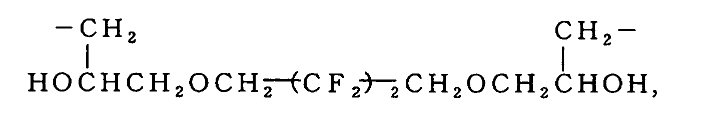 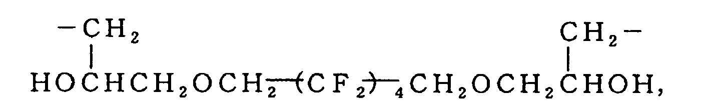 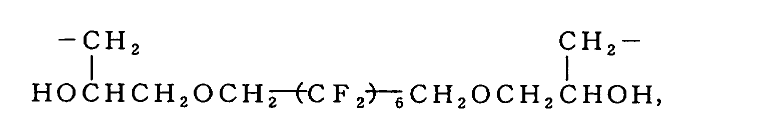 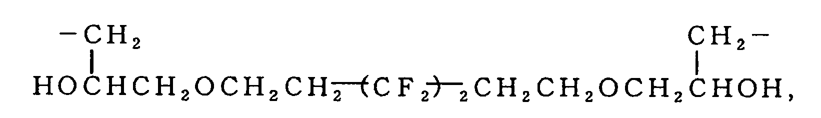 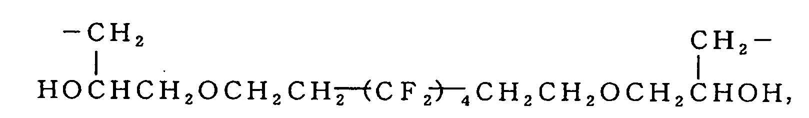 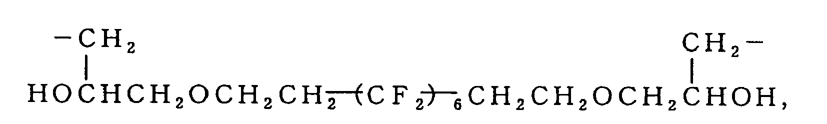 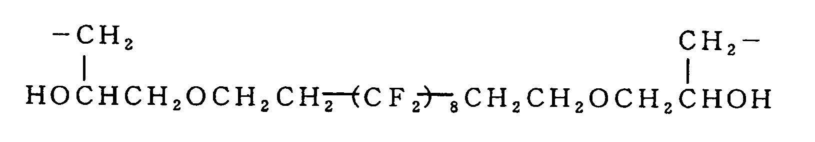 and the like.

Other examples are organic groups represented by the formulae (R2-1-2) and (R2-1-3): 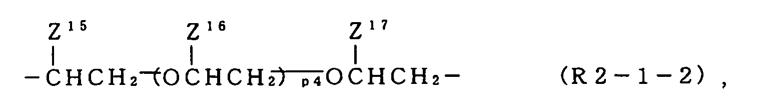 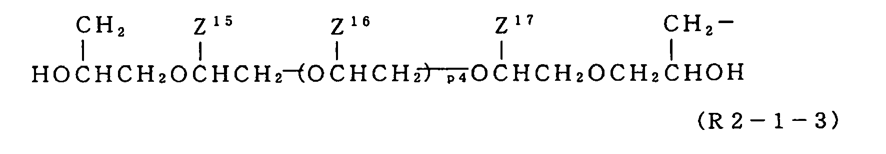 and the like, wherein p4 is 0 or an integer of 1 to 20; Z¹⁵, Z¹⁶ and Z¹⁷ are the same or different and each is H or CH₃.

Also in the case of n1=2 or more (trifunctional or more), there are organic groups represented by the formula (R2-2): 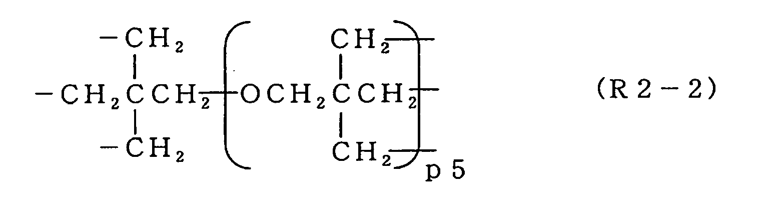 wherein p5 is 0 or an integer of 1 to 5.

Concretely there are: 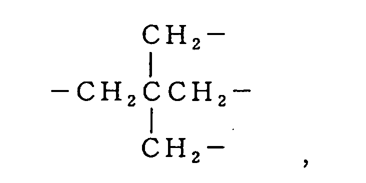 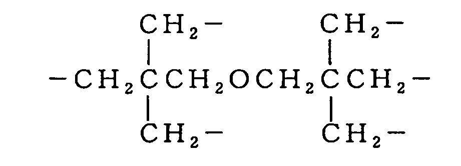 and the like.

Examples other than the formula (R2-2) are, for instance, 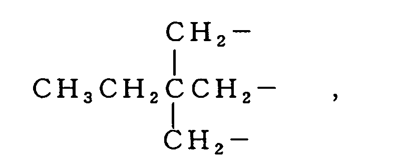 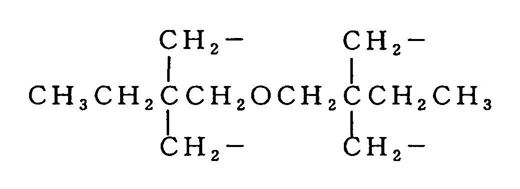 and the like.

Examples of the organic groups having a fluorine-containing alkylene group are those of the formulae (R2-3) and (R2-4): 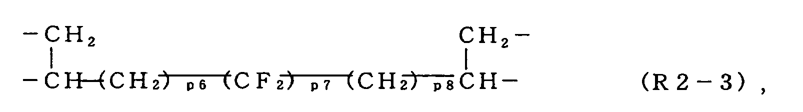 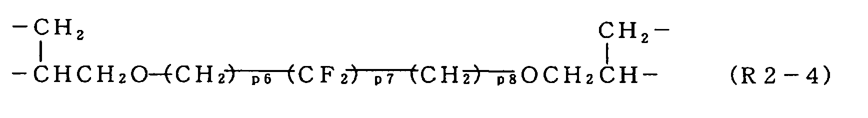 and the like, wherein p6 and p8 are the same or different and each is an integer of 1 to 10; p7 is an integer of 1 to 30.

Concretely preferred examples thereof are: 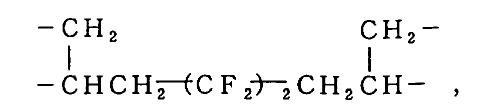 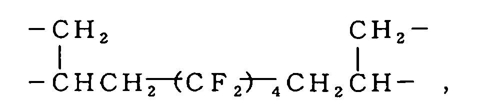 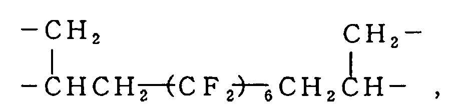 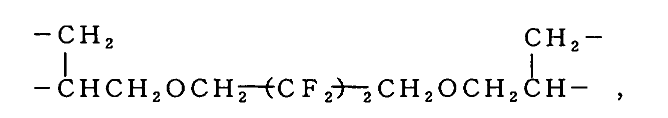 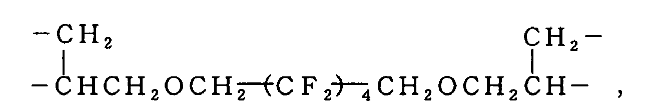 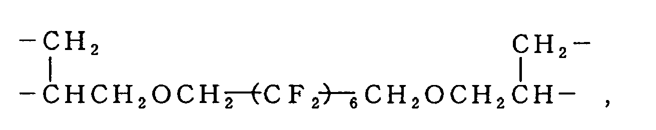 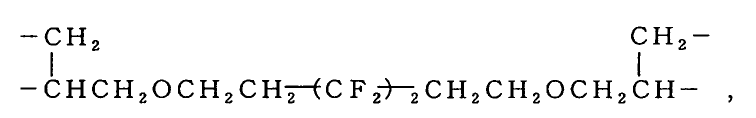 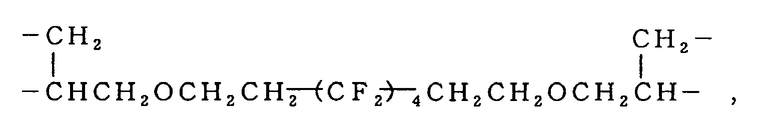 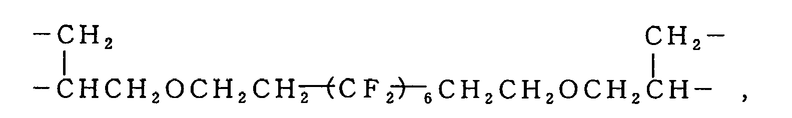 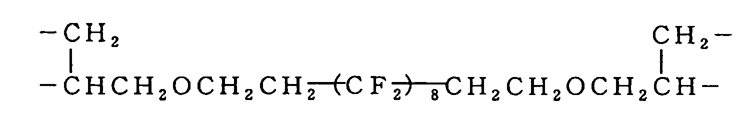 and the like.

The divalent or more organic groups having the linear or branched alkylene group exemplified above are preferred as the R² because flexibility and elasticity can be imparted to the polymer and also because compatibility with the rare earth metal compound (B) is excellent. Further those organic groups are preferred because when introducing fluorine atom, the fluorine content can be made high, which is advantageous from the viewpoint of an intensity of light emission (amplification) and a light emitting (amplifying) efficiency. (2) (n1 + 1)-valent organic group having an aromatic ring structure

There are, for example, divalent organic groups containing a moiety represented by the formula (R2-5): 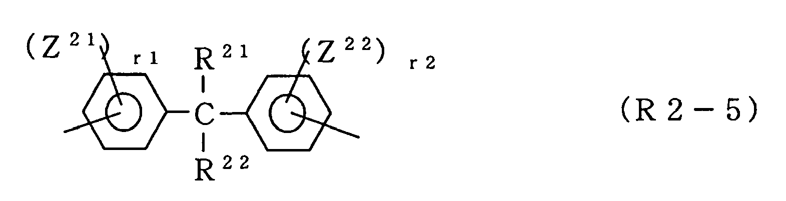 wherein R²¹ and R²² are the same or different and each is an alkyl group having 1 to 5 carbon atoms or a fluorine-containing alkyl group having 1 to 5 carbon atoms; Z²¹ and Z²² are the same or different and each is an alkyl group having 1 to 5 carbon atoms, a fluorine-containing alkyl group having 1 to 5 carbon atoms, a functional group, hydrogen atom or halogen atom; r1 and r2 are the same or different and each is an integer of 1 to 4, or divalent organic groups containing a moiety represented by the formula (R2-6): 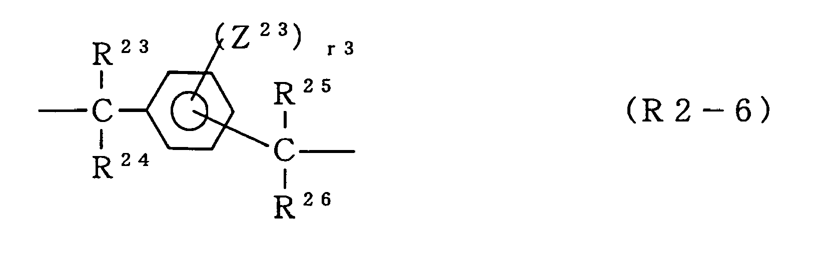 wherein R²³, R²⁴, R²⁵ and R²⁶ are the same or different and each is an alkyl group having 1 to 5 carbon atoms or a fluorine-containing alkyl group having 1 to 5 carbon atoms; Z²³ is an alkyl group having 1 to 5 carbon atoms, a fluorine-containing alkyl group having 1 to 5 carbon atoms, a functional group, hydrogen atom or halogen atom; r3 is an integer of 1 to 4.

In addition, there are divalent organic groups containing a moiety represented by the following formulae (R2-7) to (R2-11).

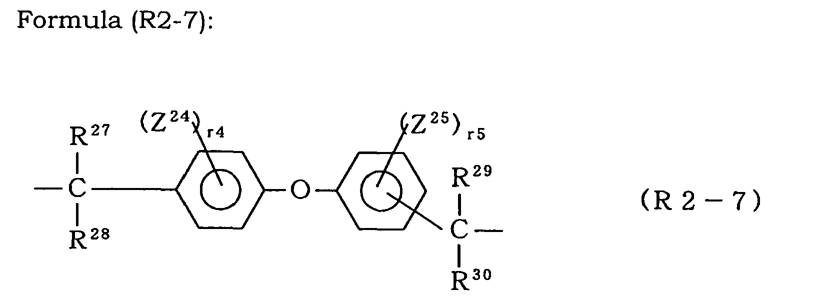

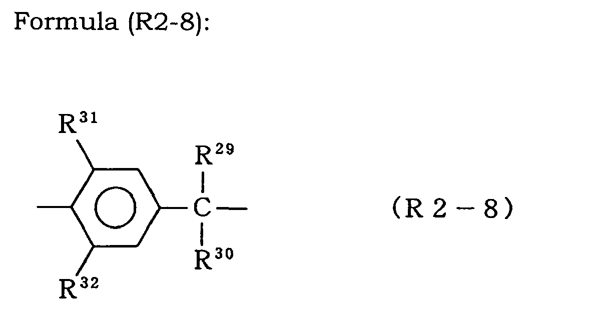

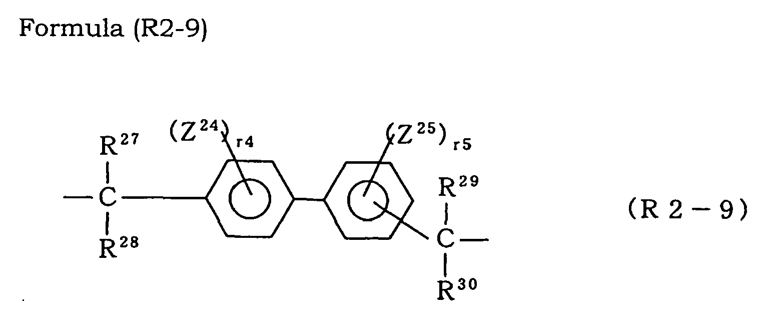

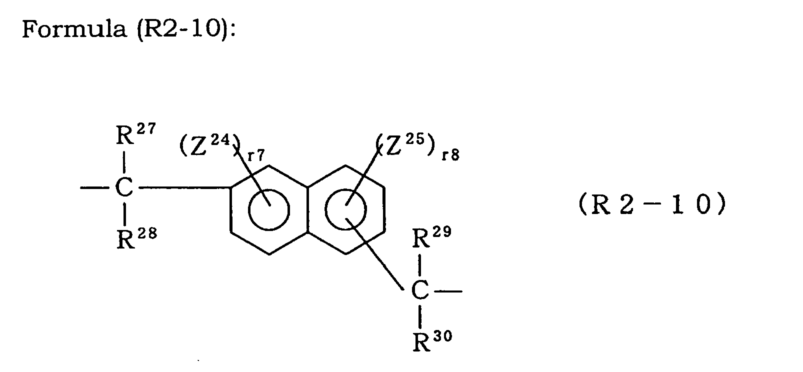

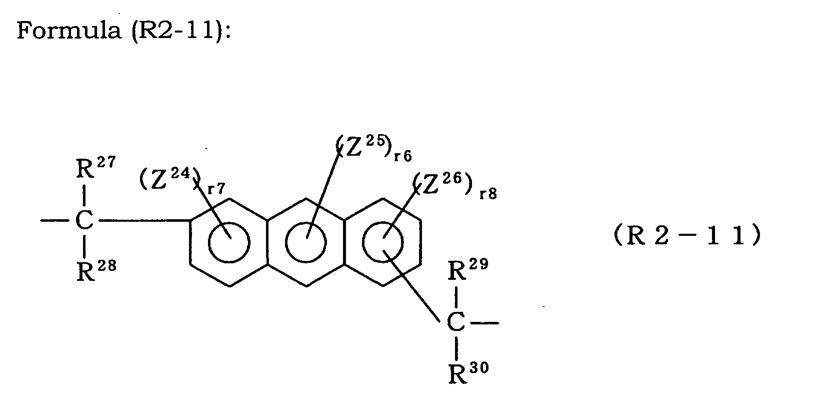

In the above formulae, R²⁷, R²⁸, R²⁹ and R³⁰ are the same or different and each is an alkyl group having 1 to 5 carbon atoms or a fluorine-containing alkyl group having 1 to 5 carbon atoms; R³¹ and R³² are the same or different and each is an alkyl group having 1 to 5 carbon atoms, a fluorine-containing alkyl group having 1 to 5 carbon atoms or hydrogen atom; Z²⁴, Z²⁵ and Z²⁶ are the same or different and each is an alkyl group having 1 to 5 carbon atoms, a fluorine-containing alkyl group having 1 to 5 carbon atoms, a functional group, hydrogen atom or a halogen atom; r4 and r5 are the same or different and each is an integer of 1 to 4; r6 is an integer of 1 to 2; r7 and r8 are the same or different and each is an integer of 1 to 3. In the different formulae, the same symbols can represent different groups or different integers.

Preferred examples of the formula (R2-5) are: 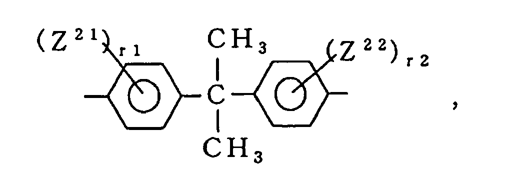 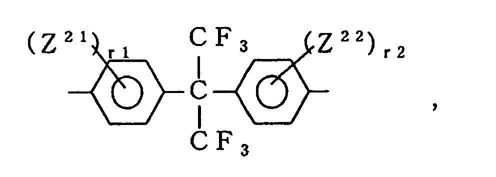 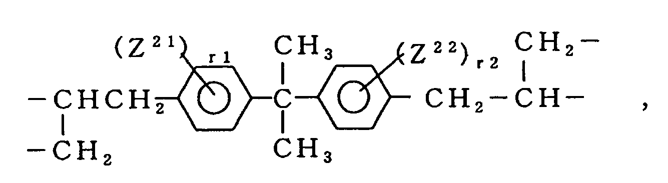 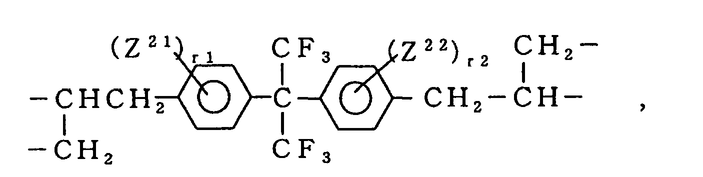 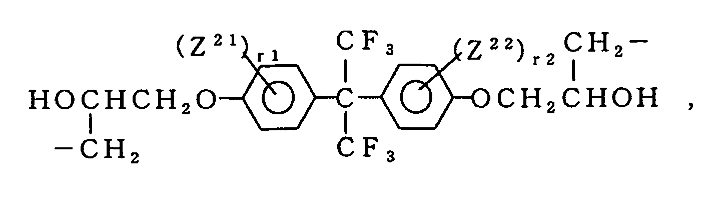 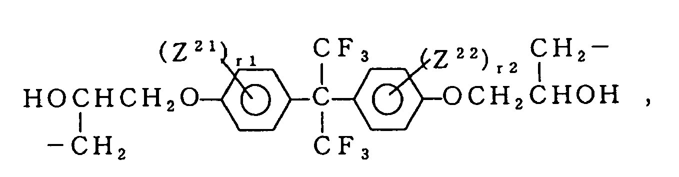 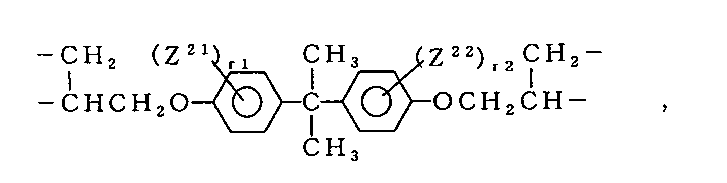 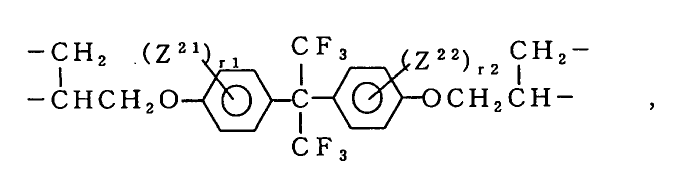 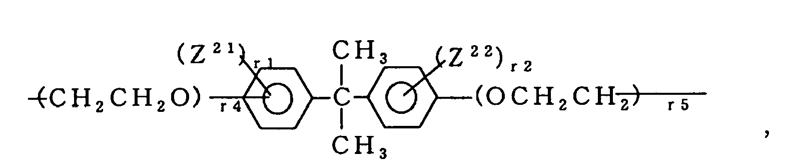 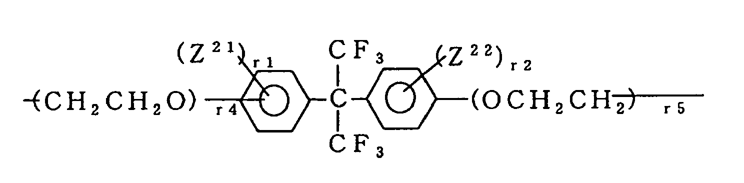 and the like wherein r4 and r5 are the same or different and each is an integer of 1 to 10; Z²¹, Z²², r1 and r2 are as defined in the formula (R2-5).

Preferred examples of the formula (R2-6) are: 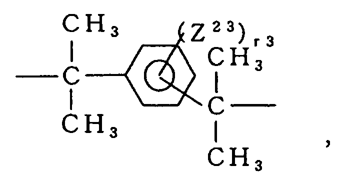 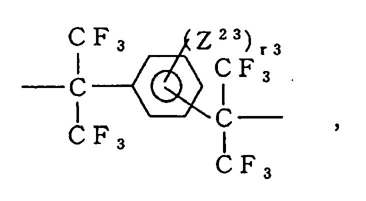 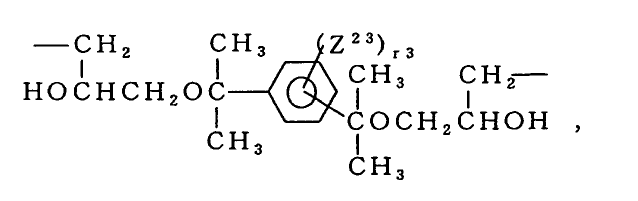 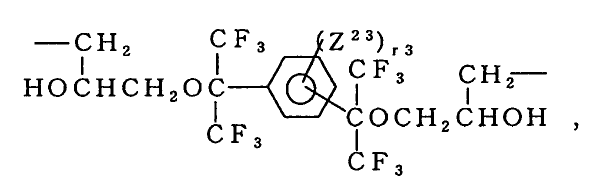 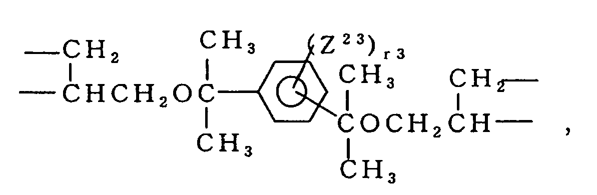 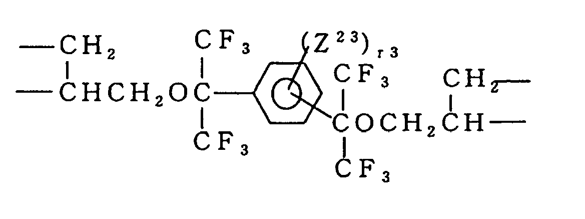 and the like wherein Z²³ and r3 are as defined in the formula (R2-6).

Preferred examples of the formula (R2-7) are: 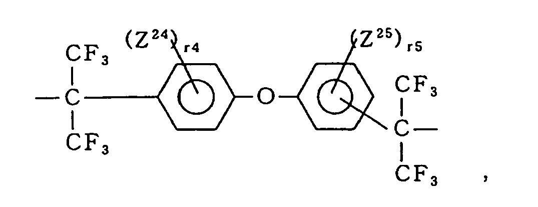 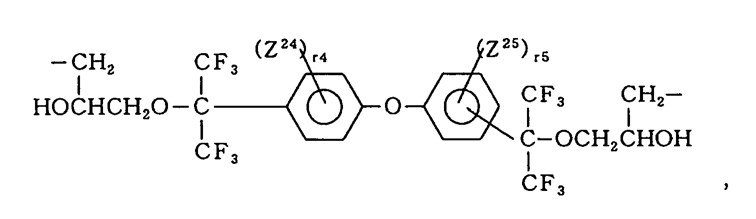 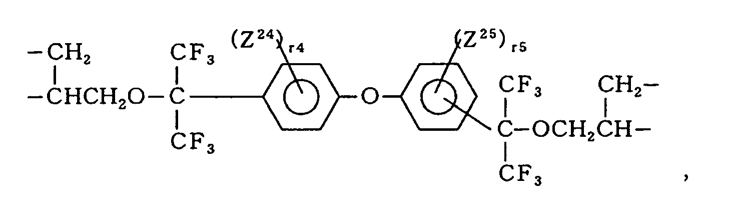 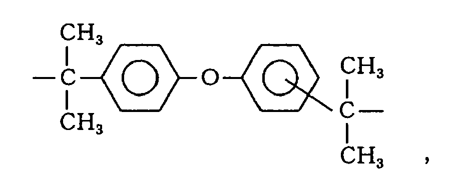 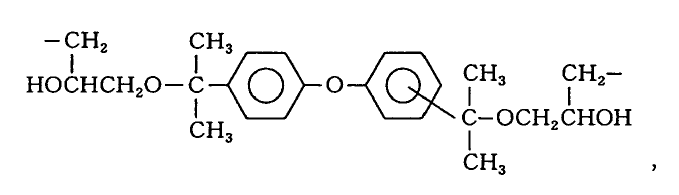 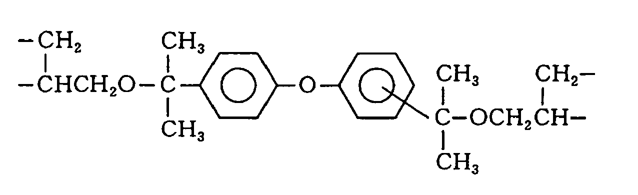 and the like wherein Z²⁴, Z²⁵, r4 and r5 are as defined in the formula (R2-7).

Preferred examples of the formula (R2-8) are: 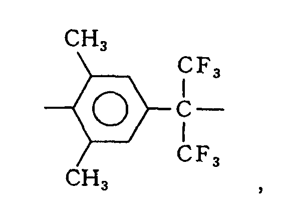 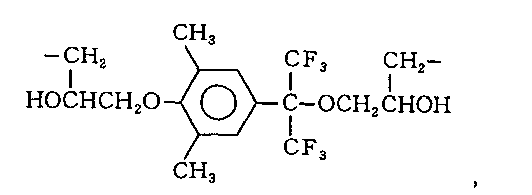 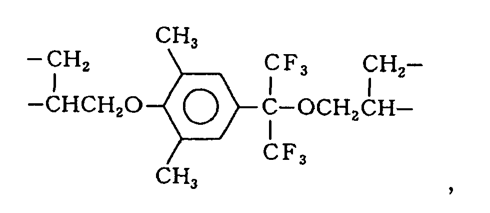 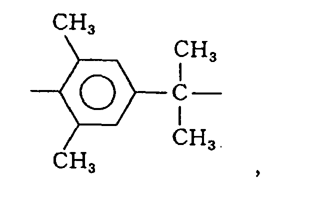 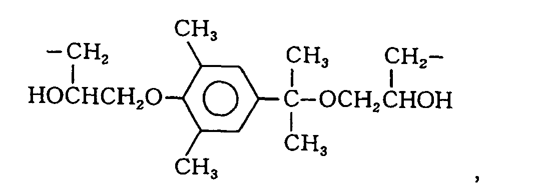 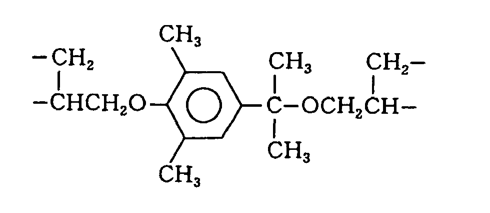 and the like.

Preferred examples of the formula (R2-9) are: 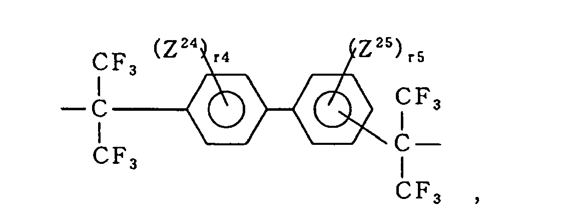 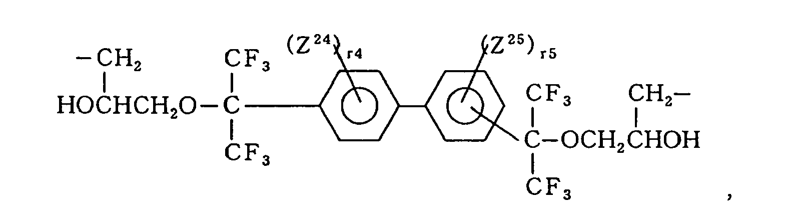 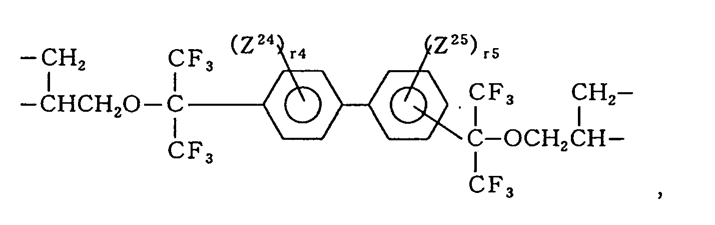 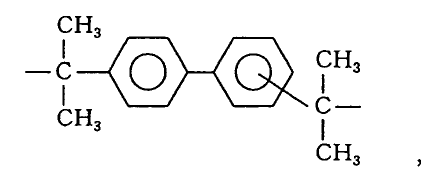 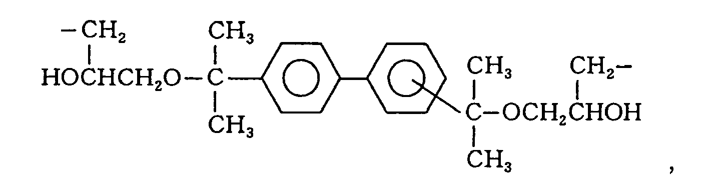 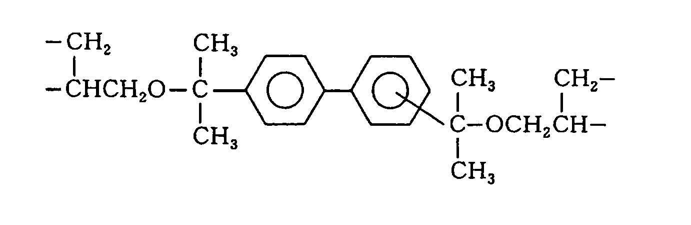 and the like wherein Z²⁴, Z²⁵, r4 and r5 are as defined in the formula (R2-9).

Preferred examples of the formula (R2-10) are: 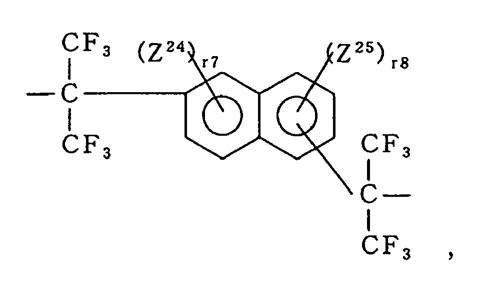 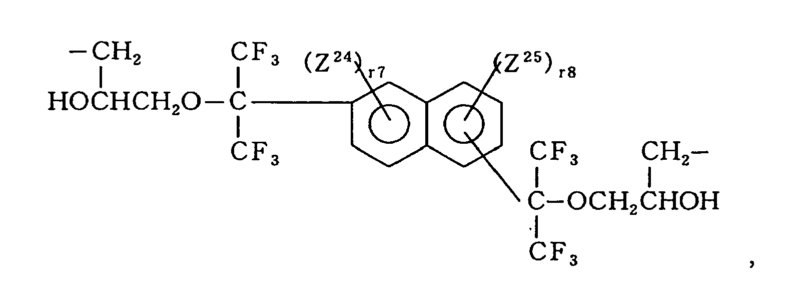 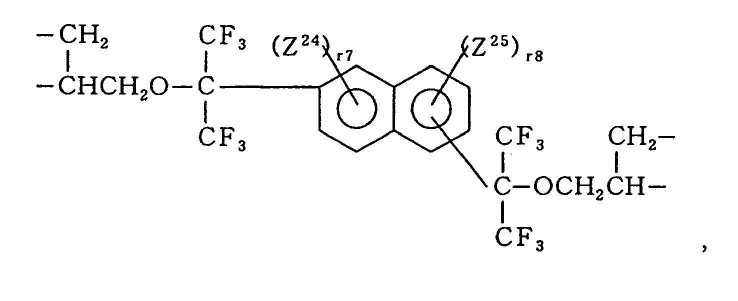 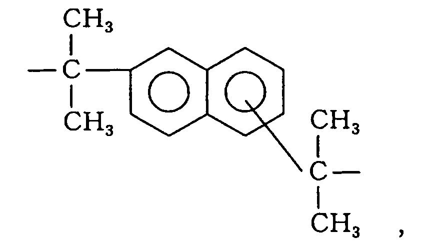 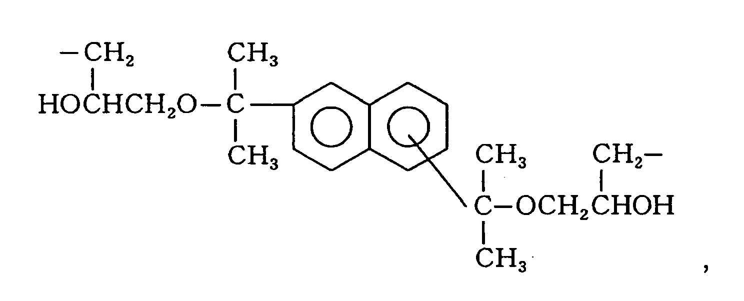 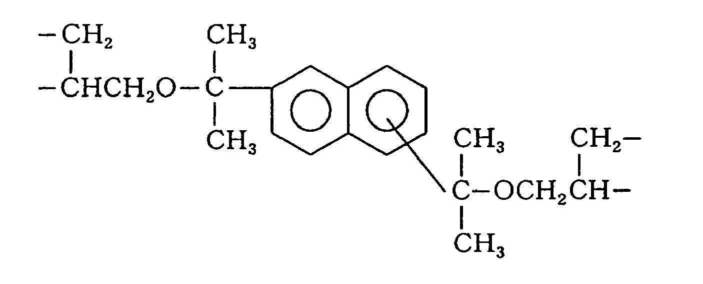 and the like wherein Z²⁴, Z²⁵, r7 and r8 are as defined in the formula (R2-10) .

Preferred examples of the formula (R2-11) are: 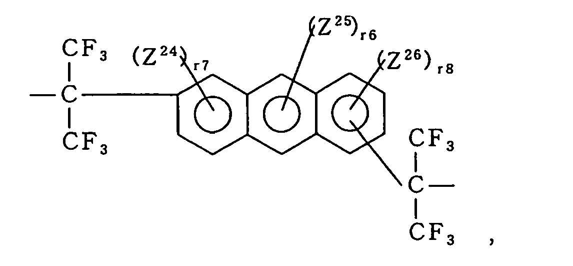 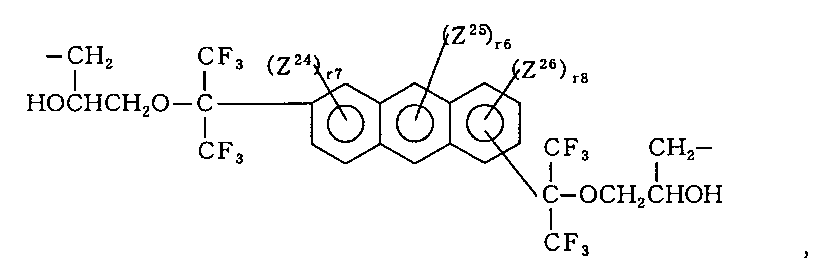 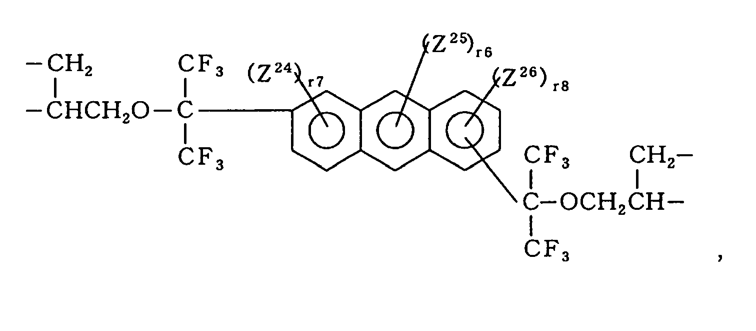 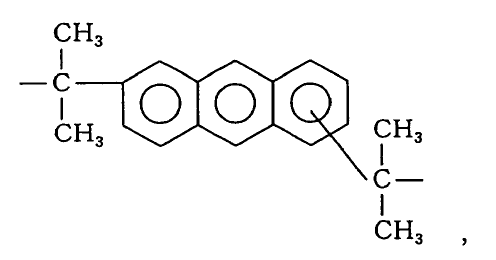 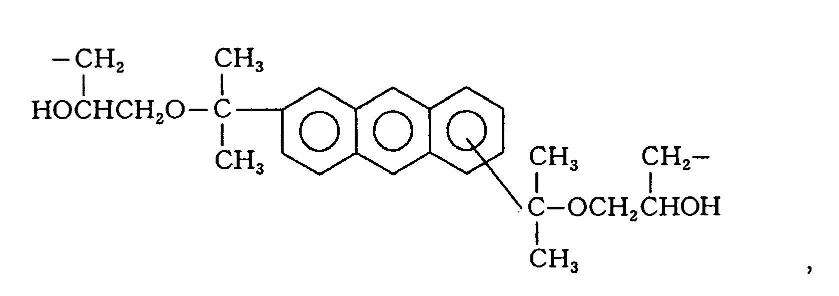 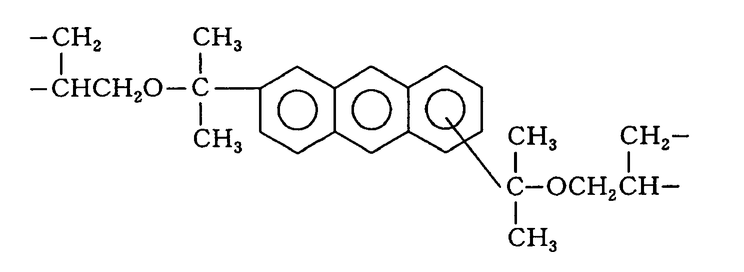 and the like wherein Z²⁴, Z²⁵, Z²⁶, r6, r7 and r8 are as defined in the formula (R2-11).

Examples of Z²¹, Z²², Z²³, Z²⁴, Z²⁵ and Z²⁶ are, for instance, hydrogen atom, fluorine atom, methyl and the like.

Those divalent or more organic groups having the aromatic ring structure are preferred because heat resistance and mechanical properties are excellent and a glass transition temperature can be set high and as a result, an intensity of light emission (amplification) and a light emitting (amplifying) efficiency can be enhanced.

Among them, those having fluorine atom are preferred because transparency to light of a near infrared region is high at light amplification for communication and also because the introduction of fluorine atom functions effectively for a light emission efficiency and an amplification efficiency.

### (3) (n1 + 1)-valent organic group having an aliphatic ring (monocyclic or polycyclic) structure

There are, for example, divalent organic groups containing a moiety represented by the formula (R2-12): 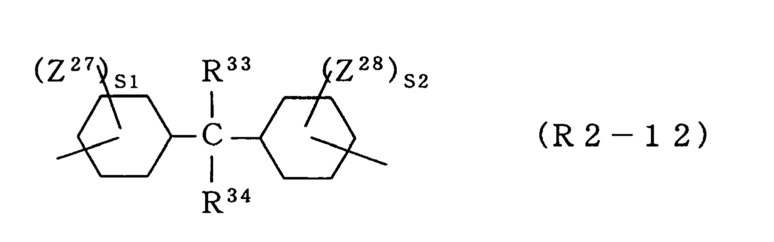 wherein R³³ and R³⁴ are the same or different and each is an alkyl group having 1 to 5 carbon atoms or a fluorine-containing alkyl group having 1 to 5 carbon atoms; Z²⁷ and Z²⁸ are the same or different and each is an alkyl group having 1 to 5 carbon atoms, a fluorine-containing alkyl group having 1 to 5 carbon atoms, a functional group, hydrogen atom or a halogen atom; s1 and s2 are the same or different and each is an integer of 1 to 4, or divalent organic groups containing a moiety represented by the formula (R2-13): 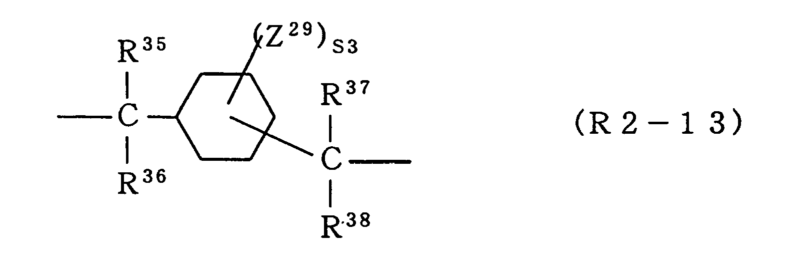 wherein R³⁵, R³⁶, R³⁷ and R³⁸ are the same or different and each is an alkyl group having 1 to 5 carbon atoms or a fluorine-containing alkyl group having 1 to 5 carbon atoms; Z²⁹ is an alkyl group having 1 to 5 carbon atoms, a fluorine-containing alkyl group having 1 to 5 carbon atoms, a functional group, hydrogen atom or a halogen atom; s3 is an integer of 1 to 4.

In addition, there are divalent organic groups containing a moiety represented by the following formulae (R2-14) to (R2-18).

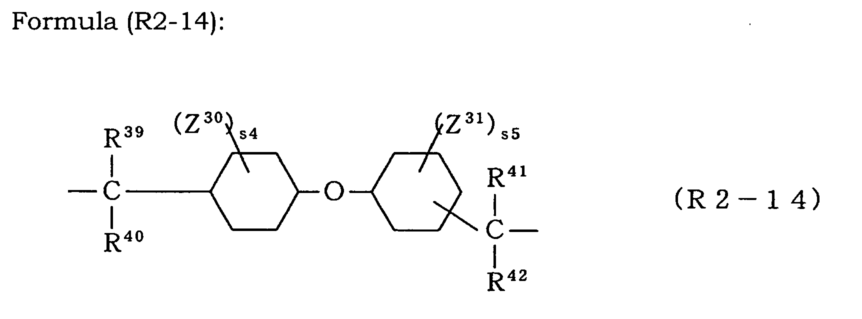

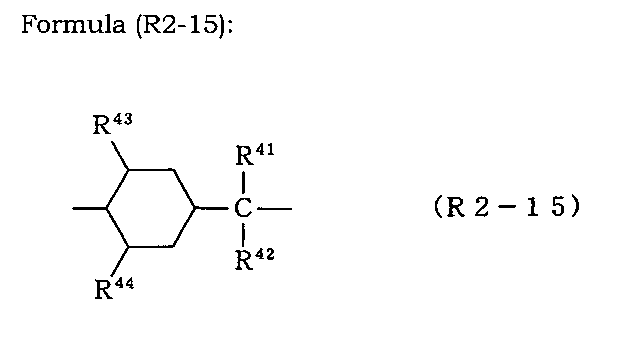

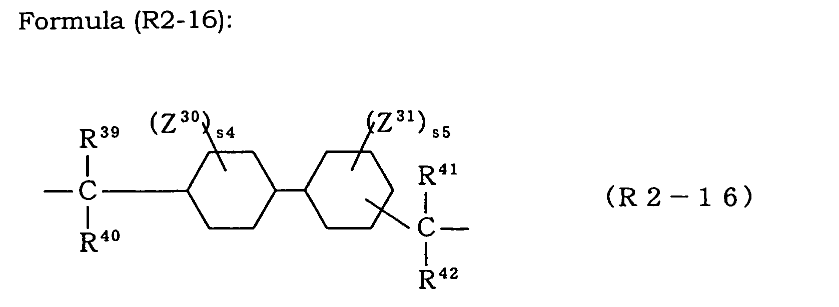

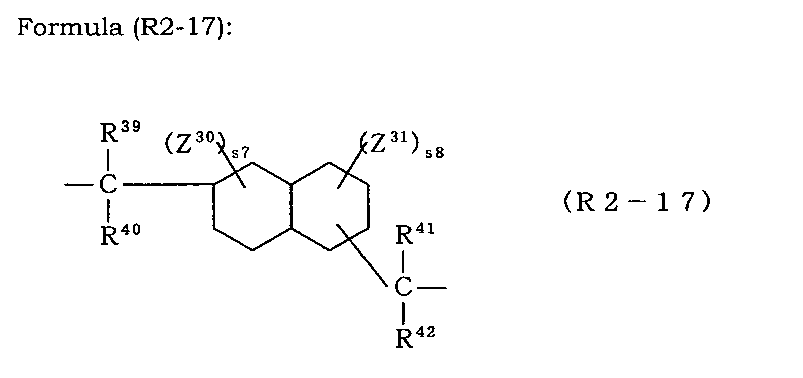

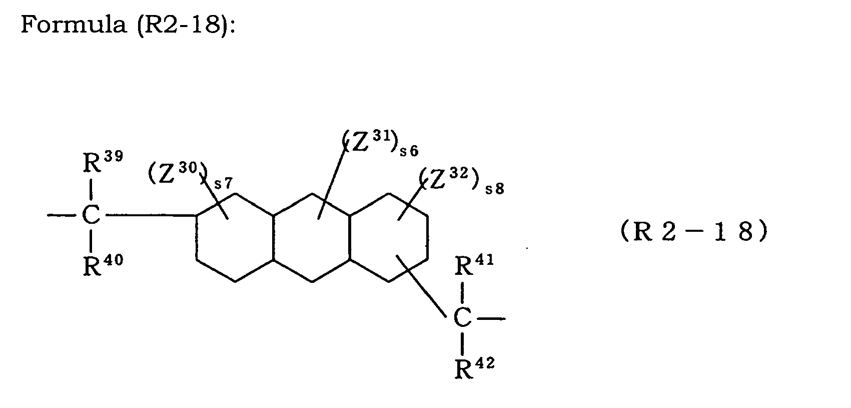

In the above formulae, R³⁹, R⁴⁰, R⁴¹ and R⁴² are the same or different and each is an alkyl group having 1 to 5 carbon atoms or a fluorine-containing alkyl group having 1 to 5 carbon atoms; R⁴³ and R⁴⁴ are the same or different and each is an alkyl group having 1 to 5 carbon atoms, a fluorine-containing alkyl group having 1 to 5 carbon atoms or hydrogen atom; Z³⁰, Z³¹ and Z³² are the same or different and each is an alkyl group having 1 to 5 carbon atoms, a fluorine-containing alkyl group having 1 to 5 carbon atoms, a functional group, hydrogen atom or a halogen atom; s4 and s5 are the same or different and each is an integer of 1 to 4; s6 is an integer of 1 to 2; s7 and s8 are the same or different and each is an integer of 1 to 3. In the different formulae, the same symbols can represent different groups or different integers.

Preferred examples of the formula (R2-12) are: 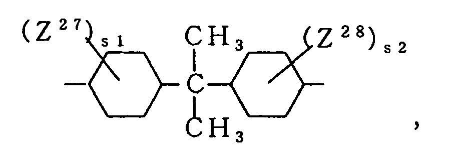 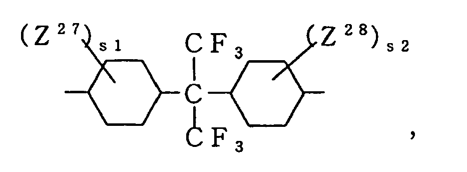 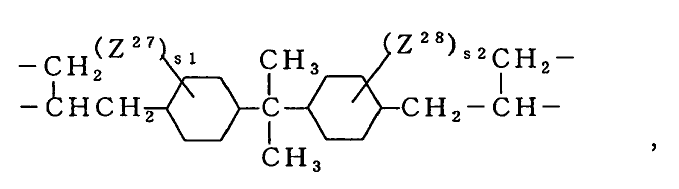 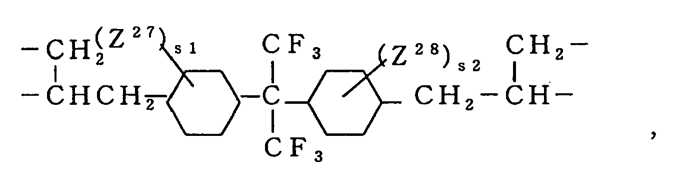 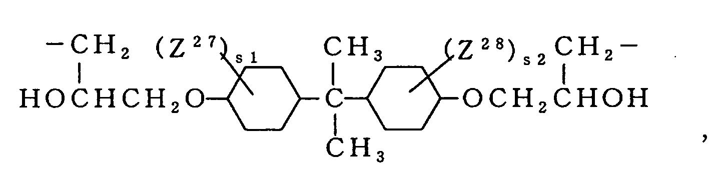 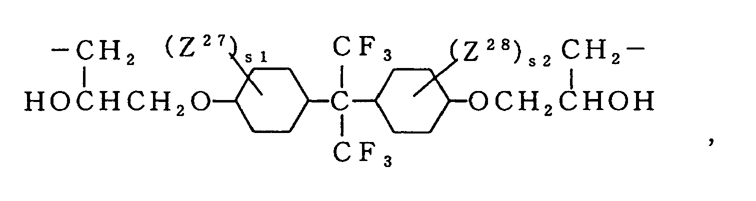 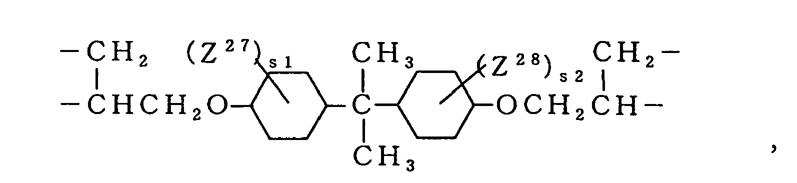 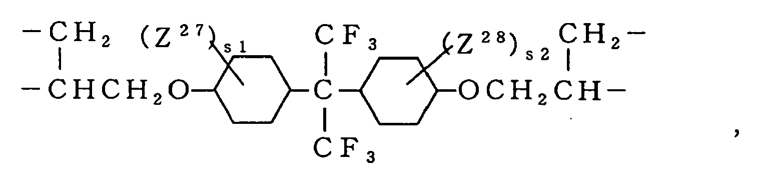 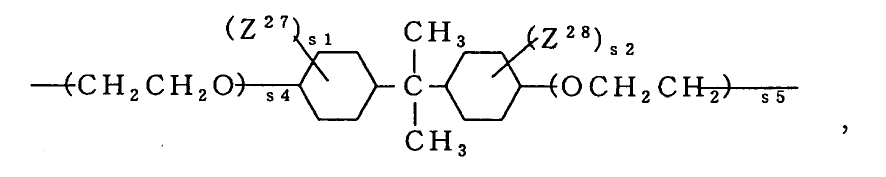 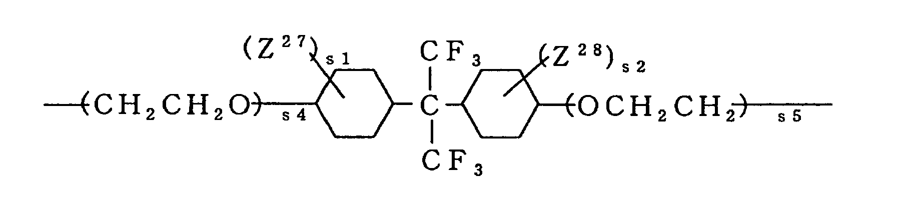 and the like, wherein s4 and s5 are the same or different and each is an integer of 1 to 10; Z²⁷, Z²⁸, s1 and s2 are as defined in the formula (R2-12).

Preferred examples of the formula (R2-13) are: 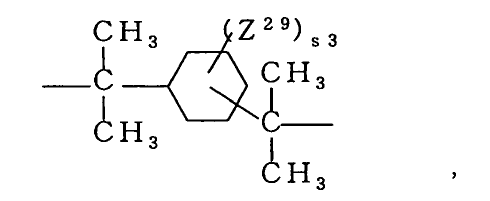 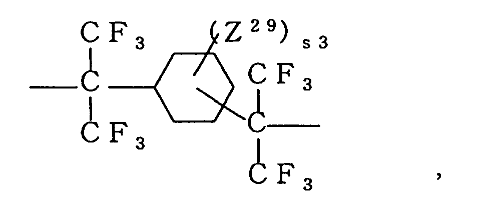 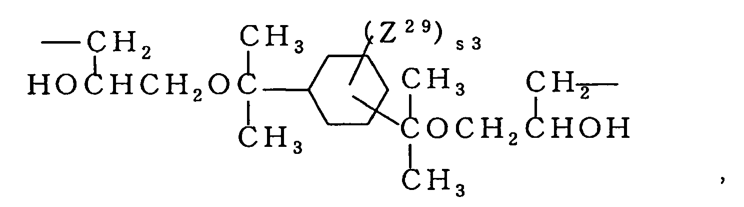 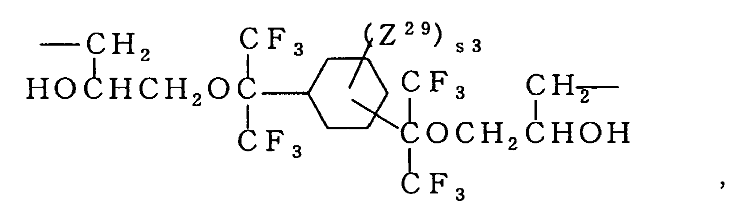 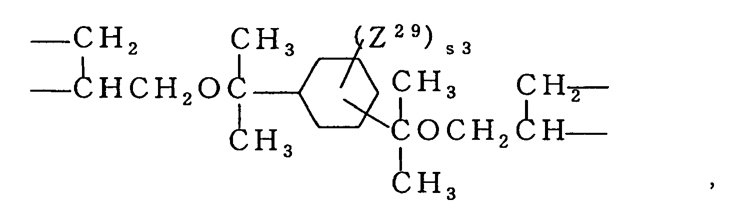 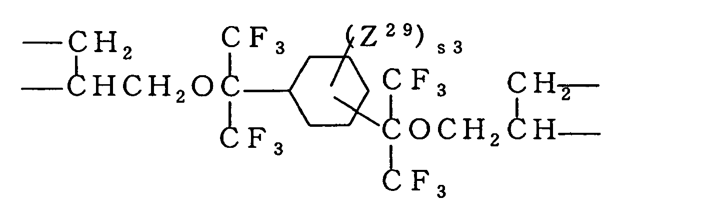 and the like, wherein Z²⁹ and s3 are as defined in the formula (R2-13).

Preferred examples of the formula (R2-14) are: 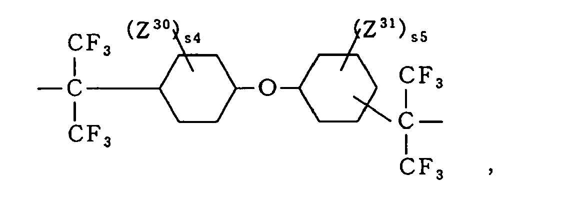 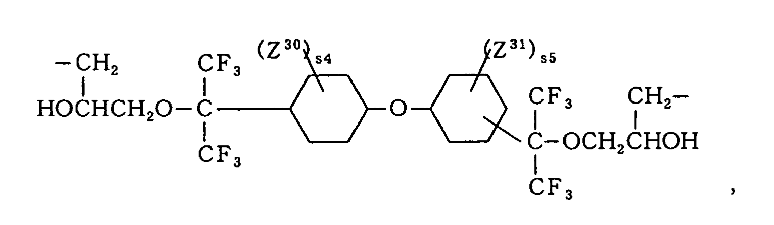 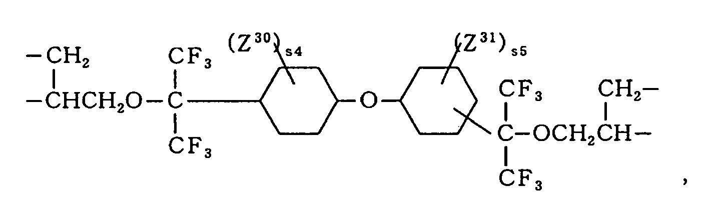 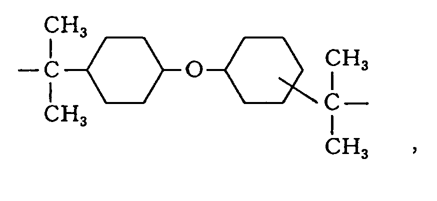 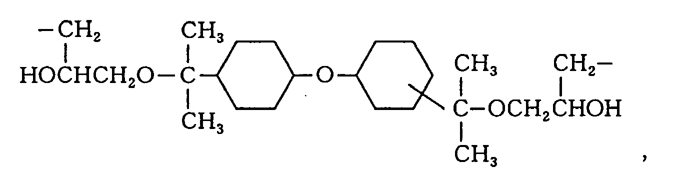 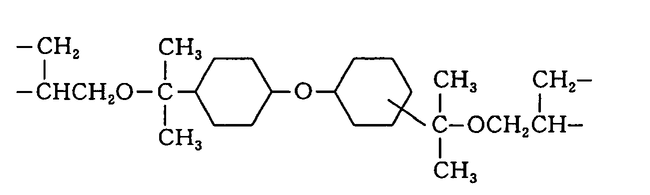 and the like, wherein Z³⁰, Z³¹, s4 and s5 are as defined in the formula (R2-14).

Preferred examples of the formula (R2-15) are: 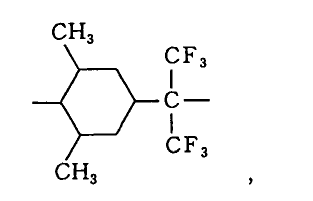 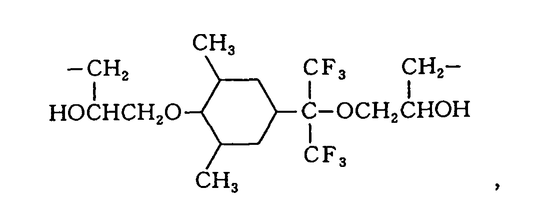 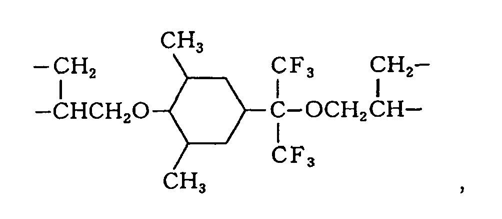 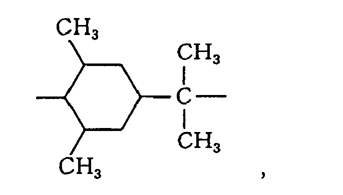 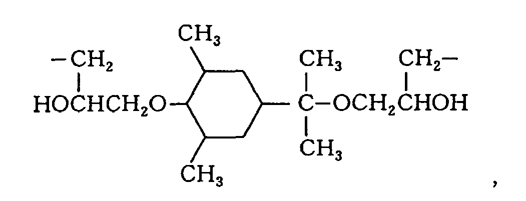 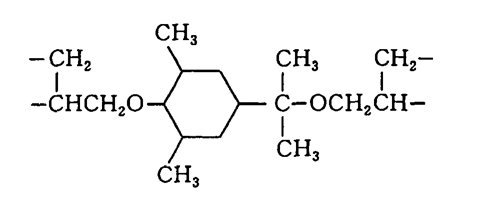 and the like.

Preferred examples of the formula (R2-16) are: 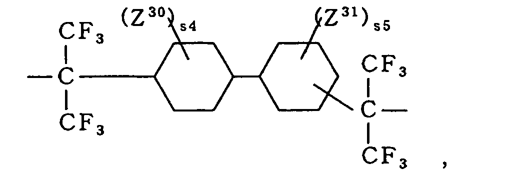 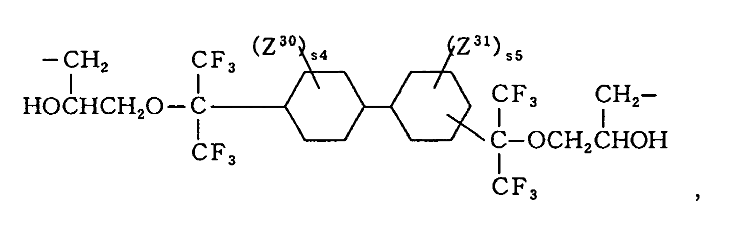 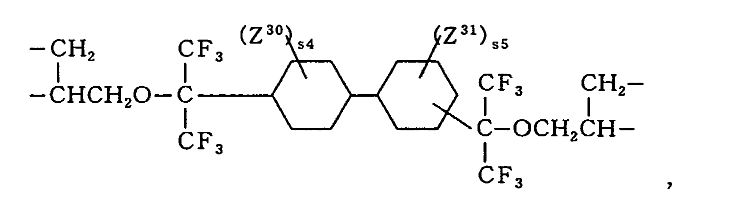 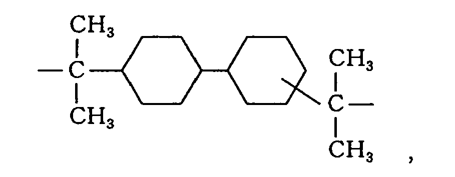 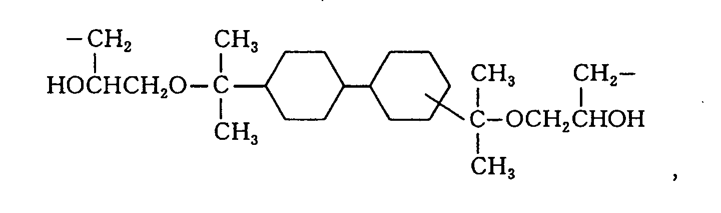 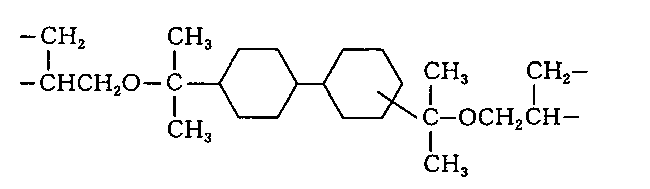 and the like, wherein Z³⁰, Z³¹, s4 and s5 are as defined in the formula (R2-16).

Preferred examples of the formula (R2-17) are: 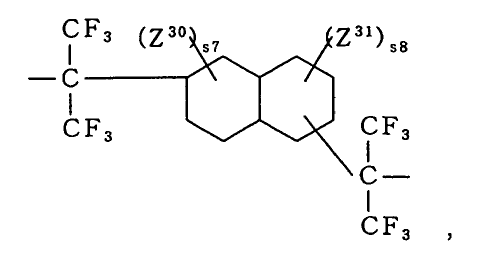 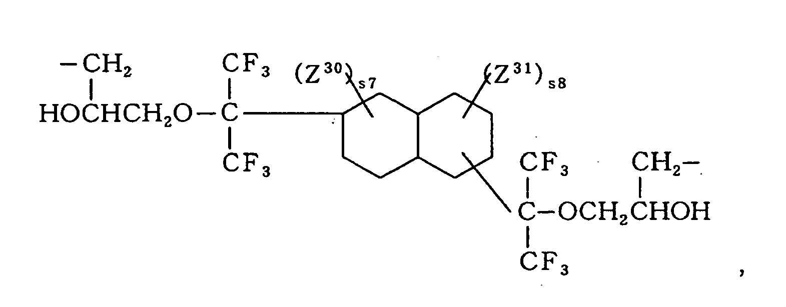 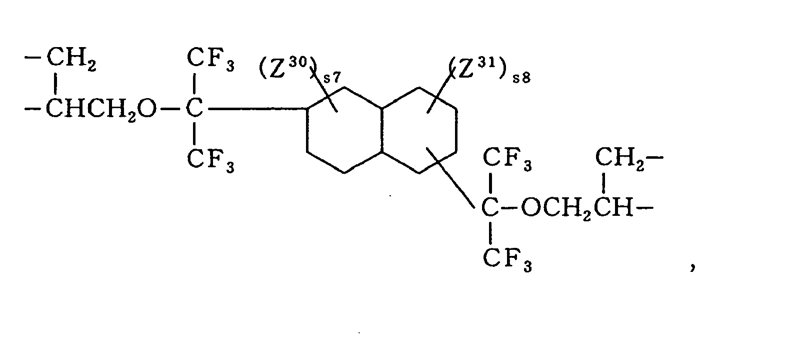 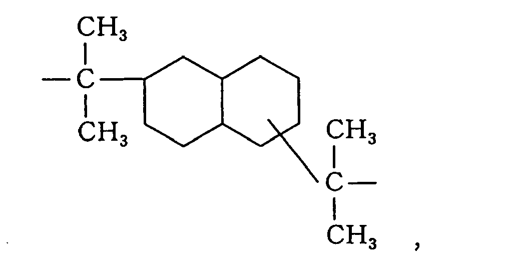 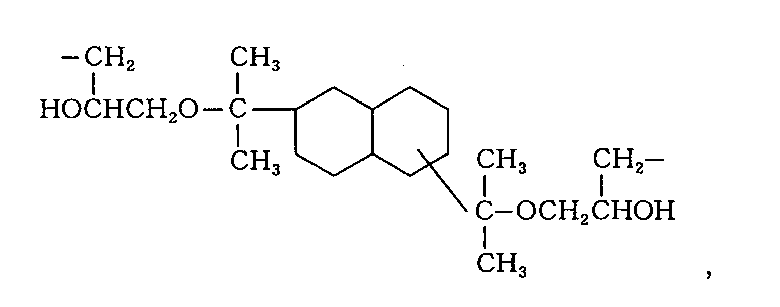 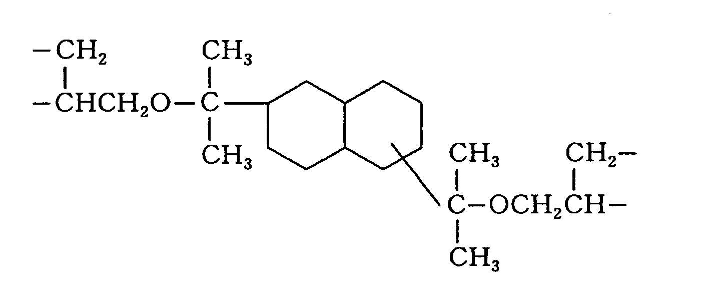 and the like, wherein Z³⁰, Z³¹, s7 and s8 are as defined in the formula (R2-17).

Preferred examples of the formula (R2-18) are: 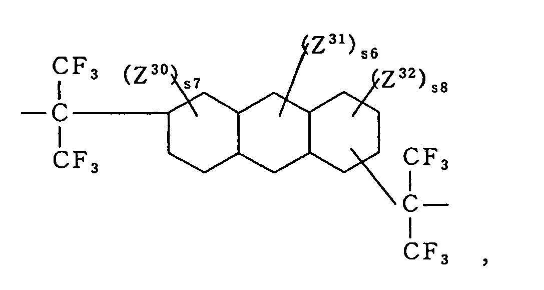 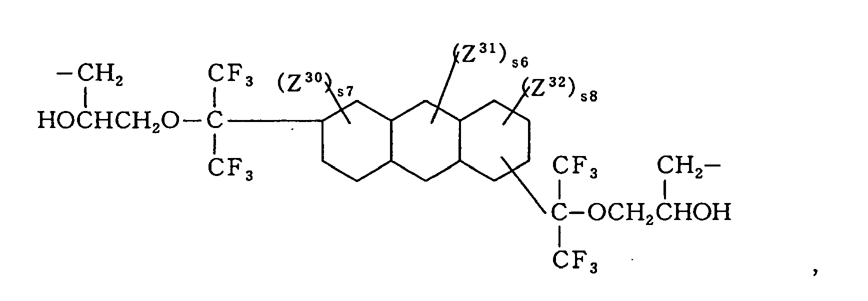 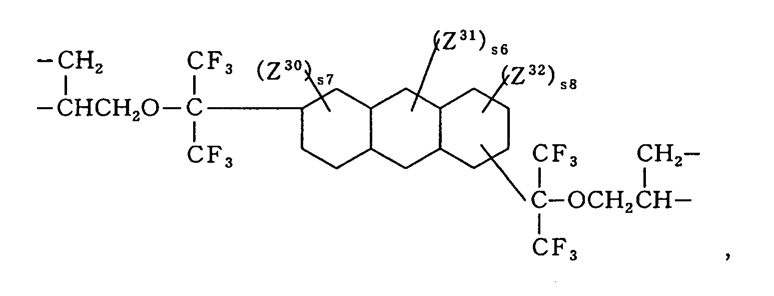 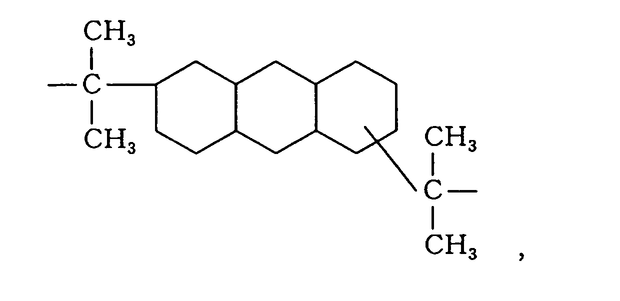 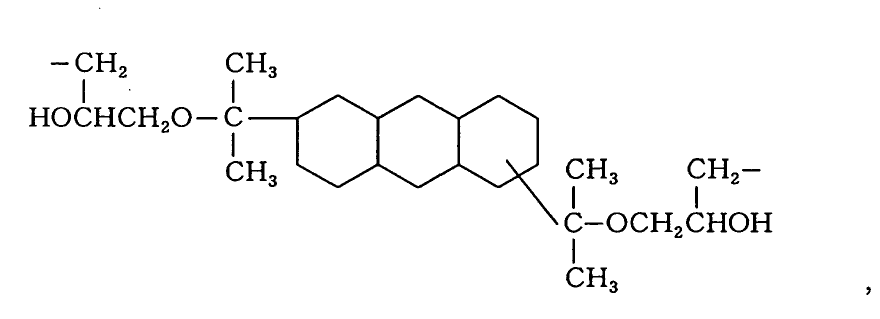 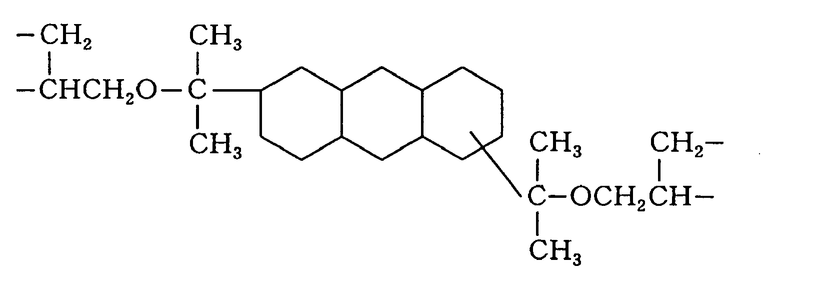 and the like, wherein Z³⁰, Z³¹, Z³², s6, s7 and s8 are as defined in the formula (R2-18).

Examples of Z²⁷, Z²⁸, Z²⁹, Z³⁰, Z³¹ and Z³² are, for instance, hydrogen atom, fluorine atom, methyl and the like.

Those divalent or more organic groups having the aliphatic ring structure are preferred because a glass transition temperature can be set high and heat resistance and mechanical properties are excellent and also because transparency to ultraviolet light usually used as excitation light for light emission is high and as a result, an intensity of light emission (amplification) and a light emitting (amplifying) efficiency can be enhanced. Also those groups are preferred because of excellent resistance to ultraviolet light.

Among them, those having fluorine atom are preferred because transparency to light of a near infrared region is high at light amplification for communication and also because the introduction of fluorine atom functions effectively for a light emitting efficiency and a light amplifying efficiency.

### (4) (n1 + 1)-valent organic group having urethane bond

Examples thereof are organic groups represented by: 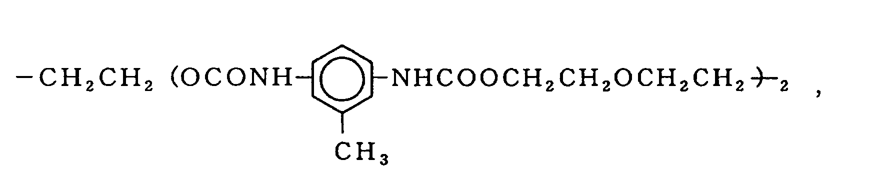 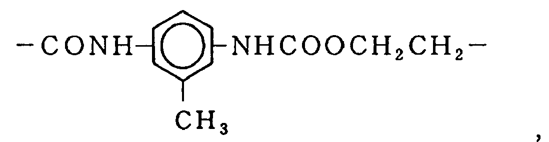 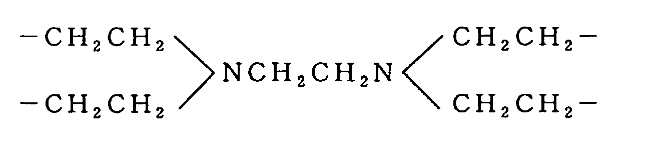 and the like.

While R² is mainly explained above, examples of the polyfunctional acrylate (a2) represented by the formula (2) are polyfunctional acrylate compounds exemplified below.

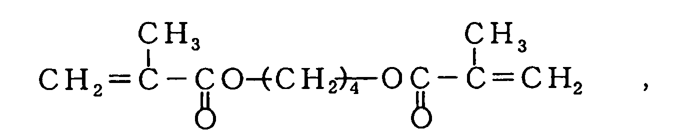

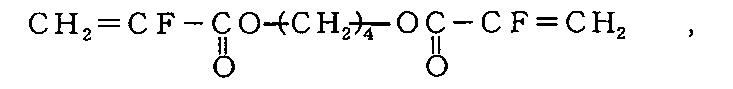

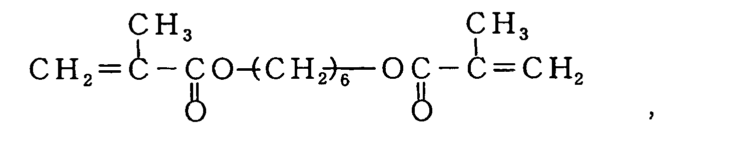

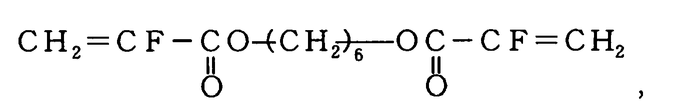

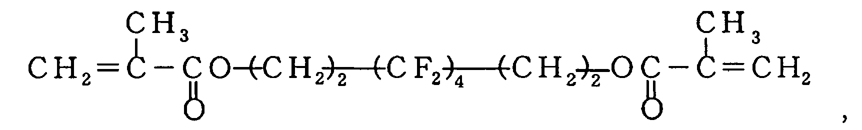

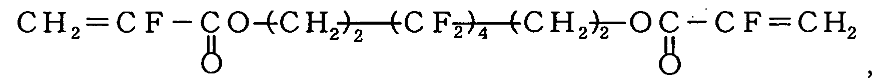

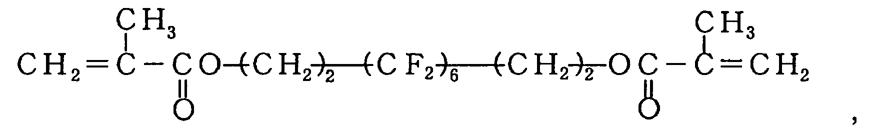

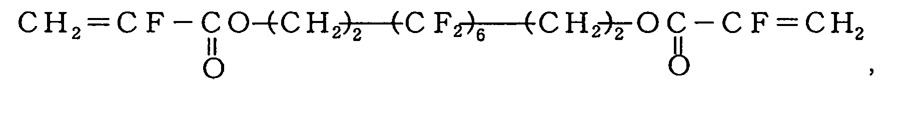

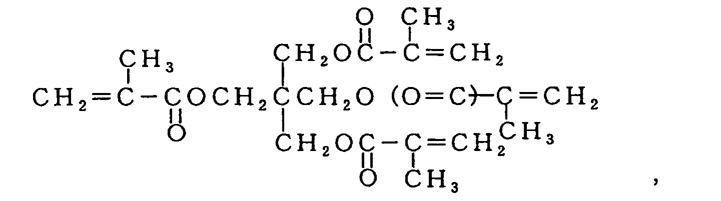

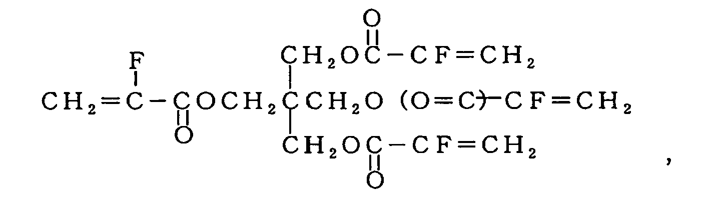

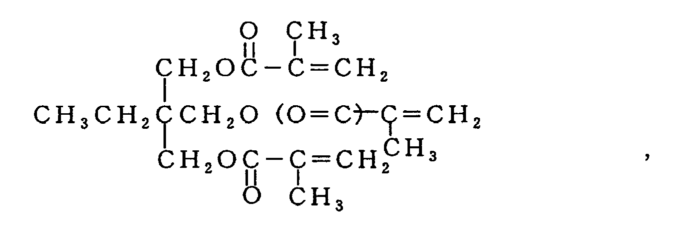

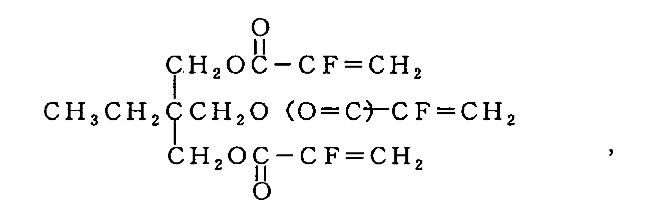

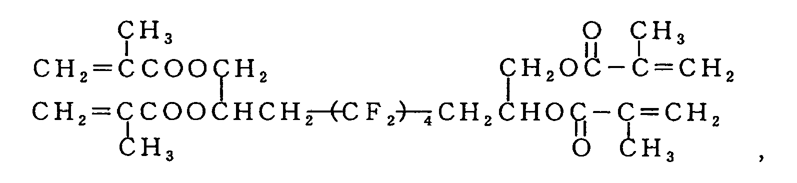

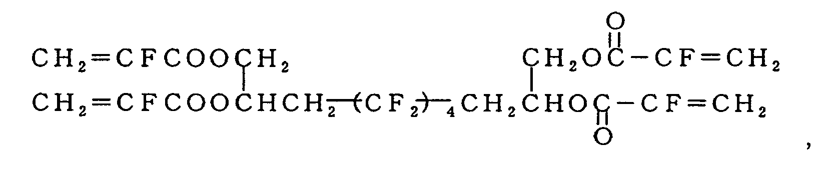

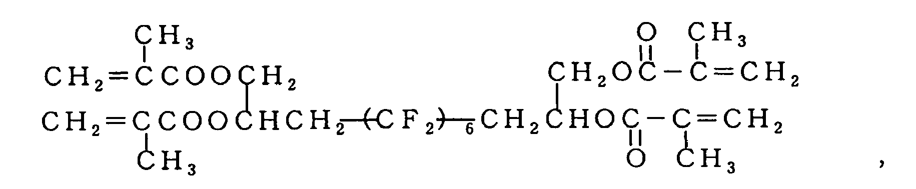

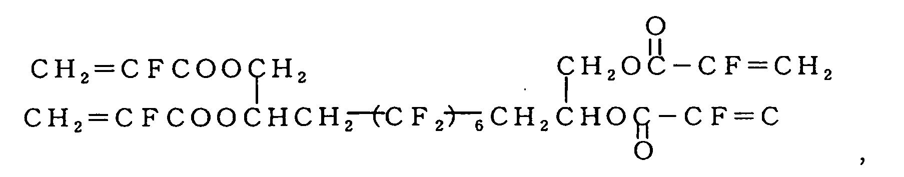

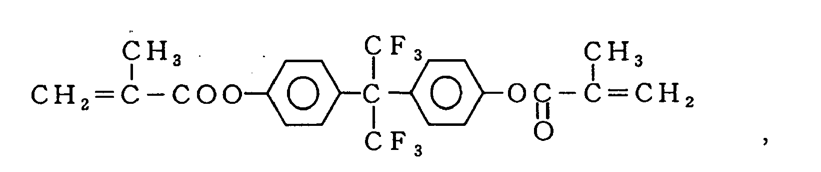

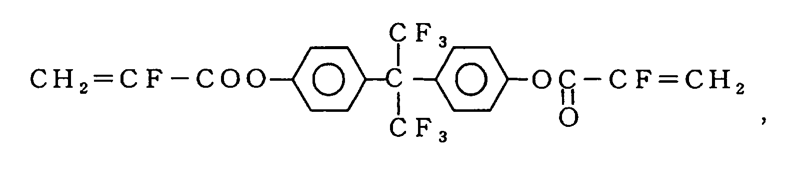

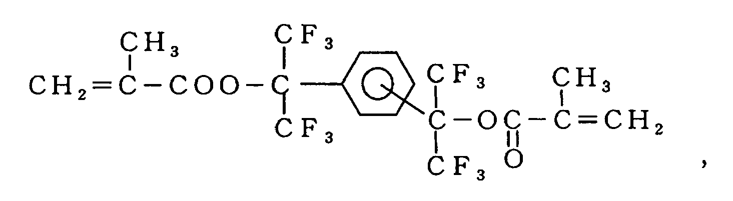

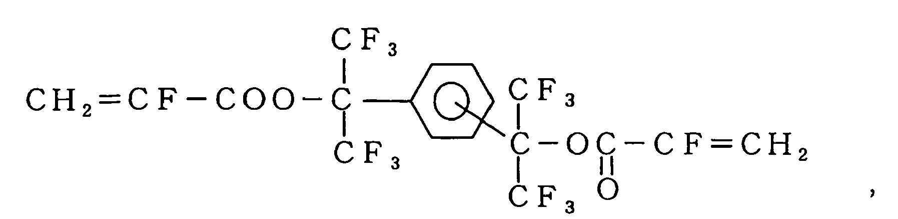

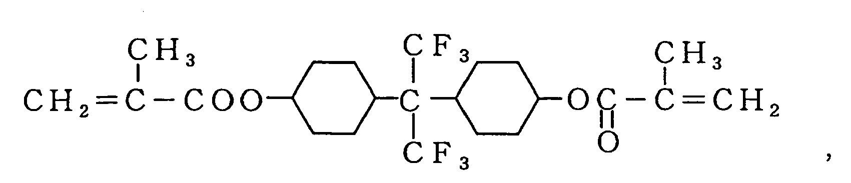

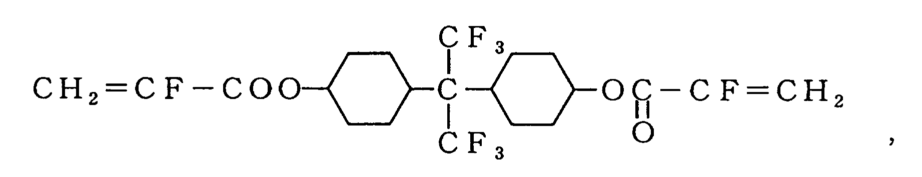

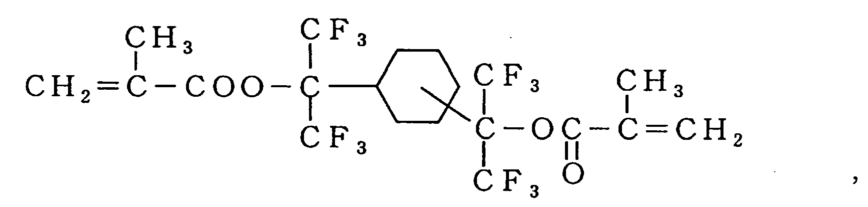

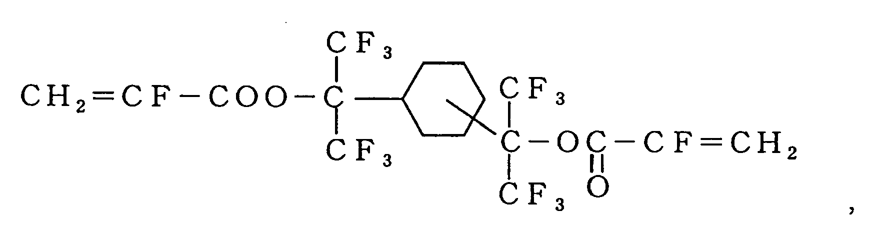

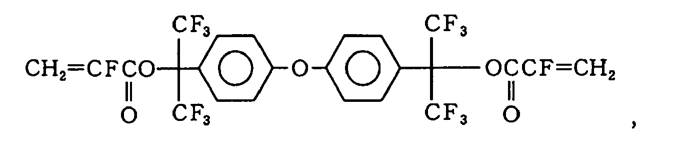

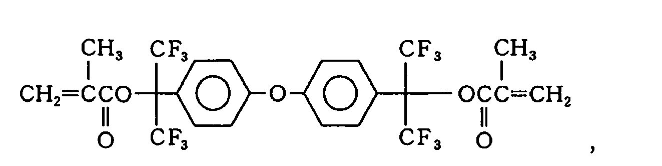

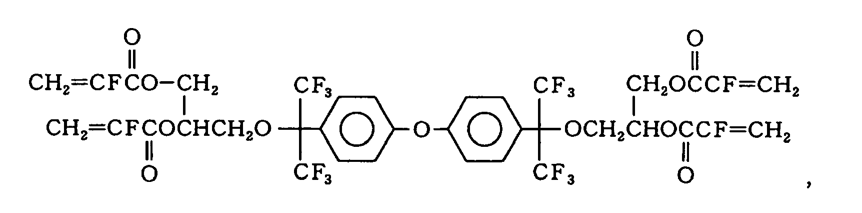

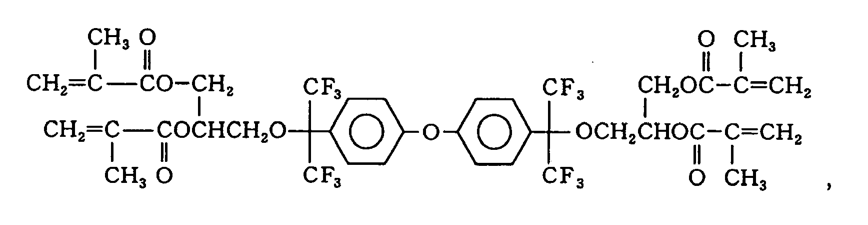

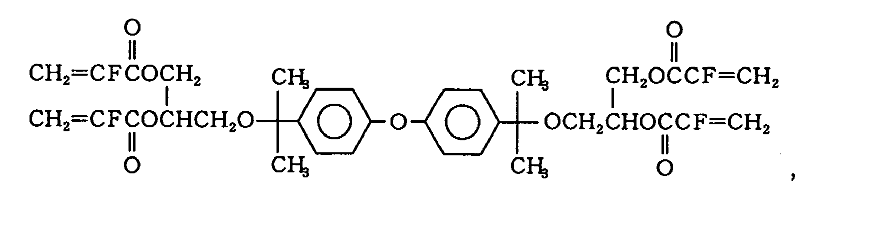

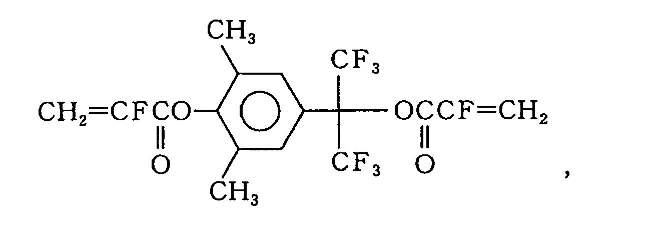

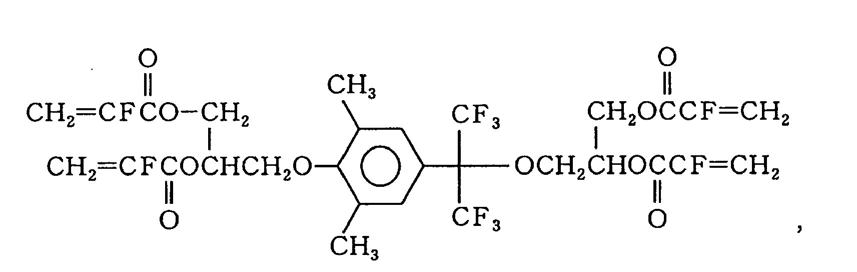

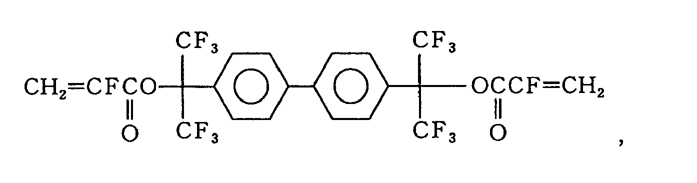

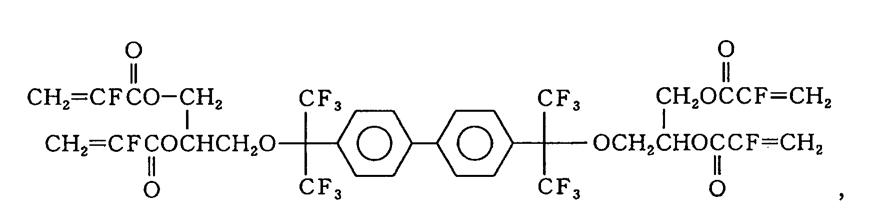

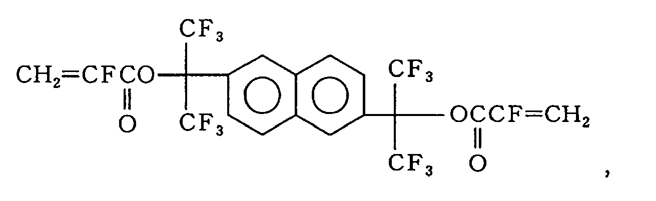

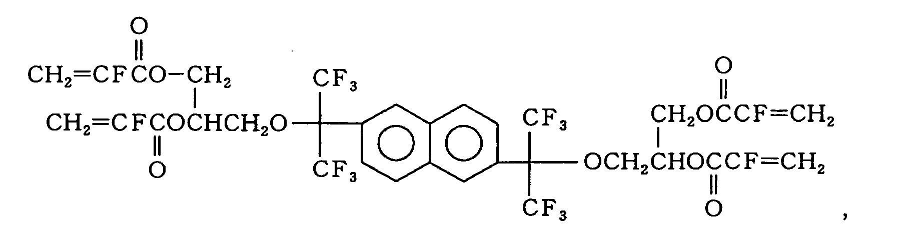

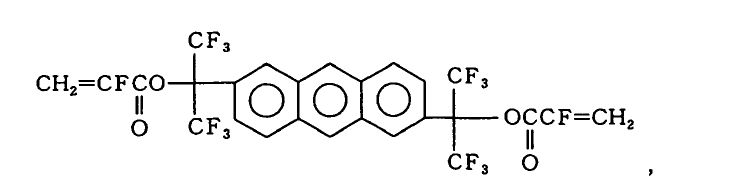

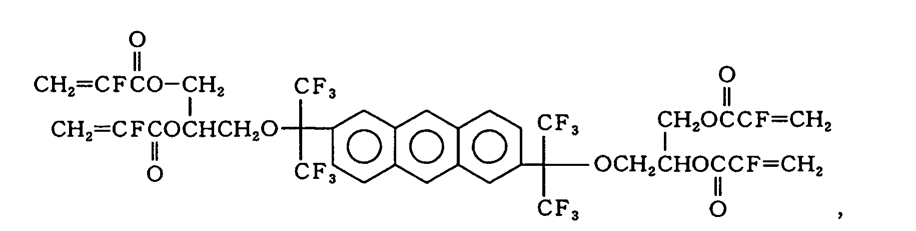

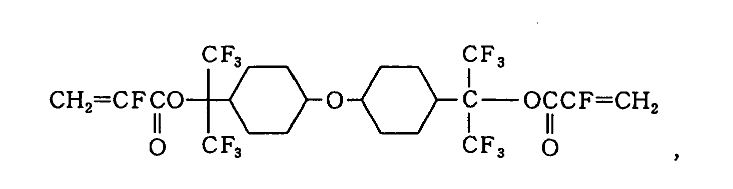

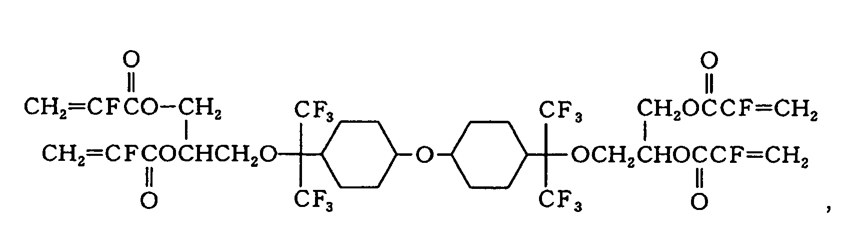

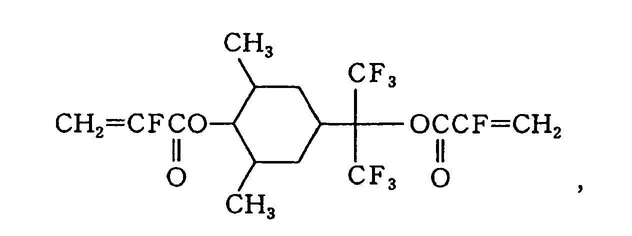

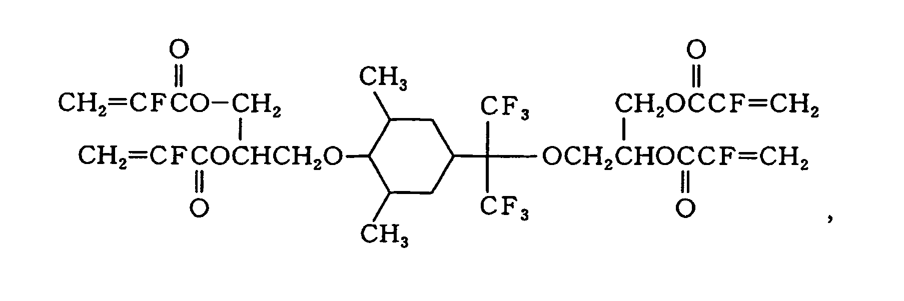

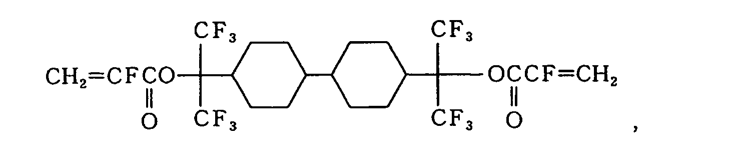

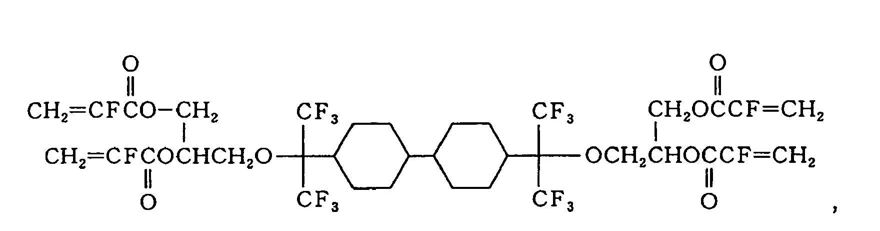

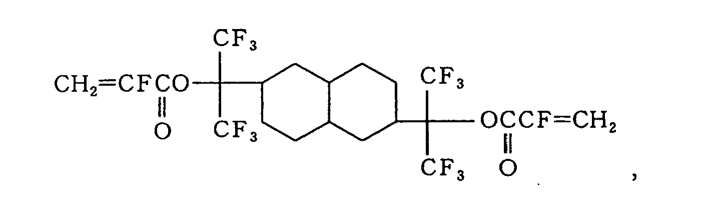

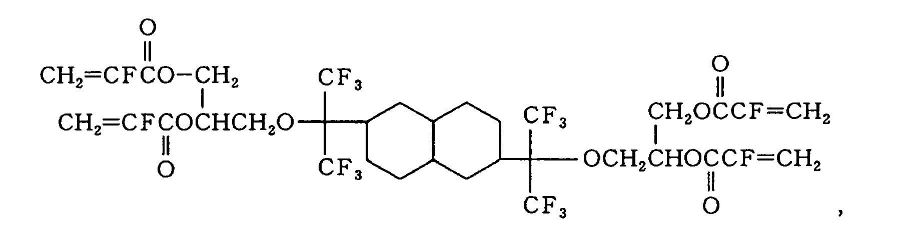

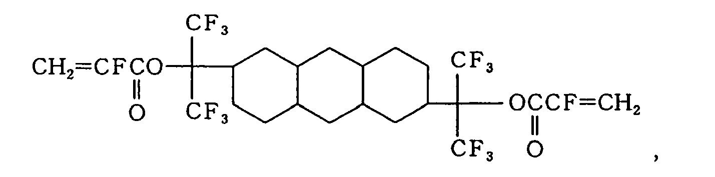

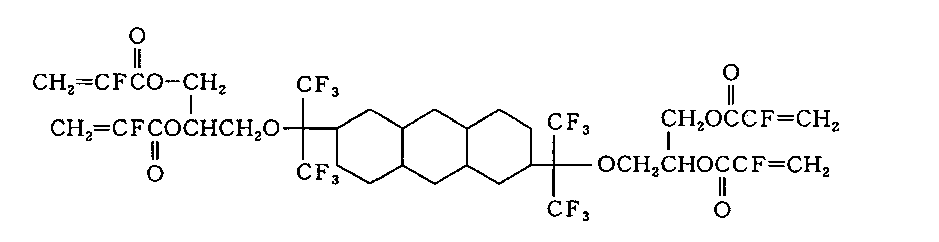

To the fluorine-containing acrylate polymer (A) to be used for the photofunctional optical material of the present invention may be introduced, as case demands, the optional structural unit N by copolymerizing the optional monomer (n) in addition to the fluorine-containing acrylate (a1) and the polyfunctional acrylate (a2).

The optional monomer (n) is not limited as long as it is copolymerizable with (a1) and (a2), and is usually selected from acrylate monomers other than (a1) and (a2), (meth)acrylic acids, fluorine-containing acrylic acids, maleic acid derivatives, vinyl chloride, ethylenes, styrene derivatives, norbornene derivatives and the like. The monomer (n) is introduced within a range not decreasing a fluorine content excessively.

The optional structural unit N is introduced, for example, for the purposes of improving dispersibility of and compatibility with the rare earth metal compound (B), adhesion to a substrate, adhesion to a substrate of other material, heat resistance and mechanical properties and adjusting a refractive index and transparency.

It is preferable that the structural unit N is selected from structural units derived from monomers such as acrylate monomers other than (a1) and (a2), (meth)acrylic acids, fluorine-containing (meth)acrylic acids and maleic acid derivatives.

Preferred examples of the acrylate monomer are (meth)acrylate monomers having a linear or branched alkyl group having 1 to 20 carbon atoms in the side chain thereof such as methyl methacrylate (MMA), methyl acrylate (MA), ethyl methacrylate (EMA), ethyl acrylate (EA), isopropyl methacrylate, isopropyl acrylate, butyl methacrylate, butyl acrylate, hexyl methacrylate, hexyl acrylate, octadecyl methacrylate and octadecyl acrylate.

Also there are (meth)acrylate monomers having functional group such as hydroxyl, epoxy or carboxyl in the side chain thereof such as hydroxyethyl methacrylate (HEMA), hydroxyethyl acrylate, glycidyl methacrylate (GMA) and glycidyl acrylate.

Also there are (meth)acrylate monomers which have, in the side chain thereof, a hydrocarbon group having 3 to 20 carbon atoms and containing an aromatic ring structure, for example, (meth)acrylate monomers having a benzene ring structure, naphthyl ring structure or heterocyclic structure in the side chain thereof, and examples are phenyl methacrylate, phenyl acrylate, benzyl methacrylate, benzyl acrylate, naphthyl methacrylate and naphthyl acrylate.

Also there are (meth)acrylate monomers which have, in the side chain thereof, a hydrocarbon group having 3 to 20 carbon atoms and containing an aliphatic ring structure, for example, (meth)acrylate monomers having a cyclohexyl structure, norbornane structure, decalin structure or adamantyl structure in the side chain thereof, and examples are cyclohexyl methacrylate, cyclohexyl acrylate, adamantyl methacrylate, adamantyl acrylate, methyl adamantyl methacrylate, methyl adamantyl acrylate, ethyl adamantyl methacrylate and ethyl adamantyl acrylate.

Examples of the (meth)acrylic acids and fluorine-containing (meth)acrylic acids are, for instance, methacrylic acids, acrylic acids, α-fluoroacrylic acids, α-trifluoromethyl acrylic acids and the like.

Preferred examples of the maleic acid derivatives are maleic acid, maleic anhydride, maleic acid monoesters (for example, maleic acid monomethyl ester, maleic acid monoethyl ester, maleic acid monopropyl ester and the like), maleic acid diesters (for example, maleic acid dimethyl ester, maleic acid diethyl ester, maleic acid dipropyl ester and the like) and the like.

The fluorine-containing acrylate polymer (A) to be used for the photofunctional optical material of the present invention is prepared by polymerizing the fluorine-containing acrylate (a1) and the polyfunctional acrylate (a2), and contains, as essential components, the structural unit A1 derived from the monomer (a1) and the structural unit A2 derived from the monomer (a2). The structural unit A1 and the structural unit A2 are contained in amounts of from 20 to 99.9 % by mole and from 0.1 to 80 % by mole, respectively.

The fluorine-containing acrylate polymer (A) to be used for the photofunctional optical material of the present invention is characterized by containing the structural unit A2 of the polyfunctional acrylate (a2), thereby enabling an intensity of light emission (amplification) and a light emitting (amplifying) efficiency of the photofunctional optical material to be enhanced remarkably.

On the other hand, by the introduction of the structural unit A1, the fluorine content of the polymer can be increased, thereby being capable of further enhancing an intensity of light emission (amplification) and a light emitting (amplifying) efficiency of the photofunctional optical material.

The fluorine content of the fluorine-containing acrylate polymer of the present invention is preferably not less than 20 % by mass, more preferably not less than 30 % by mass, particularly preferably not less than 50 % by mass.

The preferred proportions of the structural units A1 and A2 vary depending on kinds of the monomers (a1) and (a2), and a molar ratio of the structural unit A1/A2 is 30/70 to 99/ 1, more preferably 40/60 to 98/2, particularly preferably 50/50 to 95/5.

If the proportion of the structural unit A1 is too small, there is a tendency that the fluorine content in the fluorine-containing acrylate polymer (A) is decreased, and a sufficient intensity of light emission (amplification) and a sufficient light emitting (amplifying) efficiency are difficult to obtain.

If the proportion of the structural unit A2 is too small, there is a tendency that it becomes difficult to regulate motions of the polymer molecules themselves, and as a result, a sufficient intensity of light emission (amplification) and a sufficient light emitting (amplifying) efficiency are difficult to obtain.

On the contrary, if the proportion of the structural unit A2 is too large, there is a tendency that mechanical properties of the fluorine-containing acrylate polymer (A) are lowered, for example, the polymer becomes fragile and compatibility with the rare earth metal compound (B) is lowered, thereby causing a phase separation and lowering effects on an intensity of light emission (amplification) and a light emitting (amplifying) efficiency.

The optional structural unit N is introduced to an extent not impairing effects on an intensity of light emission (amplification) and a light emitting (amplifying) efficiency by the structural units A1 and A2. It is usually preferable that the proportion of the structural unit N is not more than 60 % by mole, preferably not more than 50 % by mole, more preferably not more than 30 % by mole, particularly not more than 10 % by mole based on the whole monomers in the fluorine-containing acrylate polymer (A).

Next, the rare earth metal compound (B) in the photofunctional optical material of the present invention is explained below.

The rare earth element to be used for the rare earth metal compound (B) is at least one kind selected from 17 elements in scandium elements and lanthanoids excluding actinium in Periodic Table. Among them, preferred are erbium (Er), thulium (Tm), praseodymium (Pr), holmium (Ho), neodymium (Nd), europium (Eu), cerium (Ce), samarium (Sm), dysprosium (Dy), terbium (Tb) and the like.

Kind of the rare earth element to be used is selected from the above-mentioned elements depending on applications such as light emission, light amplification and conversion of wavelength and also depending on kind (wavelength) of required light.

For example, in light amplification application in optical communication using near infrared light of 1,300 to 1,550 nm wavelength, it is preferable to select from rare earth elements having an ability of generating fluorescence of near infrared region.

Concretely there are rare earth elements such as praseodymium (fluorescence wavelength: 1,300 nm) and erbium (fluorescence wavelength: 1,550 nm). In a light amplification application in optical communication using near infrared light of 850 nm wavelength, neodymium (fluorescence wavelength: 850 nm) is preferred. In a light amplification application in optical communication using visible light of 650 nm wavelength, europium (fluorescence wavelength: 615 nm) is preferred.

In applications to light emission device and wavelength conversion material, a rare earth element generating light of necessary wavelength as a fluorescence is selected.

For example, in light emission application, it is preferable to select from terbium (fluorescence wavelength: 532 nm) emitting green light, europium (fluorescence wavelength: 615 nm) emitting red light and the like.

The rare earth metal compound (B) in the photofunctional material of the present invention means (B1) a rare earth metal complex (a state of forming a complex with a ligand), (B2) an inorganic phosphor activated with rare earth element (a state of being activated in an inorganic salt) and (B3) a rare earth metal ion (a state of being present in the form of usual ionic bonding), and particularly preferred are a rare earth metal complex and an inorganic phosphor activated with rare earth element. Especially preferred is a rare earth metal complex.

Each rare earth metal compound is then explained below.

### (B1) Rare earth metal complex

The rare earth metal complex is preferred because its light emission (amplification) efficiency is high and also because of excellent dispersibility in and compatibility with the fluorine-containing acrylate polymer (A).

Namely, the rare earth metal complex usually contains at least one ligand bonded to the rare earth element by coordination, and unlike a rare earth metal ion, the rare earth element is surrounded by ligands. Therefore in the light emitting process of the excited rare earth element, the stored energy of the rare earth element is inhibited from escaping to the ambient matrix molecules (polymer molecules and the like), and as a result, an intensity and efficiency of light emission from the rare earth metal are increased.

As long as the ligands of the rare earth metal complex contain an atom having π-electron (for example, hetero atoms or the like) or an unsaturated bond, any of inorganic and organic ligands may be used, and organic compounds having carbon-carbon double bond, carbon-hetero atom double bond or hetero atom-hetero atom double bond are preferred especially because of excellent dispersibility in and compatibility with the fluorine-containing acrylate polymer (A) to be used in the present invention.

Further it is preferable that the rare earth metal complex contains electric charge compensation type ligand which itself forms an anion and forms a coordination bond and ionic bond with rare earth metal ion (cation), from the viewpoint of excellent stability, heat resistance and resistance to ultraviolet light of the rare earth metal complex.

Examples of the electric charge compensation type ligand are, for instance, a ligand having a structural unit represented by the formula (b1): 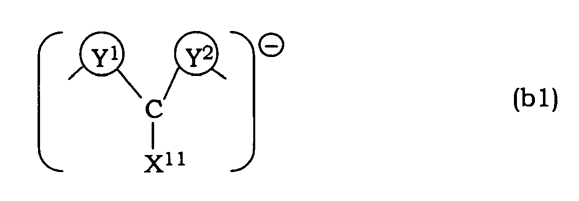 I
wherein Y¹ and Y² are the same or different and each is 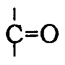 or 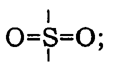 X¹¹ is selected from hydrogen atom, heavy hydrogen atom, fluorine atom, a hydrocarbon group having 1 to 20 carbon atoms and a fluorine-containing hydrocarbon group having 1 to 20 carbon atoms in which a part or the whole of hydrogen atoms are replaced by fluorine atoms,
a ligand having a structural unit represented by the formula (b2): 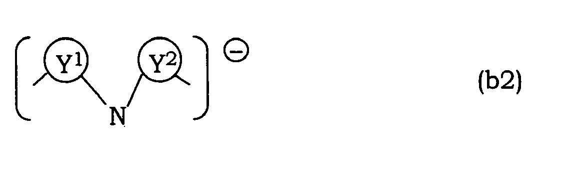 wherein Y¹ and Y² are as defined in the formula (b1), and a ligand having a structural unit represented by the formula (b3): 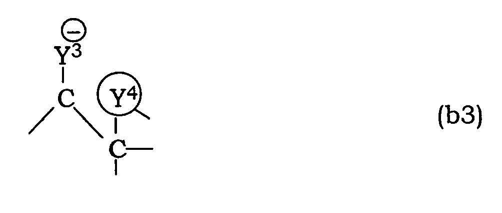 wherein Y³ is selected from O, S and N-R' (R' is selected from hydrogen atom, a hydrocarbon group having 1 to 20 carbon atoms and a fluorine-containing hydrocarbon group having 1 to 20 carbon atoms in which a part or the whole of hydrogen atoms are replaced by fluorine atoms); Y⁴ is at least one selected from 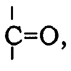 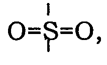 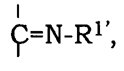 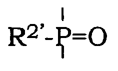 and 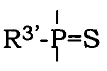 (R^{1'} is selected from hydrogen atom, a hydrocarbon group having 1 to 20 carbon atoms and a fluorine-containing hydrocarbon group having 1 to 20 carbon atoms in which a part or the whole of hydrogen atoms are replaced by fluorine atoms, and R^{1'} may form a ring structure with the carbon atom in C=N; R^{2'} and R^{3'} are the same or different and each is selected from a hydrocarbon group having 1 to 20 carbon atoms and a fluorine-containing hydrocarbon group having 1 to 20 carbon atoms in which a part or the whole of hydrogen atoms are replaced by fluorine atoms, and R^{2'} and R^{3'} may form a ring structure with the phosphorous atom.

Examples of the ligand having the structure of the formula (b1) are, for instance, those raised below.

### (b1-1) Ligands having β-diketone structure

Those ligands are concretely represented by the formula (b1-1): 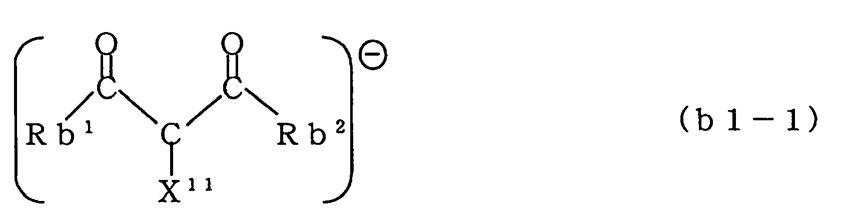 wherein Rb¹ and Rb² are the same or different and each is at least one selected from a hydrocarbon group having 1 to 20 carbon atoms, a fluorine-containing hydrocarbon group having 1 to 20 carbon atoms in which a part or the whole of hydrogen atoms are replaced by fluorine atoms and a hydrocarbon group having 1 to 20 carbon atoms and containing a heterocyclic structure; X¹¹ is as defined in the formula (b1). Those ligands are preferred because of good light emitting efficiency, good amplifying efficiency and good compatibility of the formed complex with the fluorine-containing acrylate polymer (A).

Examples thereof are: 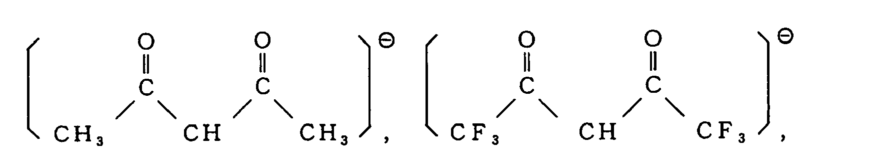 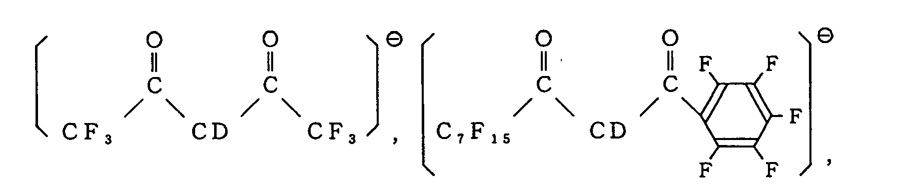 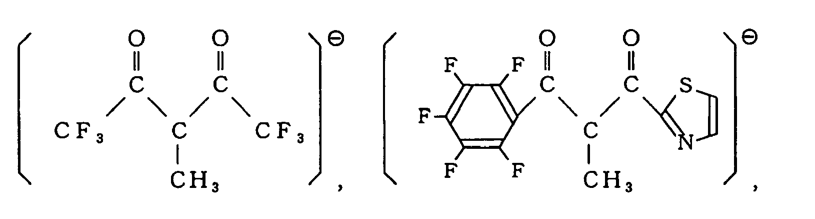 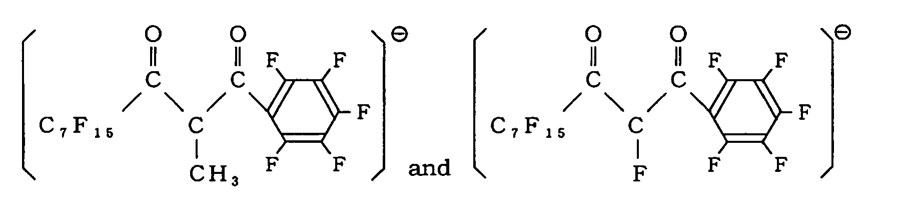 and among them, 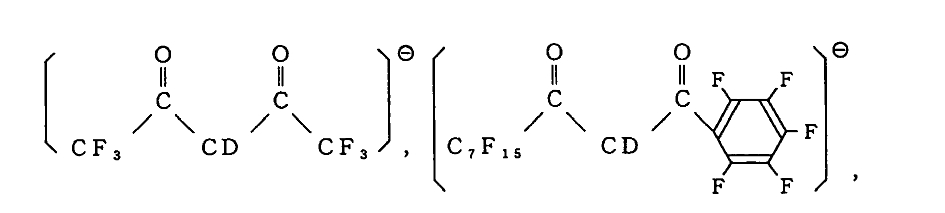 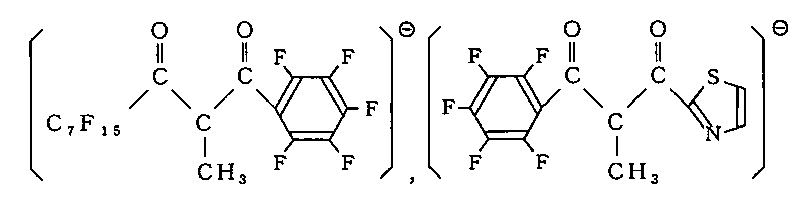 nd 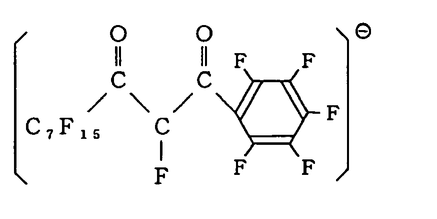 are preferred.

### (b1-2) Ligands having β-disulfonyl structure

Those ligands are concretely represented by the formula (b1-2): 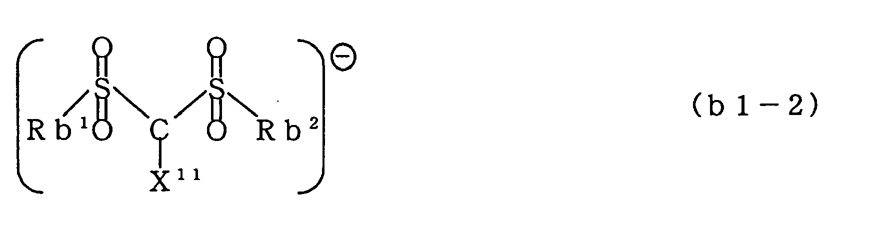 wherein Rb¹ and Rb² are as defined in the formula (b1-1); X¹¹ is as defined in the formula (b1). Those ligands are preferred because of good light emitting efficiency, good amplifying efficiency and good compatibility of the formed complex with the fluorine-containing acrylate polymer (A).

Examples thereof are: 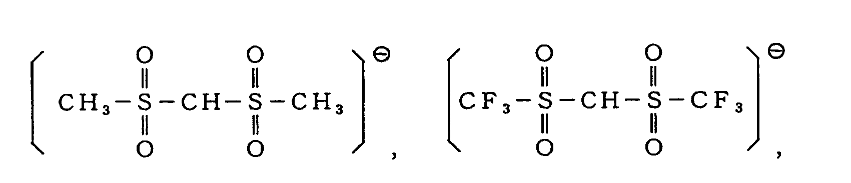 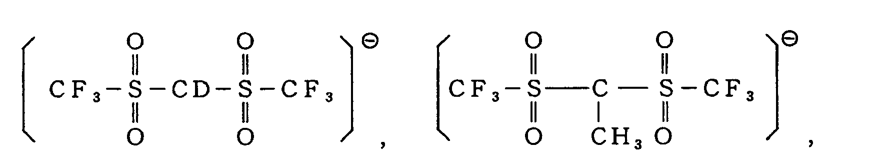 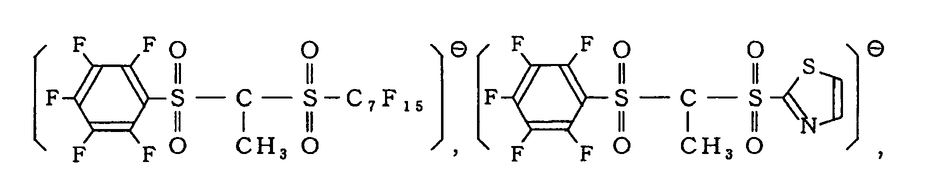 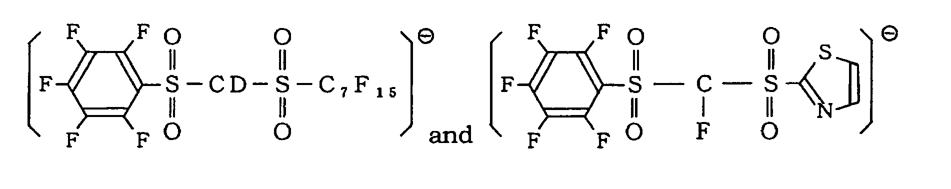 and among them, 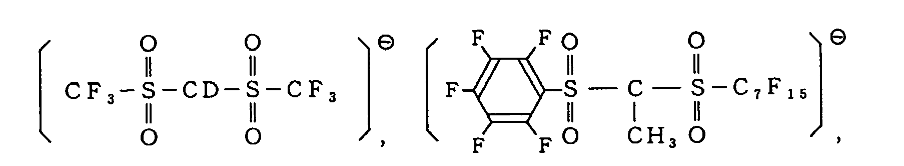 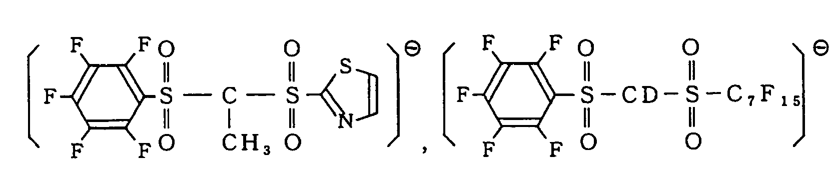 and 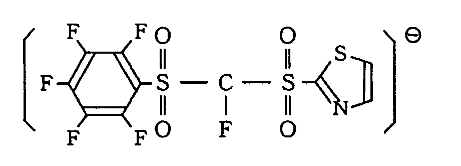 are preferred.

Examples of the ligand having the structure of the formula (b2) are, for instance, those raised below.

### (b2-1) Ligands having carbonylimide structure

Those ligands are concretely represented by the formula (b2-1): 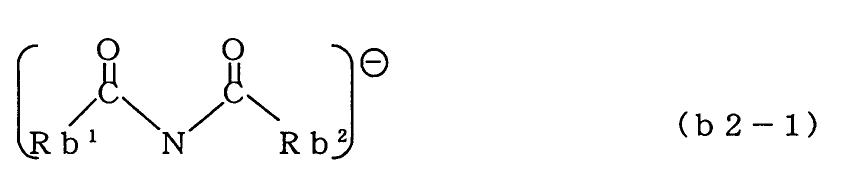 wherein Rb¹ and Rb² are as defined in the formula (b1-1). Those ligands are preferred because of good light emitting efficiency, good amplifying efficiency and good compatibility of the formed complex with the fluorine-containing acrylate polymer (A).

Examples thereof are: 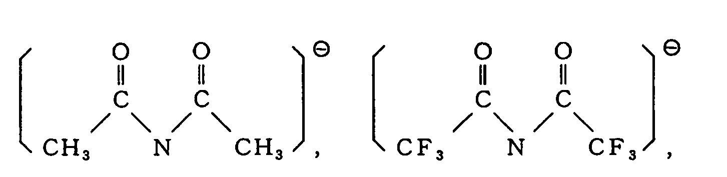 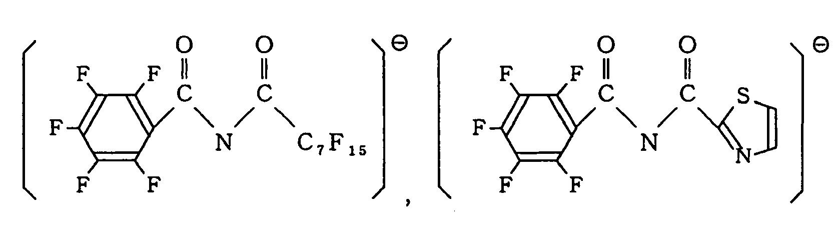 and 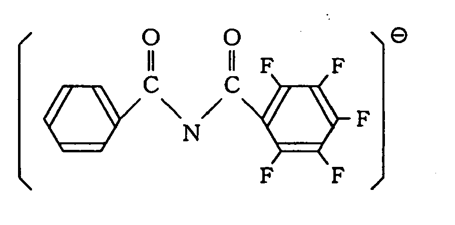 and among them, 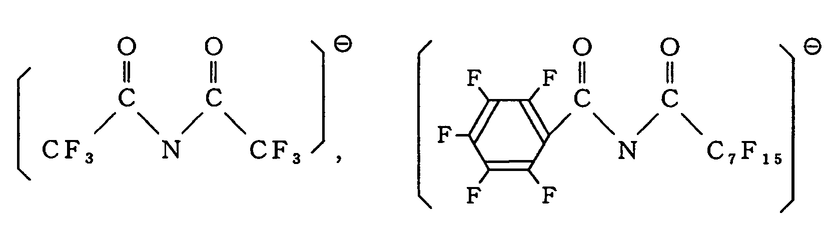 and 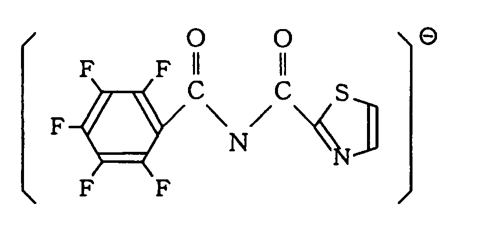 are preferred.

### (b2-2) Ligands having sulfonimide structure

Those ligands are concretely represented by the formula (b2-2): 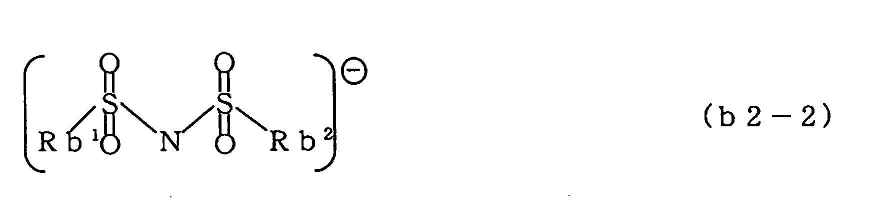 wherein Rb¹ and Rb² are as defined in the formula (b2-1). Those ligands are preferred because of good light emitting efficiency, good amplifying efficiency and good compatibility of the formed complex with the fluorine-containing acrylate polymer (A).

Examples thereof are: 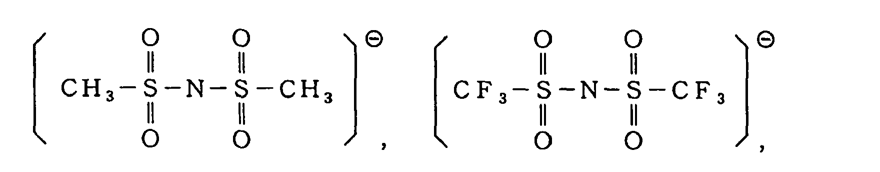 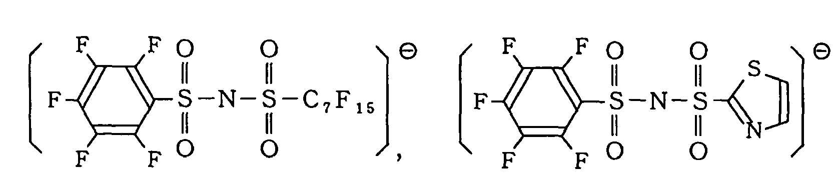 and 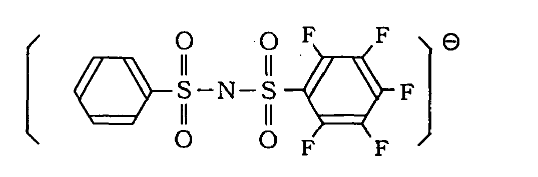 and among them, 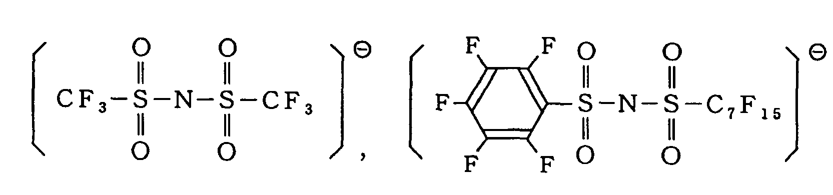 and 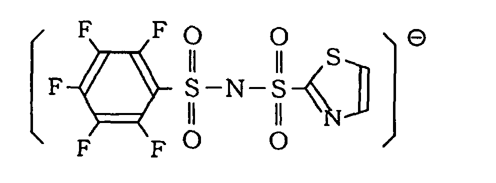 are preferred.

In the formulae (b1-1), (b1-2), (b2-1) and (b2-2), it is preferable that at least either Rb¹ or Rb² is a fluorine-containing hydrocarbon group having 1 to 20 carbon atoms in which a part or the whole of hydrogen atoms are replaced by fluorine atoms, from the viewpoint of a light emitting (amplifying) efficiency.

Further in the formulae (b1-1) and (b1-2), it is preferable that X¹¹ is heavy hydrogen atom or fluorine atom, from the viewpoint of a light emitting (amplifying) efficiency.

Examples of the ligand having the structure of the formula (b3) are, for instance, those raised below.

### (b3-1) Ligands represented by the formula (b3-1):

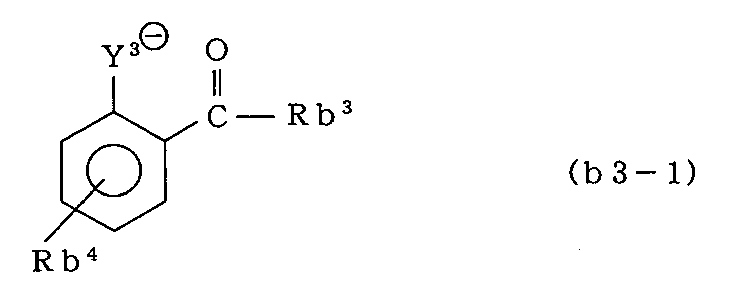

wherein Rb³ is at least one selected from hydrogen atom, a hydrocarbon group having 1 to 20 carbon atoms, a fluorine-containing hydrocarbon group having 1 to 20 carbon atoms in which a part or the whole of hydrogen atoms are replaced by fluorine atoms and a hydrocarbon group having 1 to 20 carbon atoms and containing a heterocyclic structure; Rb⁴ is hydrogen atom, a hydrocarbon group which has 1 to 20 carbon atoms and may have ether bond or a fluorine-containing hydrocarbon group which may have ether bond in which a part or the whole of hydrogen atoms are replaced by fluorine atoms; Y³ is as defined in the formula (b3). Those ligands are preferred because of good light emitting efficiency, good amplifying efficiency and good compatibility of the formed complex with the fluorine-containing acrylate polymer (A).

Examples thereof are: 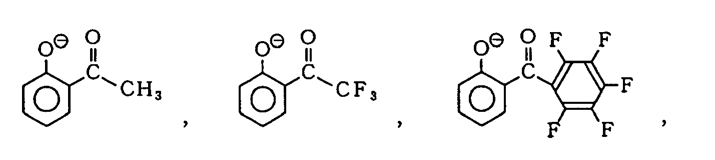 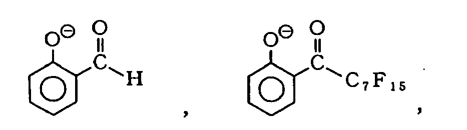 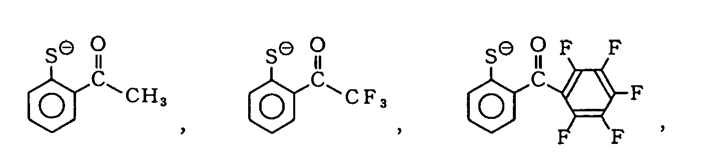 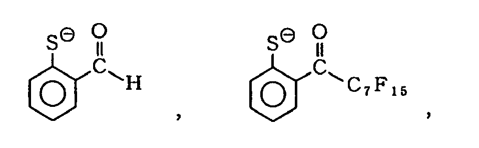 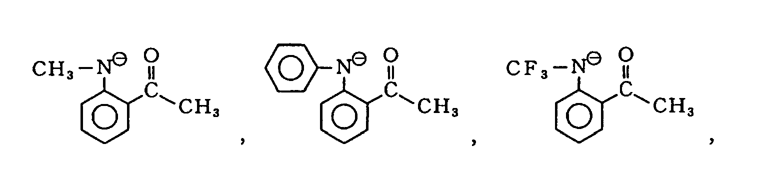 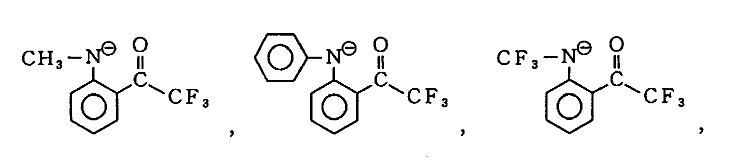 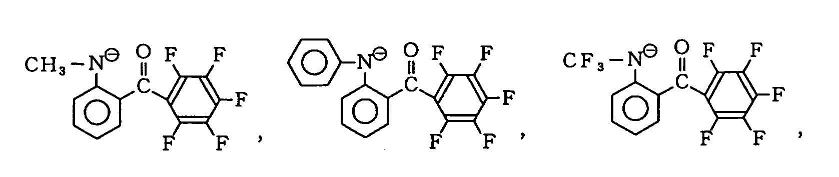 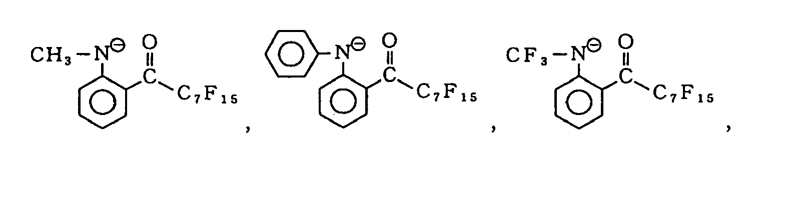 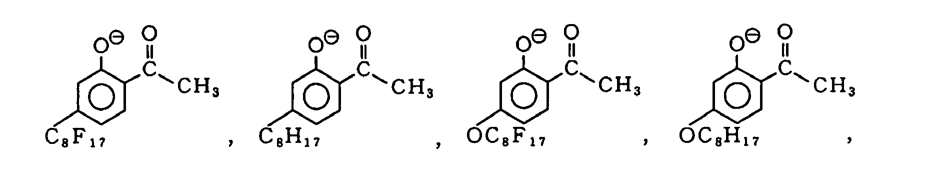 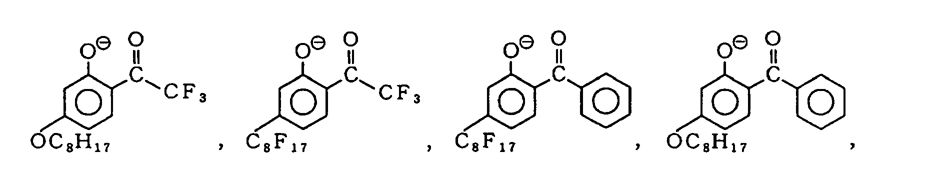 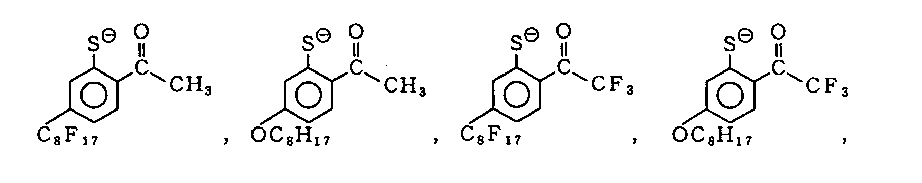 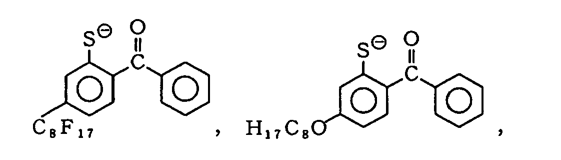 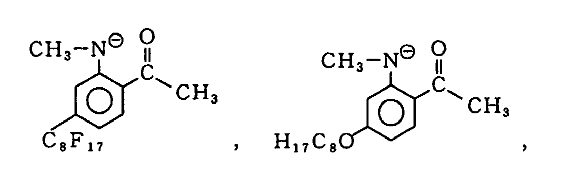 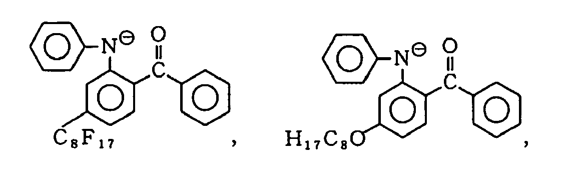 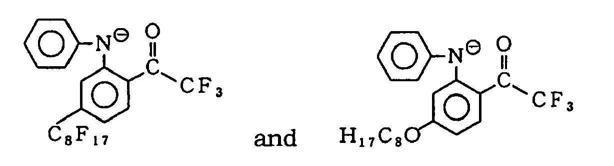 and among them, 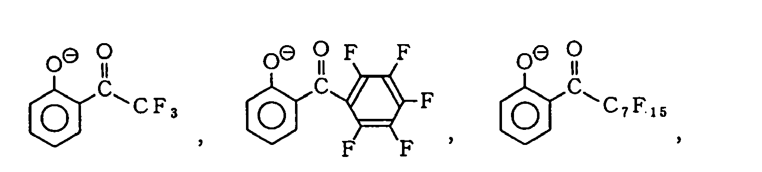 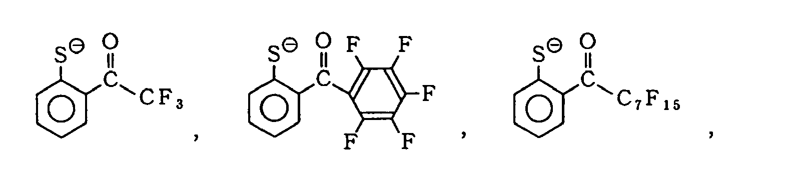 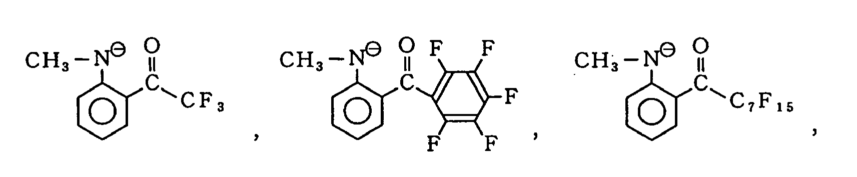 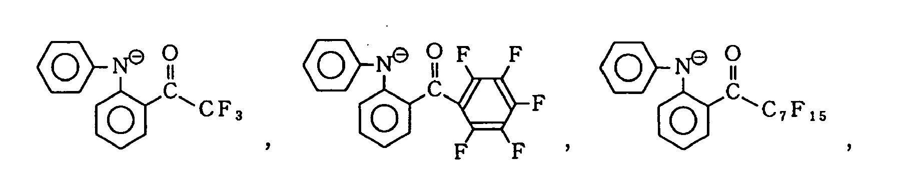 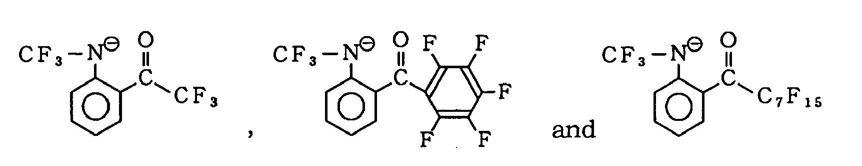 are preferred.

### (b3-2) Ligands represented by the formula (b3-2):

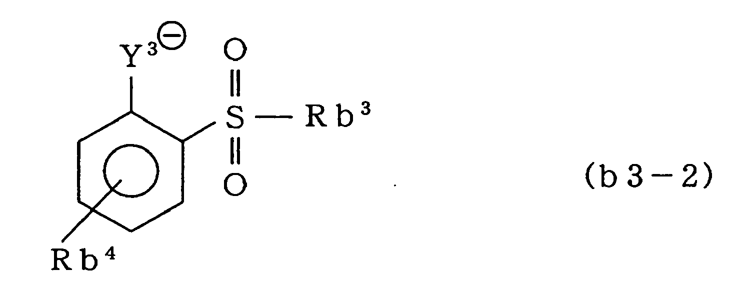

wherein Rb³ and Rb⁴ are as defined in the formula (b3-1); Y³ is as defined in the formula (b3). Those ligands are preferred because of good light emitting efficiency, good amplifying efficiency and good compatibility of the formed complex with the fluorine-containing acrylate polymer (A).

Examples thereof are: 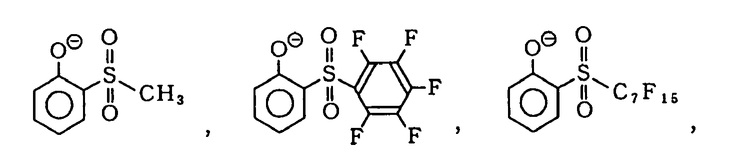 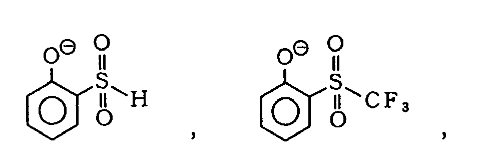 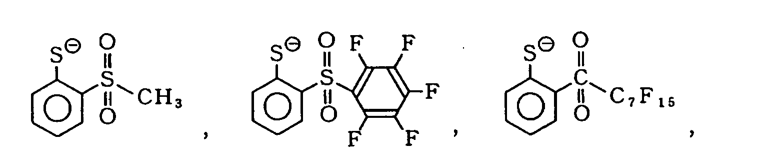 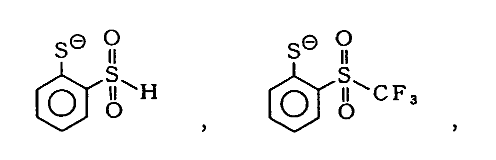 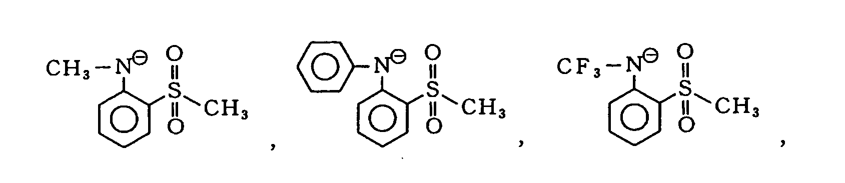 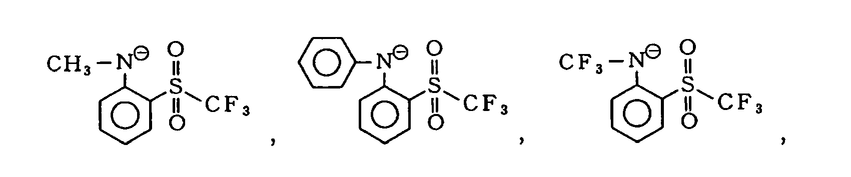 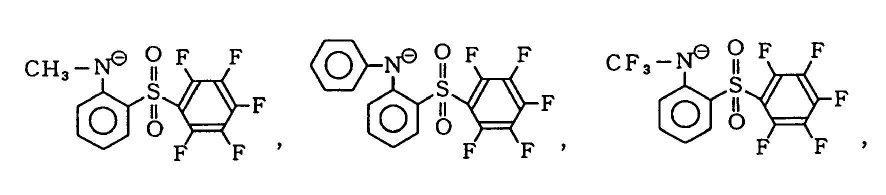 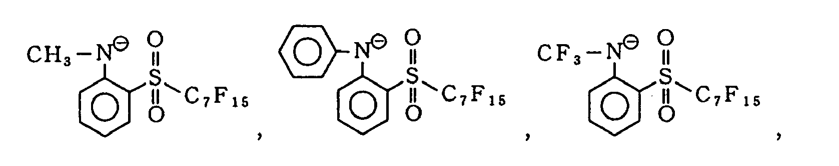 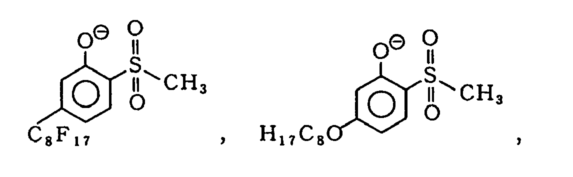 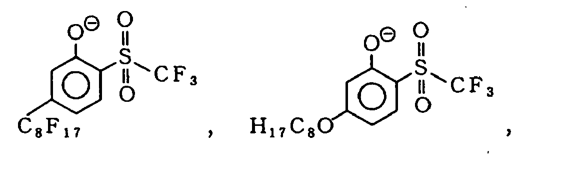 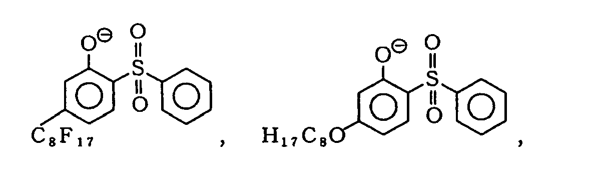 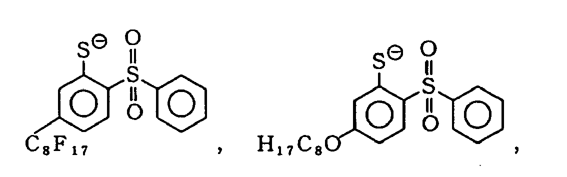 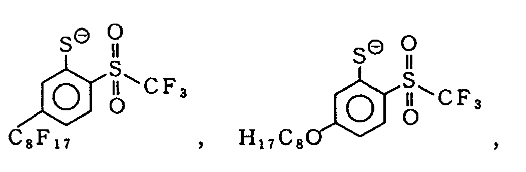 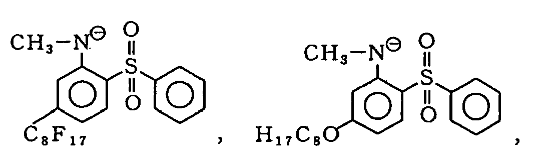 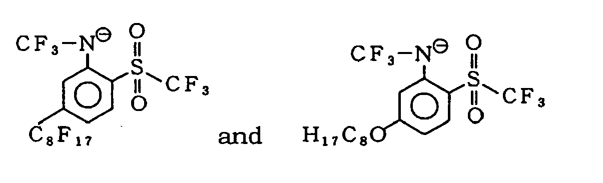 and among them, 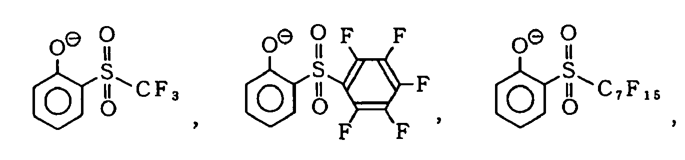 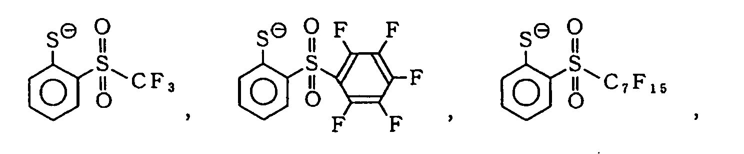 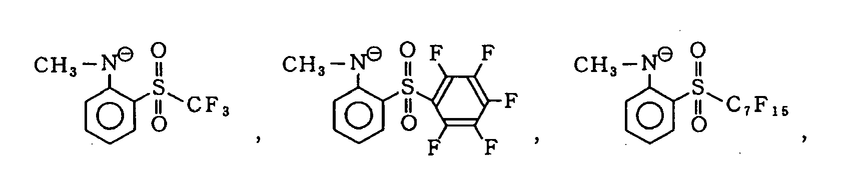 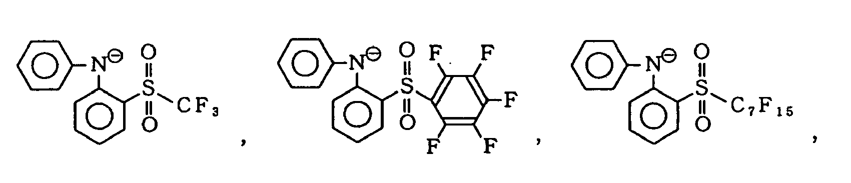 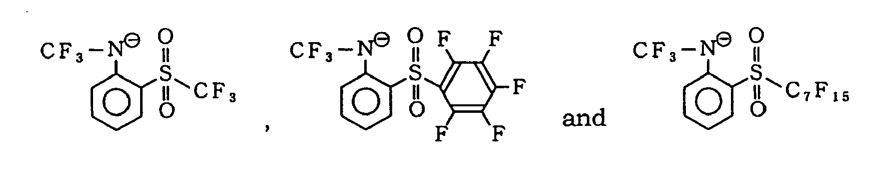 are preferred.

### (b3-3) Ligands represented by the formula (b3-3):

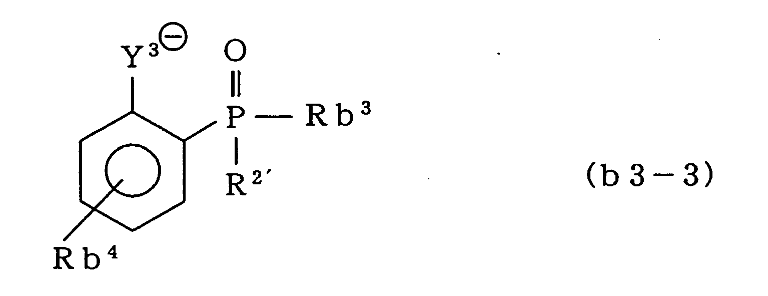

wherein Rb³ and Rb⁴ are as defined in the formula (b3-1); Y³ and R^{2'} are as defined in the formula (b3). Those ligands are preferred because of good light emitting efficiency, good amplifying efficiency and good compatibility of the formed complex with the fluorine-containing acrylate polymer (A).

Examples thereof are: 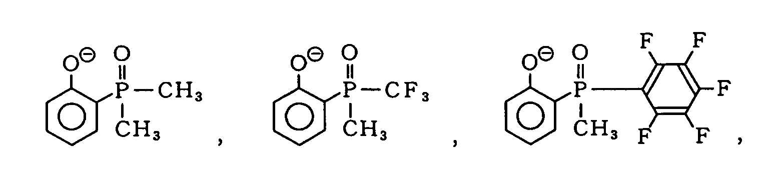 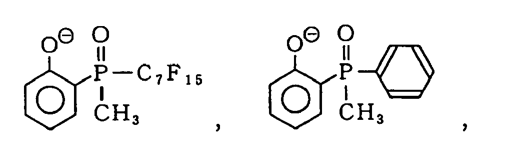 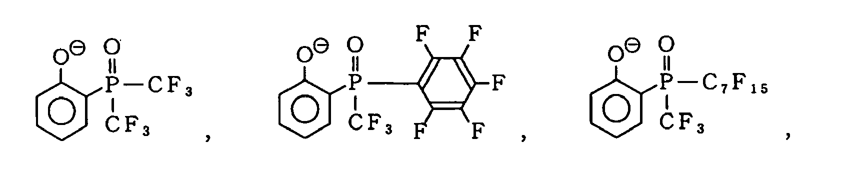 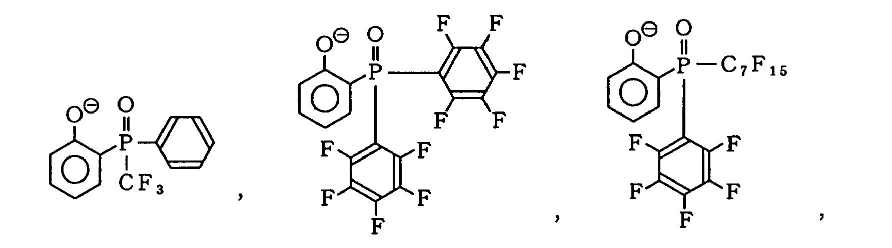 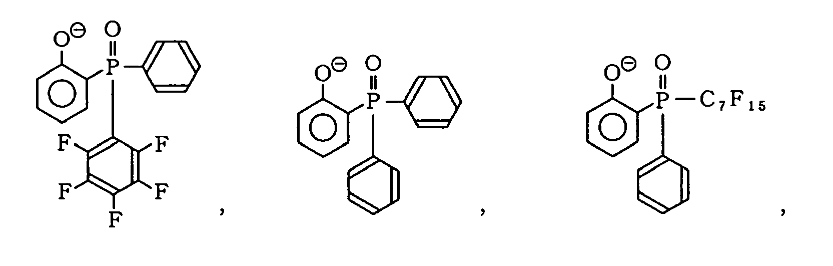 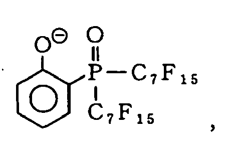 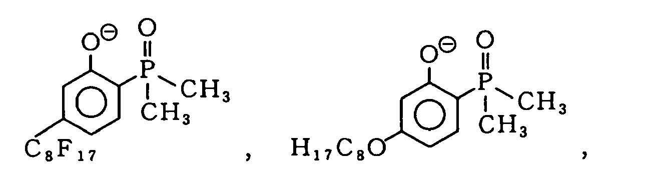 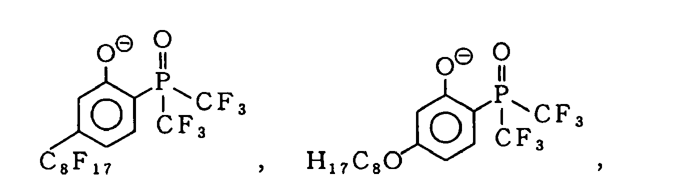 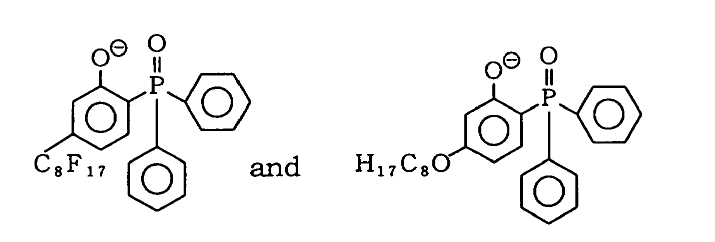 and among them, 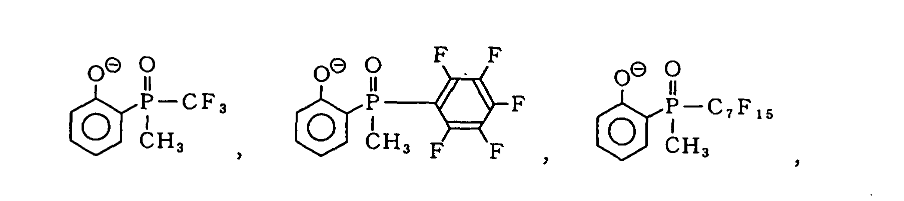 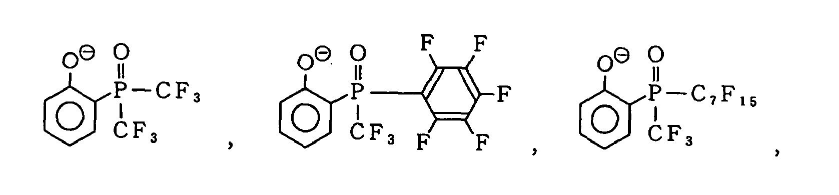 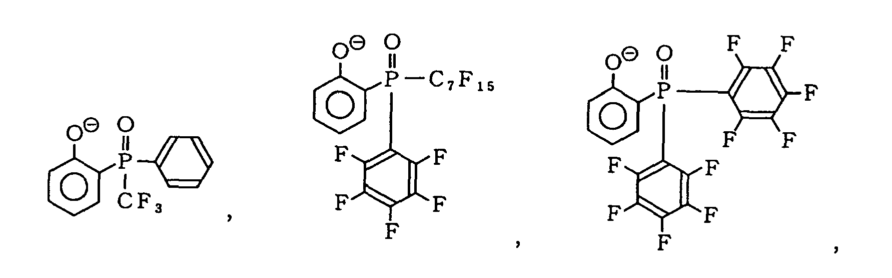 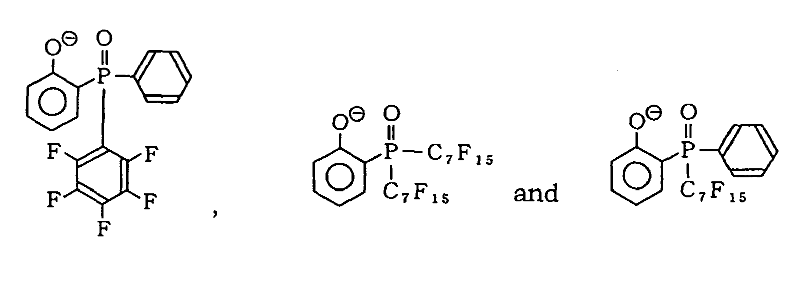 are preferred.

In the formulae (b3), (b3-1), (b3-2) and (b3-3), it is preferable that Rb³ is a fluorine-containing hydrocarbon group having 1 to 20 carbon atoms in which a part or the whole of hydrogen atoms are replaced by fluorine atoms, from the viewpoint of a light emitting (amplifying) efficiency.

In the formulae (b3) and (b3-3), it is preferable that R^{1'}, R^{2'} and R^{3'} are fluorine-containing hydrocarbon groups having 1 to 20 carbon atoms in which a part or the whole of hydrogen atoms are replaced by fluorine atoms, from the viewpoint of a light emitting (amplifying) efficiency.

The rare earth metal complex to be used for the photofunctional optical material of the present invention may be one containing ligand of electric charge non-compensation type having no electric charge (negative charge).

The ligand of electric charge non-compensation type has no electric charge in the whole ligand and has π-electron-pair being capable of coordination on a vacant d-orbital of rare earth metal. The ligand of this type is usually selected from compounds having a moiety of: 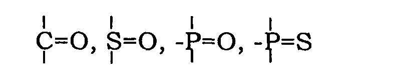 or the like.

Examples thereof are: 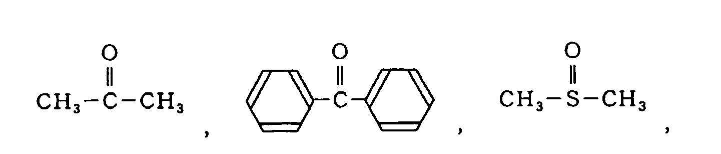 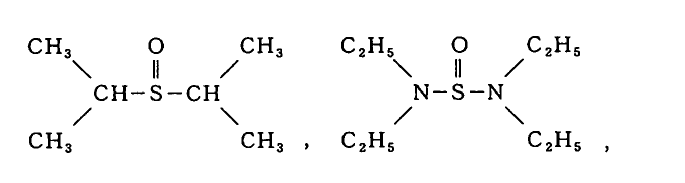 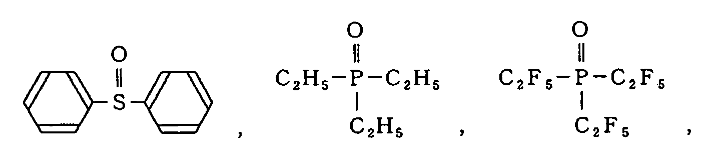 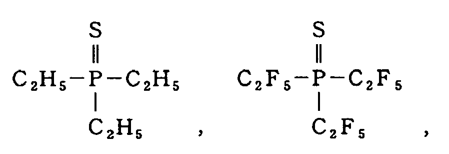 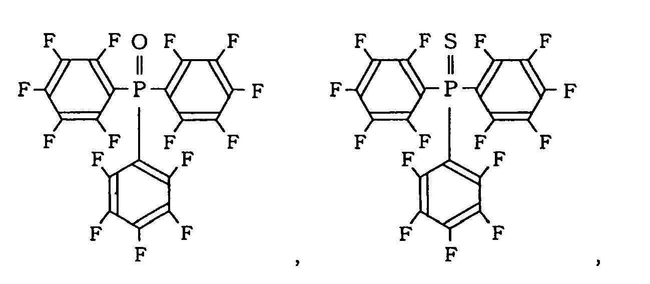 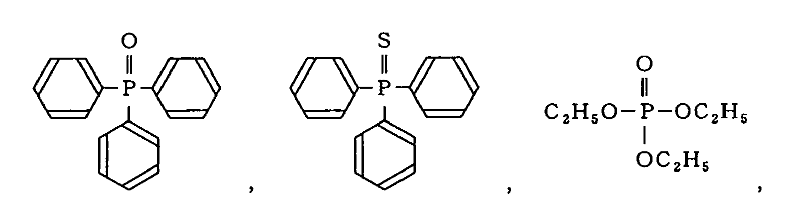 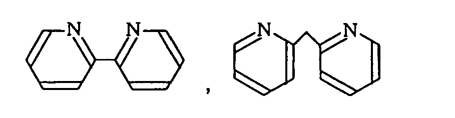 and the like, and preferred are: 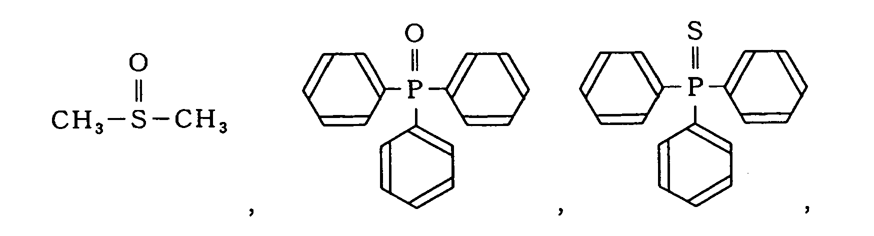 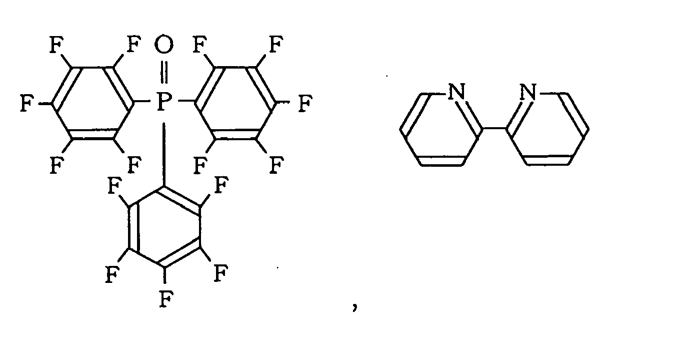 and the like.

The ligands of electric charge non-compensation type in which fluorine atoms are partly introduced are preferred from the viewpoint of a light emitting (amplifying) efficiency.

The rare earth metal complex to be used in the present invention may be one in which at least one ligand, preferably 3 or 4 ligands selected from the above-mentioned ligands of electric charge compensation type or electric charge non-compensation type are bonded by coordination to a plus trivalent rare earth metal ion. The rare earth metal complex may contain either the electric charge compensation type ligand or the electric charge non-compensation type ligand or may contain both of the electric charge compensation type ligand and the electric charge non-compensation type ligand.

Among them, a rare earth metal complex containing at least one ligand of electric charge compensation type is preferred, and particularly preferred is a rare earth metal complex containing three ligands of electric charge compensation type bonded by coordination. Further a ligand of electric charge non-compensation type may be introduced as case demands as the fourth ligand. Those complexes containing ligand of electric charge compensation type are preferred because stability thereof is high, a light emitting (amplifying) efficiency is excellent, and dispersibility in and compatibility with the fluorine-containing acrylate polymer (A) to be used in the present invention are excellent.

As a result, in the photofunctional optical material of the present invention, the rare earth metal complex functions effectively for an intensity of light emission (amplification) and a light emitting (amplifying) efficiency.

### (B2) Inorganic phosphor activated with rare earth element

The inorganic phosphor activated with rare earth element is one in which a rare earth metal is activated in an inorganic salt, and is preferred because heat resistance thereof is high.

Examples of the inorganic phosphor activated with rare earth element are phosphors raised below.
(1) YAG (yellow light emitting material)
   (YaGdl-a)(AlbGal-b)O₁₂CE³⁺ and the like
(2) YOS (red light emitting material)
   Y₂O₂S:Er and the like
(3) BAM: Eu (blue light emitting material)
   (Ba, Mg)Al₁₀O₁₇:Er and the like
(4) SCA (blue light emitting material)
   (Sr, CaBaMg)₁₀(PO₄)₆Cl₂:Eu and the like
(5) GN4 (green light emitting material)
   ZnS:Cu, A1 and the like
(6) BAM: Eu, Mn (green light emitting material)
   (Ba, Mg)Al₁₀O₁₇: Eu, Mn and the like

### (B3) Rare earth metal ion

In the rare earth metal compound (B) to be used in the present invention, a rare earth metal ion is usually mixed in the form of salt with a counter anion being capable of ionic bonding to the rare earth metal ion. The valence of the rare earth metal cation is not limited, and the rare earth metal cation is usually used as a salt of divalent, trivalent or tetravalent metal cation.

Examples of the rare earth metal salt are halides such as chlorides, bromides and iodides of the rare earth elements exemplified above; and salts such as nitrates, perchlorates, bromates, acetates, sulfates and phosphates. Also the rare earth metal salt may be organic salts of rare earth metals such as salts of organic acids and salts of organic sulfonic acids. Double salt of nitrates, double salt of sulfates and chelated compounds can also be used.

Examples of the rare earth metal salts are praseodymium salts such as praseodymium chloride, praseodymium bromide, praseodymium iodide, praseodymium nitrate, praseodymium perchlorate, praseodymium bromate, praseodymium acetate, praseodymium sulfate and praseodymium phosphate; neodymium salts such as neodymium chloride, neodymium bromide, neodymium iodide, neodymium nitrate, neodymium perchlorate, neodymium bromate, neodymium acetate, neodymium sulfate and neodymium phosphate; europium salts such as europium chloride, europium bromide, europium iodide, europium nitrate, europium perchlorate, europium bromate, europium acetate, europium sulfate and europium phosphate; erbium salts such as erbium chloride, erbium bromide, erbium iodide, erbium nitrate, erbium perchlorate, erbium bromate, erbium acetate, erbium sulfate and erbium phosphate; terbium salts such as terbium chloride, terbium bromide, terbium iodide, terbium nitrate, terbium perchlorate, terbium bromate, terbium acetate, terbium sulfate and terbium phosphate; samarium salts such as samarium chloride, samarium bromide, samarium iodide, samarium nitrate, samarium perchlorate, samarium bromate, samarium acetate, samarium sulfate and samarium phosphate; and the like.

In the photofunctional material of the present invention, the proportions of the fluorine-containing acrylate polymer (A) and the rare earth metal compound (B) are from 1 to 99.99 % by mass and 0.01 to 99 % by mass (% by mass of ion, hereinafter the same with respect to the content of the rare earth metal compound (B)), respectively. The proportions are optionally selected depending on kind, application and purpose of the rare earth metal compound (B) and the fluorine-containing acrylate polymer (A) to be used.

In applications for optical communication parts such as light amplifying device and optical waveguide and for light emitter, it is preferable to select the content of rare earth metal compound within a range of from 0.01 to 20 % by mass, more preferably from 0.1 to 15 % by mass, most preferably from 0.5 to 10 % by mass from the viewpoint of enhancement of fluorescence intensity.

If the content of rare earth metal compound (B) is too small, desired performance such as an intended light amplifying action, intensity of light emission and wavelength conversion effect are not exhibited.

On the other hand, if the content of rare earth metal compound (B) is too large, dispersibility and compatibility of the rare earth metal compound (B) and the fluorine-containing acrylate polymer (A) forming a matrix polymer are lowered, and therefore a too large content is not preferred.

The content of rare earth metal ion can be determined by burning the organic component in an electric oven of about 600°C and measuring an ash content thereof or can be determined quantitatively by physico-chemical means such as fluorescent X-ray spectroscopy.

To the photofunctional optical material of the present invention may be blended various additives as case demands in addition to the above-mentioned fluorine-containing acrylate polymer (A) and rare earth metal compound (B). Examples of the additives are, for instance, a leveling agent, a viscosity control agent, a light-stabilizer, an antioxidant, a moisture absorbing agent, a pigment, a dye, a reinforcing agent and the like.

The method of preparing the photofunctional material of the present invention comprising the fluorine-containing acrylate polymer (A) and rare earth metal compound (B) is not limited particularly. For example, it is possible to adopt
(1) a method of mixing or dissolving the rare earth metal compound (B) in the fluorine-containing acrylate (a1) and the polyfunctional acrylate (a2) which provide the fluorine-containing acrylate polymer (A), and then copolymerizing by a known polymerization method such as a radical polymerization method, anionic polymerization method or the like method for mixing thereof,
(2) a method of adding and mixing the rare earth metal compound (B) to a solution obtained by dissolving the fluorine-containing acrylate polymer (A) in a solvent and then removing the solvent,
(3) a method of melt-kneading the fluorine-containing acrylate polymer (A) and the rare earth metal compound (B), and the like method.

However many of the fluorine-containing acrylate polymers (A) to be used in the present invention are usually low in solubility in a solvent and further low in melt-processability at melt-processing though it depends on kind of the polymer.

Therefore the above-mentioned method (1) is most preferred from the viewpoint of good dispersibility of the rare earth metal compound (B) in the fluorine-containing acrylate polymer (A).

More concretely the method (1) is a method to prepare the photofunctional optical material by once preparing the composition containing the fluorine-containing acrylate (a1), the polyfunctional acrylate (a2), the optional monomer (n) and the rare earth metal compound (B) and then polymerizing the composition for polymerization by adding a polymerization initiator as case demands.

Also the photofunctional optical material may be prepared by polymerizing the composition for polymerization prepared by adding an acrylate polymer as case demands to the composition containing the fluorine-containing acrylate (a1), the polyfunctional acrylate (a2), the optional monomer (n) and the rare earth metal compound (B). Examples of the acrylate polymer to be added as case demands are polymers containing the above-mentioned fluorine-containing acrylate (a1) and/or the optional monomer (n). It is preferable that the monomer (n) is selected from structural units derived from monomers such as acrylate monomers other than (a1) and (a2), (meth)acrylic acids, fluorine-containing (meth)acrylic acids, maleic acid derivatives and the like. Preferred examples of the acrylate monomer are (meth)acrylate monomers having a linear or branched alkyl group having 1 to 20 carbon atoms in a side chain thereof such as methyl methacrylate (MMA), methyl acrylate (MA), ethyl methacrylate (EMA), ethyl acrylate (EA), isopropyl methacrylate, isopropyl acrylate, butyl methacrylate, butyl acrylate, hexyl methacrylate, hexyl acrylate, octadecyl methacrylate and octadecyl acrylate.

For the polymerization, usually radical polymerization method is preferred from the viewpoint of good polymerization reactivity and productivity and high homogeneity of the monomers in the fluorine-containing acrylate polymer (A).

For the radical polymerization, there can be used a thermal radical polymerization method not using a polymerization initiator, a thermal polymerization method using a radical polymerization initiator, a photopolymerization method using a photoradical generator and the like method. Among them, a thermal polymerization method using a radical polymerization initiator and a photopolymerization method using a photoradical generator are preferred from the viewpoint of good polymerization reactivity. Further the photopolymerization method using a photoradical generator is preferred especially from the viewpoint of excellent continuous processability when preparing the photofunctional optical material by the above-mentioned method (1).

The photofunctional optical material of the present invention is useful, for example, for a material for illuminator cover, back light for liquid crystal displays, transparent decorative case, display panel, auto parts, sheet-like light emitter such as wavelength conversion filter, fiber laser, photosensitive ink, sensor, etc. in addition to light amplifying device and light emitting device explained infra.

The photofunctional material of the present invention also can be used for a material for sealing member having photo-functionality and for optical devices produced therefrom.

An optical device sealed with the material of the present invention has a sealing portion having excellent moisture-proof property and moisture resistance derived from the fluorine-containing polymer and therefore has very excellent reliability in moisture-proof property and moisture resistance. Also the material of the present invention is excellent in transparency within a wide range from ultraviolet light to near infrared light and is useful particularly for a sealing member in optical applications. Further the material of the present invention also has photo functionality, and therefore not only usual sealing function but also added values, for example, wavelength conversion and light amplifying functions can be provided.

In the present invention, examples of the application of the sealing member are, for instance, packaging (sealing) and surface mount of optical functional devices such as light emitting diode (LED), electroluminescence device, non-linear optical device, photorefractive device, light emitting element, photodetector, wavelength conversion device of photonic crystal, Optical Add Drop Multiplexer (OADM), optical cross-connect device (OXC) and modulator. Also there are sealing materials (or filling materials) for optical members such as lens for deep ultraviolet microscope and the like. Sealed optical devices are used for various applications. Nonlimiting examples thereof are light emitting element of high-mount-stop-lamp, meter panel, back light of mobile phone and light source of remote controller of various electric appliances; photodetectors for automatic focus of camera and optical pick-up of CD/DVD; and the like.

The second of the present invention relates to the composition comprising the specific fluorine-containing acrylate (a3), polyfunctional acrylate (a4) and rare earth metal compound (b).

The composition of the present invention is a material for preparing the preferred photofunctional optical material mentioned supra and makes it possible to prepare the photofunctional optical material by polymerization using heat, light or the like.

Namely, the composition of the present invention comprises:
(a3) at least one selected from fluorine-containing acrylates represented by the formula (3): 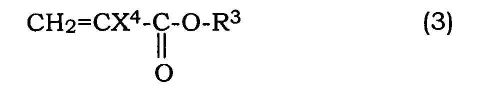 wherein X⁴ is H, F, Cl, CH₃ or CF₃; R³ is a fluorine-containing alkyl group which has 2 to 50 carbon atoms and ether bond and contains a structure represented by the formula (3-1): 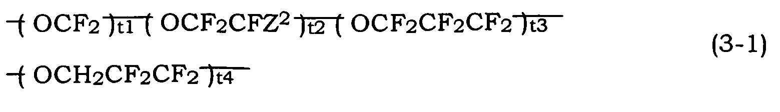 wherein Z² is F or CF₃; t1, t2, t3 and t4 are 0 or integers of 1 to 10 and t1 + t2 + t3 + t4 is an integer of 1 to 10,
(a4) at least one selected from polyfunctional acrylates represented by the formula (4): 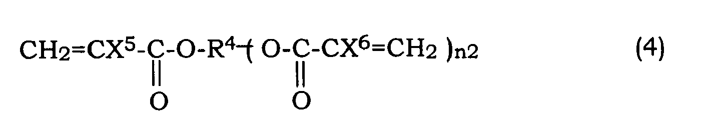 wherein X⁵ and X⁶ are the same or different and each is H, F, Cl, CH₃ or CF₃; n2 is an integer of 1 to 6; R⁴ is a (n2 + 1)-valent organic group having 1 to 50 carbon atoms, and
(b) a rare earth metal compound,
   in which ((a3) + (a4)) is contained in an amount of from 1 to 99.99 % by mass and (b) is contained in an amount of from 0.01 to 99 % by mass and when the number of moles of (a3) plus the number of moles of (a4) is assumed to be 100, a molar ratio (a3)/(a4) is 20/80 to 99/ 1.

The fluorine-containing acrylate (a3) contains the moiety of fluorine-containing polyether of the formula (3-1) in its side chain, and is preferred because of its excellent compatibility with the rare earth metal compound (b) in the composition.

The fluorine-containing acrylate polymer prepared from the fluorine-containing acrylate containing such a moiety has a high fluorine content, is high in transparency and can increase an intensity of light emission (amplification) and a light emitting (amplifying) efficiency of the photofunctional optical material obtained by polymerizing the composition.

Preferred examples of the side chain portion having the moiety of the formula (3-1) are the same as exemplified in the formula (1-1), and among them, preferred are those as represented by the formulae (1-2) to (1-7).

Particularly preferred is the fluorine-containing acrylate having, in its side chain, the fluorine-containing alkyl group which has ether bond and is represented by the formula (3-2): 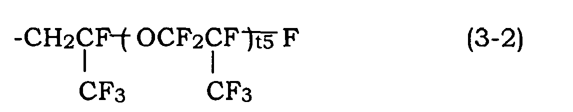 wherein t5 is an integer of 1 to 5. This fluorine-containing acrylate has a high fluorine content and makes it possible to effectively enhance an intensity of light emission (amplification) and a light emitting (amplifying) efficiency in the photofunctional optical material containing the rare earth metal compound (b) after the polymerization.

Particularly preferred examples of the fluorine-containing acrylate of the formula (3) are: 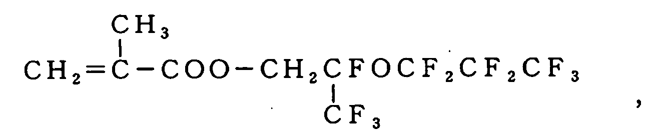 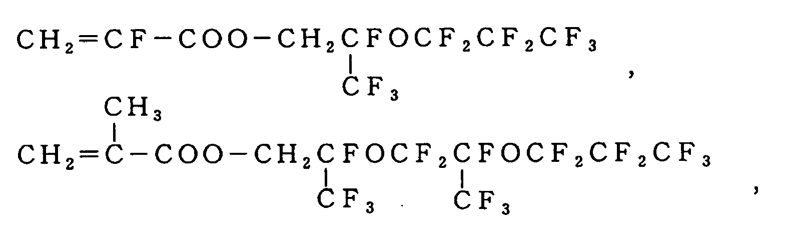 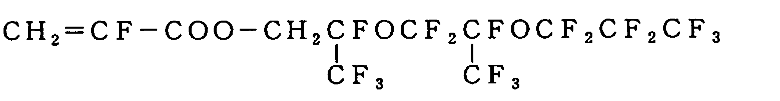 and the like, and 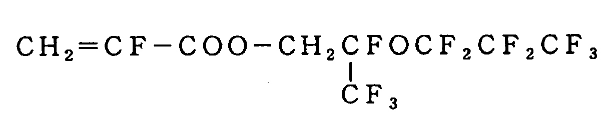 and 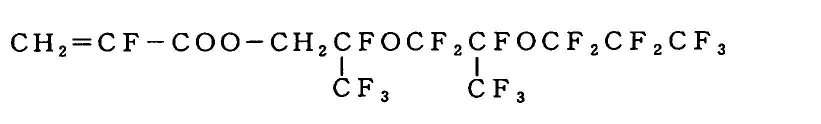 are especially preferred.

The polyfunctional acrylate (a4) in the composition of the present invention can not only improve mechanical properties and heat resistance of the photofunctional optical material obtained by polymerization but also can greatly enhance an intensity of light emission (amplification) and light emitting (amplifying) efficiency thereof.

Preferred examples of the polyfunctional acrylate (a4) of the formula (4) are the same as those of the polyfunctional acrylate of the formula (2).

For example, for adjusting a viscosity of the composition of the present invention, an acrylate polymer comprising the above-mentioned fluorine-containing acrylate (a3) and/or the above-mentioned optional monomer (n) may be blended to the composition. It is preferable that the monomer (n) is selected from structural units derived from monomers such as acrylate monomers other than (a1) and (a2), (meth)acrylic acids, fluorine-containing (meth)acrylic acids and maleic acid derivatives. Preferred examples of the acrylate monomer are (meth)acrylate monomers having a linear or branched alkyl group having 1 to 20 carbon atoms in a side chain thereof such as methyl methacrylate (MMA), methyl acrylate (MA), ethyl methacrylate (EMA), ethyl acrylate (EA), isopropyl methacrylate, isopropyl acrylate, butyl methacrylate, butyl acrylate, hexyl methacrylate, hexyl acrylate, octadecyl methacrylate and octadecyl acrylate.

The weight average molecular weight of such a polymer is not less than 10,000, preferably not less than 100,000, further preferably not less than 500,000, particularly preferably not less than 1,000,000, and not more than 50,000,000, preferably not more than 10,000,000, further preferably not more than 5,000,000.

In the composition of the present invention, preferred examples of the rare earth metal compound (b) are the same as those of the rare earth metal compound exemplified in the photofunctional optical material of the present invention. It is particularly preferable that the rare earth metal compound (b) is a rare earth metal complex especially because of excellent compatibility thereof with the fluorine-containing acrylate (a3) and polyfunctional acrylate (a4).

The composition of the present invention contains, as essential components, the fluorine-containing acrylate (a3), polyfunctional acrylate (a4) and rare earth metal compound (b), and as case demands, a monomer being copolymerizable with (a3) and (a4) may be contained in the composition for the purpose of introducing an optional structural unit.

Preferred examples of the monomer being capable of introducing an optional structural unit are the same as those of the monomer (n) exemplified in the photofunctional optical material of the present invention.

Also to the composition of the present invention may be blended various solvents and additives as case demands.

The solvents can be used usually for improving solubility of the rare earth metal compound (b) in the fluorine-containing acrylate (a3) and polyfunctional acrylate (a4), for adjusting the polymerization rate and for improving film forming property, but in the present invention, it is preferable that no solvents are used or the proportion of the solvents is as small as possible even if used.

Examples of the additives are, for instance, a leveling agent, a viscosity control agent, a light-stabilizer, an antioxidant, a moisture absorbing agent, a pigment, a dye, a reinforcing agent and the like.

In the present invention, with respect to the proportions of (a3), (a4) and (b), ((a3) + (a4)) is contained in an amount of from 1 to 99.99 % by mass and (b) is contained in an amount of from 0.01 to 99 % by mass, and when the number of moles of (a3) plus the number of moles of (a4) is assumed to be 100, a molar ratio (a3)/(a4) is 20/80 to 99/ 1.

In the case of use for parts for optical communication such as a light amplifier and optical waveguide and for a light emitter, it is preferable that the content of rare earth metal compound (b) in the composition of the present invention is selected within a range from 0.01 to 20 % by mass, further preferably from 0.1 to 15 % by mass, most preferably from 0.5 to 10 % by mass from the viewpoint of a fluorescence intensity.

If the content of rare earth metal compound (b) is too small, intended performance of the photofunctional optical material after the polymerization such as light amplifying action, intensity of light emission and wavelength conversion effect are not exhibited.

On the other hand, if the content of rare earth metal compound (b) is too large, compatibility of the rare earth metal compound (b) with the fluorine-containing acrylate (a3) and polyfunctional acrylate (a4) is lowered, and therefore a too large content is not preferred.

With respect to the proportions of the fluorine-containing acrylate (a3) and polyfunctional acrylate (a4), when the number of moles of (a3) plus the number of moles of (a4) is assumed to be 100, a molar ratio (a3)/(a4) is 20/80 to 99/ 1, preferably 30/70 to 99/ 1, more preferably 40/60 to 98/2, particularly preferably 50/50 to 95/5.

If the proportion of the fluorine-containing acrylate (a3) is too low, there is a tendency that the fluorine content of the fluorine-containing acrylate polymer after the polymerization is lowered, and a sufficient intensity of light emission (amplification) and a sufficient light emitting (amplifying) efficiency are difficult to obtain.

If the proportion of the polyfunctional acrylate (a4) is too low, there is a tendency that it becomes difficult to regulate motions of the polymer molecules, and as a result, a sufficient intensity of light emission (amplification) and a sufficient light emitting (amplifying) efficiency are difficult to obtain.

On the contrary, if the proportion of the polyfunctional acrylate (a4) is too large, there is a tendency that mechanical properties of the fluorine-containing acrylate polymer (A) after the polymerization are lowered, for example, the polymer becomes fragile and miscibility with the rare earth metal compound (b) is lowered, thereby causing a phase separation and lowering effects on an intensity of light emission (amplification) and light emitting (amplifying) efficiency.

The copolymerizable monomer (n) to be blended, as case demands, for the purpose of introducing an optional structural unit is introduced to an extent not impairing effects on an intensity of light emission (amplification) and light emitting (amplifying) efficiency by (a3) and (a4). It is usually preferable that the proportion of the monomer (n) is not more than 60 % by mole, preferably not more than 50 % by mole, more preferably not more than 30 % by mole, particularly not more than 10 % by mole based on the whole monomers in the fluorine-containing acrylate polymer after the polymerization.

A preferred viscosity of the composition of the present invention is not less than 1 mPa·s, more preferably not less than 10 mPa·s, further preferably not less than 100 mPa·s, and not more than 100,000 mPa·s, more preferably not more than 50,000 mPa·s, further preferably not more than 20,000 mPa·s.

The composition of the present invention becomes the photofunctional optical material having various functions mentioned above when subjected to polymerization.

The polymerization of the composition of the present invention is achieved by radical polymerization, anionic polymerization or the like, preferably by radical polymerization method.

There is a case where radical polymerization advances only by applying heat, but radical polymerization is usually carried out in the presence of a radical polymerization initiator in order to achieve polymerization reaction uniformly smoothly.

Therefore the composition of the present invention comprising (a3), (a4) and (b) is preferably a composition containing the following radical polymerization initiator.

The radical polymerization initiator is not limited particularly as long as a radical is generated. Preferred are those generating a radical by application of heat or irradiation of light.

First there are peroxides as a radical polymerization initiator which can generate a radical by means of heat (or room temperature or lower).

Preferred examples of peroxides are, for instance, peroxydicarbonates, oxyperesters, dialkyl peroxides and the like.

Concretely there are preferably peroxides raised below.
Peroxydicarbonates:
n-Propylperoxy dicarbonate, i-propylperoxy dicarbonate, n-butylperoxy dicarbonate, t-butylperoxy dicarbonate, bis(4-t-butylcyclohexyl)peroxy dicarbonate and the like
Oxyperesters:
α,α-bis(neodecanoylperoxy)diisopropylbenzene,
cumylperoxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxyneodecanoate, t-hexyl peroxypivalate, t-butyl peroxypivalate, 1,1,3,3-tetramethylbutylperoxy-2-ethylhexanoate, 1,5-dimethyl-2,5-bis(2-ethylhexanoylperoxy)hexane, t-hexylperoxy-2-ethylhexanoate, t-butylperoxy isobutyrate, t-hexylperoxy isopropyl monocarbonate, t-butylperoxy maleic acid, t-butylperoxy benzoate, di-t-butylperoxy isophthalate and the like
Dialkyl peroxides:
α,α-bis(t-butylperoxy)diisopropylbenzene, dicumyl peroxide, 2,5-dimethyl-2,5-bis(t-butylperoxy)hexane, t-butylcumyl peroxide, di-t-butyl peroxide and the like

Also there can be used peroxides having fluorine atom. Preferred examples thereof are one or two or more selected from fluorine-containing diacyl peroxides, fluorine-containing peroxy dicarbonates, fluorine-containing peroxy diesters and fluorine-containing dialkyl peroxides.

Among them, preferred are difluoroacyl peroxides such as pentafluoropropionoyl peroxide (CF₃CF₂COO)₂, heptafluorobutyryl peroxide (CF₃CF₂CF₂COO)₂, 7H-dodecafluoroheptanoyl peroxide (CHF₂CF₂CF₂CF₂CF₂CF₂COO)₂ and the like.

Also there can be used persulfates and azo type initiators as the radical polymerization initiator. Preferred examples of persulfates are ammonium persulfate, potassium persulfate, sodium persulfate and the like. Examples of azo type radical polymerization initiators are, for instance, 2,2'-azobisisobutyronitrile, 2,2'-azobis(2,4-dimethylvaleronitrile), 2,2'-azobis(2-methylvaleronitrile), 2,2'-azobis(2-cyclopropylpropionitrile), dimethyl 2,2'-azibis(isobutyrate), 2,2'-azobis[2-(hydroxymethyl)propionitrile], 4,4'-azobis(4-cyanopentenic acid) and the like. Examples of other radical polymerization initiator are perchloric acids, hydrogen peroxides and the like.

Among them, particularly preferred as the radical polymerization initiator are peroxydicarbonates, fluorine-containing diacyl peroxides, oxyperesters, azo type radical polymerization initiators and the like.

Also for the radical generator to be mixed to the composition of the present invention, it is also preferable to use a photoradical generator which can generate a radical by decomposition by irradiation of radiation including light, electron beam and electromagnetic wave, thereby making it possible to form a circuit more efficiently and more accurately by using the composition of the present invention when forming an optical device and optical circuit explained infra by using the photofunctional optical material.

Examples of the photoradical generator are, for instance, those raised below.

### Acetophenone

Acetophenone, chloroacetophenone, diethoxyacetophenone, hydroxyacetophenone, α-aminoacetophenone and the like.

### Benzoin

Benzoin, benzoinmethylether, benzoinethylether, benzoinisopropylether, benzoinisobutylether, benzyldimethylketal and the like.

### Benzophenone

Benzophenone, benzoyl benzoate, methyl-o-benzoylbenzoate, 4-phenylbenzophenone, hydroxybenzophenone, hydroxy-propylbenzophenone, acrylated benzophenone, Michler's ketone and the like.

### Thioxanthone

Thioxanthone, chlorothioxanthone, methylthioxanthone, diethylthioxanthone, dimethylthioxanthone and the like.

### Others

Benzyl, α-acyloxime ester, acylphosphine oxide, glyoxyester, 3-ketocoumaran, 2-ethylanthraquinone, camphorquinone, anthraquinone and the like.

Also an auxiliary for photo-initiation such as amines, sulfones or sulfines may be added.

To the composition of the present invention can be blended at least one of the photoradical generators exemplified above.

With respect to an amount of radical polymerization initiator based on 1 mole of the sum of the fluorine-containing acrylate (a3) and polyfunctional acrylate (a4) in the composition, a lower limit is 0.001 mole, preferably 0.01 mole, more preferably 0.03 mole, particularly preferably 0.05 mole, and an upper limit is 0.9 mole, preferably 0.5 mole, more preferably 0.1 mole, particularly preferably 0.08 mole. Also as case demands, a radical sensitizer and the like may be added to the composition.

According to the present invention, there can be provided optical devices, namely, a light amplifying device and light emitting device in which the photofunctional optical material of the first invention or the optical material obtained by polymerizing the composition of the second invention is used on a core portion.

A light amplifying device is a kind of optical waveguide device having a core portion and a clad portion and generally means a device in which an intensity of an optical signal is amplified while the signal is passing through a core portion of an optical waveguide formed on a substrate. The core portion of this light amplifying device need be formed by using a material having a light amplifying action.

According to the present invention, the core portion (a portion of optical waveguide having a light amplifying action) of the light amplifying device is made by using the photofunctional optical material of the first invention or the optical material obtained by polymerizing the composition of the second invention.

When using those optical materials of the present invention for a core portion of a light amplifying device, a proper clad material is required. Though it is necessary to use a material for a clad portion having a refractive index lower than that of a material for a core portion, when the optical materials of the present invention are used for a core portion, a material for a clad portion is not limited particularly, and existing organic materials are used. It is a matter of course that only the fluorine-containing acrylate polymer (A) without blending the rare earth metal compound (B) or (b) or only a mixture of the monomers (a3) and (a4) may be used.

In the present invention, the light emitting device encompasses, for example, electroluminescence device, luminescent organic polymer, light emission diode, optical fiber laser, laser device, optical fiber, back lighting system for liquid crystal displays, photodetector, wavelength conversion filter and the like and is applied on a large size display, illumination, liquid crystal, photo-disk, laser printer, laser for medical use, laser processing machine, printing machine, copying machine, etc.

In the case of a light emitting device having a core portion and a clad portion, like the light amplifying device, the photofunctional optical material of the present invention can be used on the core portion, and existing organic materials, for example, only the fluorine-containing acrylate polymer (A) or only a mixture of the monomers (a3) and (a4) can be used on the clad portion.

Also a multi-functional optical circuit can be produced when the light amplifying device or light emitting device in the present invention is integrated with other optical devices. Examples of the other optical devices are a photo-switch, photo-filter, optical branch device, etc. Particularly preferred is an optical circuit having, on the same substrate, the light amplifying device in the present invention and an optical branching device having a N-branch waveguide (N represents an integer of 2 or more) which is made of the same material as a core portion of the light amplifying device and is connected to an output end of the core portion because the optical circuit can be used as a branch device assuring a small loss of light.

When the optical material of the first invention is used, the light amplifying device and light emitting device in the present invention can be produced by known method except that the optical material is used on the core portion.

Also a circuit can be efficiently formed more accurately by molding the composition of the second invention containing the fluorine-containing acrylate (a3), polyfunctional acrylate (a4) and rare earth metal compound (b).

Particularly preferred is a composition obtained by adding a photoradical generator to the fluorine-containing acrylate (a3), polyfunctional acrylate (a4) and rare earth metal compound (b) because a circuit can be formed efficiently by photolithography method explained below.

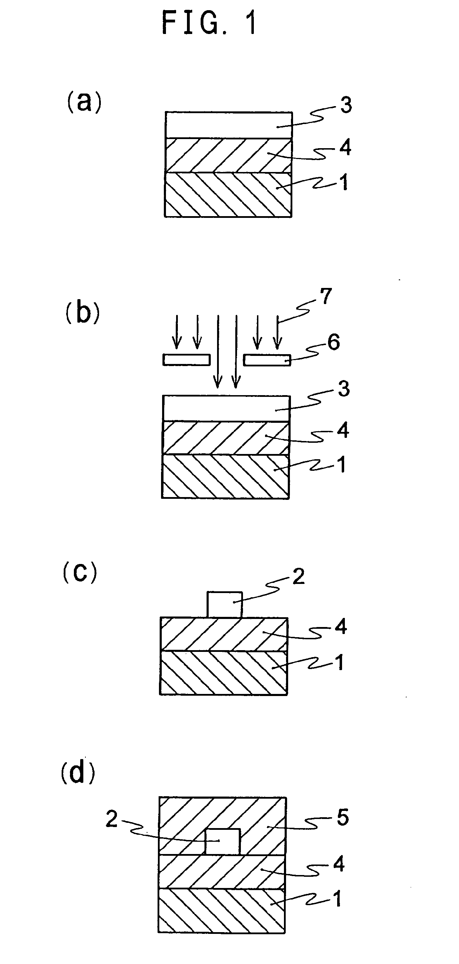

Fig. 1 shows an example of production steps of an optical waveguide device using the composition of the second invention. The optical waveguide device is produced using a photolithography technology.

For example, first, as shown in Fig. 1(a), a clad portion 4 is previously formed on a substrate 1, and then a film 3 of the photofunctional optical material of the present invention for a core portion is formed by applying and then polymerizing the composition of the present invention.

The film forming the core portion is formed by applying a homogeneous liquid composition containing (a3), (a4), (b) and a photoradical generator by coating means such as rotary coating or cast coating or by using a metal mold. The above-mentioned homogeneous liquid composition is prepared preferably by filtering, for example, with an about 0.2 µm filter.

A preferred viscosity of the liquid composition is generally from 10 to 10,000 cp, particularly preferably from 20 to 5,000 cp, further preferably from 50 to 1,000 cp.

Next, as shown in Fig. 1(b), the film 3 formed by using the composition containing (a3), (a4), (b) and a photoradical generator is irradiated with active energy ray 7 through a mask 6 having a specific pattern form. Then pre-baking is carried out as case demands. By the light irradiation, polymerization occurs between the molecules of the fluorine-containing acrylate (a3) and the polyfunctional acrylate (a4) in the film 3. As a result, a hardness of the film is increased, mechanical strength is increased and heat resistance is enhanced.

By the light irradiation (photopolymerization) on the composition containing the polyfunctional acrylate (a4), the composition becomes insoluble in many kinds of solvents. Namely, the composition functions as a photoresist material.

Then un-irradiated portion of the film 3 is dissolved and removed with a proper solvent to form the core portion 2 having a specific pattern form as shown in Fig. 1(c). Though the optical waveguide device in the form having only the so-obtained core portion 2 can be used as it is, it is preferable that after the formation of the core portion 2, the clad portion 5 is further formed as shown in Fig. 1(d). It is preferable that the clad portion 5 is formed by coating the solution of material therefor by rotary coating, cast coating, roll coating or the like, and the rotary coating is particularly preferred. The homogeneous liquid composition for the clad portion 5 is prepared preferably by filtrating, for example, with an about 0.2 µm filter.

The composition of the present invention comprising the fluorine-containing acrylate (a3), polyfunctional acrylate (a4) and rare earth metal compound (b) is preferred because an intended circuit pattern can be easily formed efficiently by a photolithography method using a direct exposing method as mentioned above and also a core portion having good heat resistance and mechanical properties and exhibiting photo-functionality can be formed.

The composition of the present invention is suitable particularly for optical applications and is also useful for applications other than optical applications, for example, a material for producing an adhesive, coating, various molding materials and the like.

### EXAMPLE

The present invention is then explained by means of examples, but is not limited to those examples.

The methods of measuring various physical properties and parameters which are used in the present invention are explained as follows.

### (1) NMR

NMR measuring equipment: available from BRUKER CO., LTD.
Measuring conditions of ¹H-NMR: 300 MHz (tetramethylsilane = 0 ppm) Measuring conditions of ¹⁹F-NMR: 282 MHz (trichlorofluoromethane = 0 ppm)

### (2) IR analysis: Measuring is carried out at room temperature with a Fourier-transform infrared spectrophotometer 1760X available from Perkin Elmer Co., Ltd.

### (3) Tg-DTA

Elevation of temperature, lowering of temperature and elevation of temperature (the second elevation of temperature is called a second run) are carried out at a temperature elevating or lowering rate of 10°C/min within a range of from 30°C to 200°C by using a differential scanning calorimeter (RTG220 available from SEIKO), and an intermediate point of a heat absorption curve at the second run is assumed to be Tg (°C).

### (4) Fluorine content

The fluorine content (% by mass) is obtained by burning 10 mg of a sample by an oxygen flask combustion method, absorbing cracked gas in 20 ml of de-ionized water and then measuring a fluorine ion concentration in the fluorine ion-containing solution through a fluoride-ion selective electrode method (using a fluorine ion meter model 901 available from Orion).

### (5) Measurement of intensity of light emission of sample containing Eu complex

A light emission spectrum of each sample is measured by using a fluorescence spectrophotometer (Fluorescence spectrophotometer F-4010 available from Hitachi Ltd.) equipped with an integrating sphere, and a peak area at a specific wavelength is compared to determine a relative intensity of light emission.

### (6) Measurement of intensity of light emission of sample containing Er complex

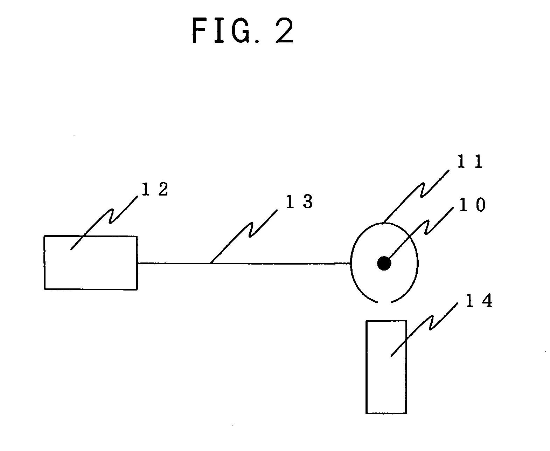

The intensity is measured by an optical system shown in Fig. 2. In Fig. 2, numeral 10 represents a sample to be measured which is arranged in an integrating sphere 11. A laser beam (1,480 nm) generated in a variable wavelength type laser generator 12 is fed into the integrating sphere 11 through an optical fiber 13, and an intensity of light emission of 1,550 nm generated from the sample is measured with an optical power meter 14.

The variable wavelength laser generator is 81480A available from Agilent Technology, the optical power meter is ML9001A or MA9711A available from Anritsu Corp., and the integrating sphere is IS-040-SL available from Labsphere, Inc.

### PREPARATION EXAMPLE 1

### (Preparation of Eu(CF₃COCHCOCF₃)₃)

Into a 100 ml glass flask were poured 2.0 g (5 mmol) of europium acetate, tetrahydrate, 3.0 g (20 mmol) of hexafluoroacetylacetone and 50 ml of pure water, followed by stirring at 25°C for three days.

Next, the precipitated solid was taken out by filtration, and after washing with water, was subjected to re-crystallization with a water/methanol solvent mixture, and a white crystal was obtained (yield: 60 %).

This crystal was subjected to IR, ¹H-NMR and ¹⁹F-NMR analyses and was confirmed to be an intended complex, i.e. Eu(CF₃COCHCOCF₃)₃.

Also by Tg-DTA measurement, the obtained white crystal was presumed to be a dihydrate.

### PREPARATION EXAMPLE 2

### (Preparation of Eu(CF₃COCHCOCF₃)₃((C₆H₅)₃P=O)₂)

Into a 100 ml glass flask were poured 2.3 g (3 mmol) of europium complex: Eu(CF₃COCHCOCF₃)₃ obtained in Preparation Example 1, 1.4 g (5 mmol) of triphenylphosphine oxide and 50 ml of methanol, followed by refluxing for 12 hours (65° to 70°C).

Next, methanol was distilled off from the solution of the reaction mixture with an evaporator for concentration, and hexane was added thereto to precipitate a white solid. The precipitated solid was taken out by filtration and subjected to re-crystallization with toluene, and a white crystal was obtained (yield: 50 %).

This crystal was subjected to IR, ¹H-NMR and ¹⁹F-NMR analyses and was confirmed to be an intended complex, i.e. Eu(CF₃COCHCOCF₃)₃((C₆H₅)₃P=O)₂.

### EXAMPLE 1

### (Production of photofunctional optical material)

Into a heat resistant glass tube of 4 mm inner diameter x 200 mm long which was sealed at one end were poured 2.0 g of a fluorine-containing acrylate represented by the formula (a3-1): 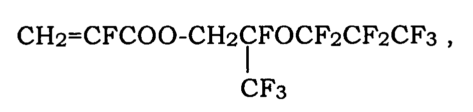 0.044 g of a bifunctional fluorine-containing acrylate represented by the formula (a4-1): 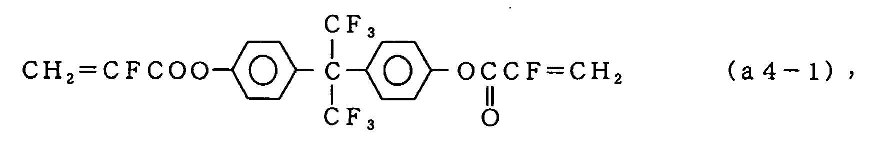 0.020 g of the rare earth metal complex: Eu(CF₃COCHCOCF₃)₃((C₆H₅)₃P=O)₂ obtained in Preparation Example 2 and 0.002 g of azobisisobutyronitrile (AIBN) as a radical polymerization initiator, followed by mixing, and a transparent homogeneous solution was obtained.

Next, the heat resistant glass tube containing the composition obtained above by mixing was dipped in liquid nitrogen, and while cooling, the inside of the tube was sufficiently evacuated with a vacuum pump and the tube was sealed.

After heating at 60°C for 12 hours, the heat resistant glass tube was crushed, and a transparent cylindrical solid comprised of the fluorine-containing acrylate polymer (A) and the europium complex (B) was obtained.

### EXAMPLE 2

### (Production of photofunctional optical material)

Polymerization reaction was carried out in the same manner as in Example 1 except that 2.0 g of the fluorine-containing acrylate represented by the formula (a3-1), 0.17 g of the bifunctional acrylate represented by the formula (a4-1), 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 3

### (Production of photofunctional optical material)

Polymerization reaction was carried out in the same manner as in Example 1 except that 2.0 g of the fluorine-containing acrylate represented by the formula (a3-1), 0.056 g of a tetrafunctional fluorine-containing acrylate represented by the formula (a4-2): 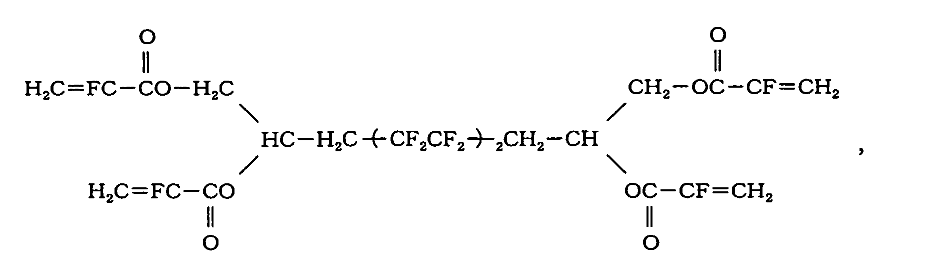 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 4

### (Production of photofunctional optical material)

Polymerization reaction was carried out in the same manner as in Example 1 except that 2.0 g of the fluorine-containing acrylate represented by the formula (a3-1), 0.160 g of a bifunctional acrylate represented by the formula (a4-3): 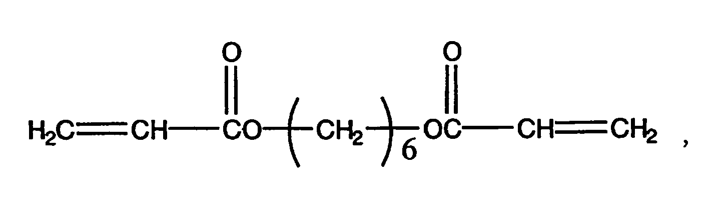 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 5

### (Production of photofunctional optical material)

Polymerization reaction was carried out in the same manner as in Example 1 except that 2.0 g of the fluorine-containing acrylate represented by the formula (a3-1), 1.3 g of the bifunctional acrylate represented by the formula (a4-3), 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 6

### (Production of photofunctional optical material)

Polymerization reaction was carried out in the same manner as in Example 1 except that 2.0 g of fluorine-containing acrylate (8FFA) represented by the formula (a3-2):

CH₂=CFCOOCH₂(CF₂CF₂)₂H (a3-2),

0.078 g of the bifunctional fluorine-containing acrylate represented by the formula (a4-1), 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 7

### (Production of photofunctional optical material)

Polymerization reaction was carried out in the same manner as in Example 1 except that 0.15 g of methyl methacrylate (MMA), 1.0 g of 2,2,2-trifluoroethyl-α-fluoroacrylate (3FFA) represented by the formula (a3-3):

CH₂=CFCOOCH₂CF₃ (a3-2),

0.115 g of the tetrafunctional fluorine-containing acrylate represented by the formula (a4-2), 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### EXAMPLE 8

### (Production of photofunctional optical material)

Polymerization reaction was carried out in the same manner as in Example 1 except that 0.39 g of methyl methacrylate, 1.0 g of 2,2,2-trifluoroethyl-α-fluoroacrylate (3FFA) represented by the formula (a3-3), 0.155 g of the tetrafunctional fluorine-containing acrylate represented by the formula (a4-2), 0.020 g of the europium complex: Eu(CF₃COCHCOCF₃)₃((C₆H₅)₃P=O)₂ obtained in Preparation Example 2 and 0.002 g of AIBN were used, and a solid comprised of the fluorine-containing acrylate polymer (A) and the europium complex (B) was obtained.

### COMPARATIVE EXAMPLE 1

Polymerization reaction was carried out in the same manner as in Example 1 except that 2.0 g of the fluorine-containing acrylate represented by the formula (a3-1), 0.020 g of the europium complex: Eu(CF₃COCHCOCF₃)₃((C₆H₅)₃P=O)₂ obtained in Preparation Example 2 and 0.002 g of AIBN were used, and a solid comprised of a fluorine-containing acrylate polymer and an europium complex was obtained.

### COMPARATIVE EXAMPLE 2

Polymerization reaction was carried out in the same manner as in Example 1 except that 2.0 g of methyl methacrylate, 0.32 g of the tetrafunctional fluorine-containing acrylate represented by the formula (a4-2), 0.020 g of the europium complex: Eu(CF₃COCHCOCF₃)₃((C₆H₅)₃P=O)₂ obtained in Preparation Example 2 and 0.002 g of AIBN were used, and a solid comprised of a fluorine-containing acrylate polymer and an europium complex was obtained.

### COMPARATIVE EXAMPLE 3

Polymerization reaction was carried out in the same manner as in Example 1 except that 2.0 g of isopropyl methacrylate (IPMA), 0.098 g of the tetrafunctional fluorine-containing acrylate represented by the formula (a4-2), 0.020 g of the europium complex: Eu(CF₃COCHCOCF₃)₃((C₆H₅)₃P=O)₂ obtained in Preparation Example 2 and 0.002 g of AIBN were used, and a solid comprised of a fluorine-containing acrylate polymer and an europium complex was obtained.

### COMPARATIVE EXAMPLE 4

Polymerization reaction was carried out in the same manner as in Example 1 except that 2.0 g of methyl methacrylate, 0.020 g of the europium complex: Eu(CF₃COCHCOCF₃)₃((C₆H₅)₃P=O)₂ obtained in Preparation Example 2 and 0.002 g of AIBN were used, and a solid comprised of a fluorine-containing acrylate polymer and an europium complex was obtained.

### EXPERIMENTAL EXAMPLE 1

With respect to the obtained solids containing europium complex, the following physical properties were determined. The results are shown in Table 1. Measurement of fluorine content in fluorine-containing acrylate polymer (A)

### (1-1) Synthesis of fluorine-containing acrylate polymer (A)

Polymerization reaction was carried out in the same manner as in Examples 1 to 8 and Comparative Examples 1 to 4, respectively except that the europium complex: Eu(CF₃COCHCOCF₃)₃((C₆H₅)₃P=O)₂ was not added, to synthesize fluorine-containing acrylate polymers corresponding to the respective examples and comparative examples.

### (1-2) Measurement of fluorine content

The fluorine content (% by mass) of each of the obtained fluorine-containing acrylate polymers was measured by the oxygen flask combustion method explained supra.

### (2) Content of rare earth metal complex

In Examples 1 to 8 and Comparative Examples 1 to 4, an amount (% by mass) of metal (ion) based on the whole photofunctional optical material is calculated from the amount of rare earth metal complex used.

### (3) Appearance

With respect to the respective cylindrical solids comprised of the fluorine-containing acrylate polymer and the europium complex, transparency was evaluated with naked eyes by the following criteria.
○: Completely transparent without precipitation of rare earth metal complex in the composition.
× : Precipitation of rare earth metal complex is observed, and there is turbidity.

### (4) Relative intensity of light emission

The respective cylindrical solids of Examples 1 to 8 and Comparative Examples 1 to 4 comprised of the fluorine-containing acrylate polymer and the europium complex were cut by 3 cm in the direction of height, and both ends thereof were subjected to optical grinding.

The samples were set on the fluorescence spectrophotometer equipped with an integrating sphere, and a light emission spectrum was measured by irradiating the samples with a specific amount of light of 465 nm wavelength as an excitation wavelength.

In the light emission spectrum, attention was directed to a light emission peak at 615 nm, and when the light emission peak area at 615 nm of the solid sample of Comparative Example 4 is assumed to be 100, a relative ratio of light emission peak area of each sample was calculated and assumed to be a relative intensity of light emission at 615 nm.

**TABLE 1**

| | Fluorine content in polymer (A) (% by mass) | Content of rare earth metal complex (% by mass) | Appearance | Relative intensity of light emission at 615 nm wavelength |
|---|---|---|---|---|
| Ex. 1 | 61.0 | 0.054 | ○ | 260 |
| Ex. 2 | 53.8 | 0.051 | ○ | 240 |
| Ex. 3 | 61.1 | 0.054 | ○ | 250 |
| Ex. 4 | 60.2 | 0.052 | ○ | 250 |
| Ex. 5 | 51.4 | 0.034 | ○ | 250 |
| Ex. 6 | 55.4 | 0.053 | ○ | 240 |
| Ex. 7 | 35.2 | 0.087 | ○ | 210 |
| Ex. 8 | 26.4 | 0.072 | ○ | 180 |
| Com. Ex. 1 | 61.7 | 0.056 | ○ | 230 |
| Com. Ex. 2 | 0.87 | 0.048 | ○ | 110 |
| Com. Ex. 3 | 3.2 | 0.053 | ○ | 140 |
| Com. Ex. 4 | 0 | 0.056 | ○ | 100 |

### PREPARATION EXAMPLE 3

### (Preparation of Er(CF₃COCHCOCF₃)₃)

Into a 100 ml glass flask were poured 2.1 g (5 mmol) of erbium acetate, tetrahydrate, 3.0 g (20 mmol) of hexafluoroacetyl acetone and 50 ml of pure water, followed by stirring at 25°C for three days.

Next, the precipitated solid was taken out by filtration, and after washing with water, was subjected to re-crystallization with a water/methanol solvent mixture, and a light-pink crystal was obtained (yield: 50 %).

This crystal was subjected to IR, ¹H-NMR and ¹⁹F-NMR analyses and was confirmed to be an intended complex, i.e. Er(CF₃COCHCOCF₃)₃.

Also by Tg-DTA measurement, the obtained light-pink crystal was presumed to be a dihydrate.

### EXAMPLE 9

### (Production of photofunctional optical material)

Polymerization reaction was carried out in the same manner as in Example 1 except that 2.0 g of the fluorine-containing acrylate represented by the formula (a3-1), 0.044 g of the bifunctional fluorine-containing acrylate represented by the formula (a4-1), 0.020 g of the rare earth metal complex : Er(CF₃COCHCOCF₃)₃ obtained in Preparation Example 3 and 0.002 g of AIBN were used, and a solid comprised of the fluorine-containing acrylate polymer (A) and the erbium complex (B) was obtained.

### EXAMPLE 10

### (Production of photofunctional optical material)

Polymerization reaction was carried out in the same manner as in Example 1 except that 2.0 g of the fluorine-containing acrylate represented by the formula (a3-1), 0.32 g of the tetrafunctional fluorine-containing acrylate represented by the formula (a4-2), 0.020 g of the erbium complex : Er(CF₃COCHCOCF₃)₃ obtained in Preparation Example 3 and 0.002 g of AIBN were used, and a solid comprised of the fluorine-containing acrylate polymer (A) and the erbium complex (B) was obtained.

### COMPARATIVE EXAMPLE 5

Polymerization reaction was carried out in the same manner as in Example 1 except that 2.0 g of methyl methacrylate, 0.32 g of the tetrafunctional fluorine-containing acrylate represented by the formula (a4-2), 0.020 g of the europium complex: Er(CF₃COCHCOCF₃)₃ obtained in Preparation Example 3 and 0.002 g of AIBN were used, and a solid comprised of a fluorine-containing acrylate polymer and an erbium complex was obtained.

### COMPARATIVE EXAMPLE 6

Polymerization reaction was carried out in the same manner as in Example 1 except that 2.0 g of methyl methacrylate, 0.020 g of the erbium complex: Er(CF₃COCHCOCF₃)₃ obtained in Preparation Example 3 and 0.002 g of AIBN were used, and a solid comprised of a fluorine-containing acrylate polymer and an erbium complex was obtained.

### EXPERIMENTAL EXAMPLE 2

With respect to the obtained solids containing erbium complex, the fluorine content in the fluorine-containing acrylate polymer (A), the content of rare earth metal complex and appearance were determined in the same manner as in Experimental Example 1, and the relative intensity of light emission at 1,550 nm wavelength was determined by the following method (5). The results are shown in Table 2.

### (5) Relative intensity of light emission at 1,550 nm wavelength

The respective cylindrical solids which were comprised of the fluorine-containing acrylate polymer and the erbium complex and were obtained in Examples 9 and 10 and Comparative Examples 5 and 6 were cut by 3 cm in the direction of height, and both ends thereof were subjected to optical grinding.

The samples were set on the fluorescence spectrophotometer equipped with an integrating sphere shown in Fig. 2, and the samples were irradiated with a specific amount of light of 1,480 nm wavelength as an excitation wavelength to determine an intensity of light emission from light emission spectrum.

In the light emission spectrum, when an intensity of the light emission peak at 1,550 nm of the solid sample of Comparative Example 6 is assumed to be 100, a relative ratio of an intensity of light emission peak of each sample was calculated and assumed to be a relative intensity of light emission at 1,550 nm.

**TABLE 2**

| | Fluorine content in polymer (A) (% by mass) | Content of rare earth metal complex (% by mass) | Appearance | Relative intensity of light emission at 1,550 nm wavelength |
|---|---|---|---|---|
| Ex. 9 | 60.9 | 0.18 | ○ | 340 |
| Ex. 10 | 58.5 | 0.18 | ○ | 320 |
| Com. Ex. 5 | 0.87 | 0.16 | ○ | 120 |
| Com. Ex. 6 | 0 | 0.019 | ○ | 100 |

### INDUSTRIAL APPLICABILITY

A light emission phenomenon of a rare earth metal compound is usually a phenomenon such that an energy level of a rare earth metal ion is increased by absorption of excitation light such as ultraviolet light to be acted thereon and then when the energy level is decreased to a ground state, light corresponding to the energy difference is generated as light of specific wavelength (visual light or near infrared light).

A wavelength of necessary excitation light and a wavelength of emitted light vary depending on kind of a rare earth metal ion and are derived from properties inherent to a rare earth metal ion.

In the above-mentioned light emission phenomenon, generally the whole of the applied excitation light is not always converted to light emission energy, and it can be considered that a part of the excitation light is changed (energy transfer) to a vibration energy (namely, thermal energy) of matrix polymer molecules neighboring to the rare earth metal compound and therefore an intensity and quantum yield (light emission efficiency) of light emission become insufficient.

The present inventors could inhibit an energy transfer from a rare earth metal compound to a matrix polymer by using, as a matrix polymer, a copolymer of a monofunctional acrylate having a high fluorine content and a polyfunctional acrylate, and as a result, an intensity of light emission and quantum yield of the rare earth metal compound could be increased.

Further in the present invention, the structural formula of the fluorine-containing acrylate polymer is properly selected in consideration of solubility of the rare earth metal compound in the matrix, and there can be provided the photofunctional optical material which has never been prepared and can give a light amplifying material, wavelength conversion material and high efficiency light emission material usable for a color filter, etc.

## Claims

1. A photofunctional optical material comprising:
(A) a fluorine-containing acrylate polymer which is prepared by polymerizing:
(a1) at least one selected from fluorine-containing acrylates represented by the formula (1): 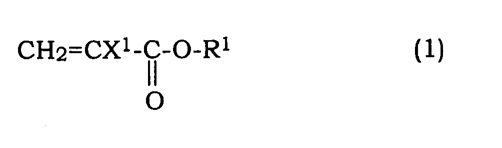 wherein X¹ is H, F, Cl, CH₃ or CF₃; R¹ is at least one selected from a monovalent hydrocarbon group which has 1 to 50 carbon atoms and may have ether bond and a monovalent fluorine-containing hydrocarbon group which has 1 to 50 carbon atoms and may have ether bond; at least either X¹ or R¹ contains fluorine atom,
(a2) at least one selected from polyfunctional acrylates represented by the formula (2): 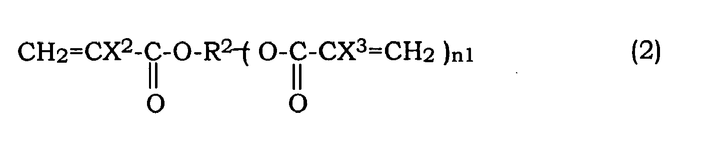 wherein X² and X³ are the same or different and each is H, F, Cl, CH₃ or CF₃; n1 is an integer of 1 to 6; R² is a (n1 + 1)-valent organic group having 1 to 50 carbon atoms, and
(n) at least one selected from monomers being copolymerizable with said (a1) and (a2),
and contains a structural unit A1 derived from the monomer (a1), a structural unit A2 derived from the monomer (a2) and a structural unit N derived from the monomer (n) in amounts of from 20 to 99.9 % by mole, from 0.1 to 80 % by mole and from 0 to 60 % by mole, respectively, and
(B) a rare earth metal compound,
in which (A) and (B) are contained in amounts of from 1 to 99.99 % by mass and from 0.01 to 99 % by mass, respectively.

2. The photofunctional optical material of Claim 1, wherein the fluorine content of the fluorine-containing acrylate polymer (A) is not less than 30 % by mass.

3. The photofunctional optical material of Claim 1 or 2, wherein R¹ in the fluorine-containing acrylate of the formula (1) constituting the fluorine-containing acrylate polymer (A) is a fluorine-containing alkyl group which has ether bond and contains a structure represented by the formula (1-1): 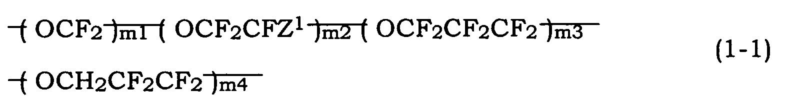 wherein Z¹ is F or CF₃; m1, m2, m3 and m4 are 0 or integers of 1 to 10 and m1 + m2 + m3 + m4 is an integer of 1 to 10.

4. The photofunctional optical material of Claim 3, wherein R¹ in the fluorine-containing acrylate of the formula (1) constituting the fluorine-containing acrylate polymer (A) is a fluorine-containing alkyl group which has ether bond and is represented by the formula (1-2): 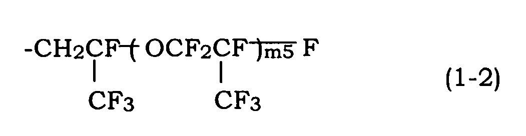 wherein m5 is an integer of 1 to 5.

5. The photofunctional optical material of any of Claims 1 to 4, wherein R² in the polyfunctional acrylate of the formula (2) constituting the fluorine-containing acrylate polymer (A) is a (n + 1)-valent organic group having 3 to 50 carbon atoms in which a part or the whole of hydrogen atoms may be substituted by fluorine atoms and contains at least one moiety selected from moieties of aromatic hydrocarbon structure which may have hetero atom and moieties of aliphatic cyclic hydrocarbon structure which may have hetero atom.

6. The photofunctional optical material of any of Claims 1 to 5, wherein the rare earth metal compound (B) is a rare earth metal complex.

7. A composition which comprises:
(a3) at least one selected from fluorine-containing acrylates represented by the formula (3): 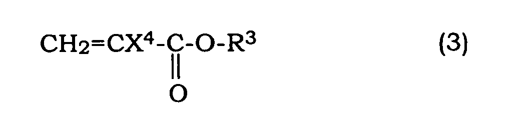 wherein X⁴ is H, F, Cl, CH₃ or CF₃; R³ is a fluorine-containing alkyl group which has 2 to 50 carbon atoms and ether bond and contains a structure represented by the formula (3-1): 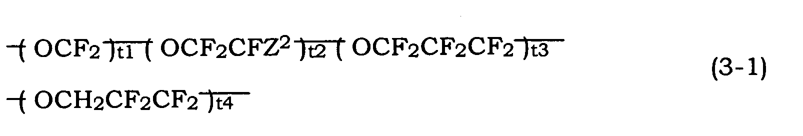 wherein Z² is F or CF₃; t1, t2, t3 and t4 are 0 or integers of 1 to 10 and t1 + t2 + t3 + t4 is an integer of 1 to 10,
(a4) at least one selected from polyfunctional acrylates represented by the formula (4): 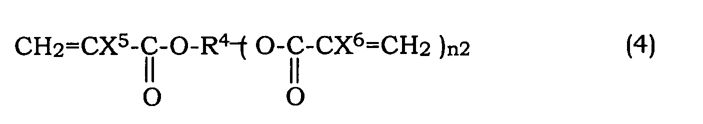 wherein X⁵ and X⁶ are the same or different and each is H, F, Cl, CH₃ or CF₃; n2 is an integer of 1 to 6; R⁴ is a (n2 + 1)-valent organic group having 1 to 50 carbon atoms, and
(b) a rare earth metal compound,
in which ((a3) + (a4)) is contained in an amount of from 1 to 99.99 % by mass and (b) is contained in an amount of from 0.01 to 99 % by mass and when the number of moles of (a3) plus the number of moles of (a4) is assumed to be 100, a molar ratio (a3)/(a4) is 20/80 to 99/1.

8. The composition of Claim 7, wherein R³ in the fluorine-containing acrylate of the formula (3) is a fluorine-containing alkyl group which has ether bond and is represented by the formula (3-2): 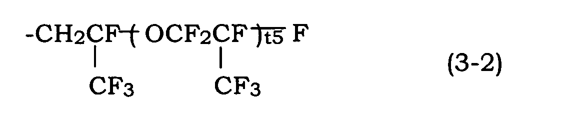 wherein t5 is an integer of 1 to 5.

9. The composition of Claim 7 or 8, which further contains (c) a photoradical generator in addition to the fluorine-containing acrylate (a3), polyfunctional acrylate (a4) and rare earth metal compound (b).

10. The composition of any of Claims 7 to 9, wherein the rare earth metal compound (b) is a rare earth metal complex.
